# EUROPEAN PATENT APPLICATION

(11) **EP 4 746 653 A1**
(43) Date of publication of application: **20.05.2026**
(21) Application number: 24839783.8
(22) Date of filing: 10.07.2024
(51) Int. Cl.: H10K 50/12, C09K 11/06, H10K 50/15, H10K 50/17, H10K 50/18, H10K 59/10, H10K 85/60

(54) **ORGANIC ELECTROLUMINESCENT ELEMENT AND ELECTRONIC DEVICE**

(30) Priority: 10.07.2023 JP 2023113230
(71) Applicant: Hodogaya Chemical Co., Ltd., Tokyo, 105-0021 (JP)
(72) Inventor: HIRAYAMA, Yuta, Tokyo 105-0021 (JP); KASE, Kouki, Tokyo 105-0021 (JP); PARK, Young-Hwan, Tokyo 105-0021 (JP); HAYASHI, Shuichi, Tokyo 105-0021 (JP); JOO, Sung-Hoon, Cheongju-si, Chungcheongbuk-do 28122 (KR); JO, Hyeon-Jun, Cheongju-si, Chungcheongbuk-do 28122 (KR); KANG, Soo-Kyung, Cheongju-si, Chungcheongbuk-do 28122 (KR)
(74) Representative: Müller-Boré & Partner Patentanwälte PartG mbB
(86) International application number: PCT/JP2024/024917
(87) International publication number: WO 2025/013893

(57) **Abstract**

An organic electroluminescent device using a compound represented by the following general formula and an organoboron compound has high efficiency, low drive voltage, and long lifetime. A₃, R₁ and R₂ each represent a monovalent aromatic hydrocarbon group, etc.; A₁ and A₂ each represent a naphthylene group; L₁ to L₃ each represent a single bond, or a divalent aromatic hydrocarbon group, etc.

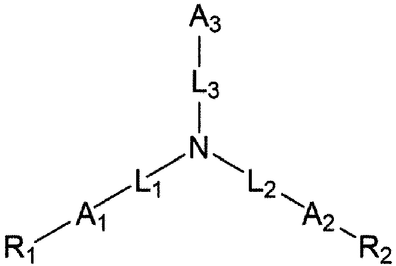

## Description

### Technical Field

The present invention relates to an organic electroluminescent device, which is a self-luminous device suitable for various display devices, and to an electronic device, and precisely, the invention relates to an organic electroluminescent device (hereinafter abbreviated as "organic EL device") using a specific arylamine compound and a specific organoboron compound, and to an electronic device.

### Background Art

Organic EL devices are the subject of active research because they are self-luminous devices, which means they are brighter and more visible than liquid crystal devices, and can provide a clearer display.

In 1987, C.W. Tang et al. of Eastman Kodak Company developed a laminate structure device in which various roles are assigned to individual materials, as a practical organic EL device. Specifically, they laminate a phosphor that can transport electrons and an organic material that can transport holes, and inject both charges into the phosphor layer to emit light, thus having realized a high luminance of 1000 cd/m² or more at a voltage of 10 V or less (see, for example, PTL 1 and PTL 2).

To date, many improvements have been made for the practical application of organic EL devices, and high efficiency and durability have been achieved by further subdividing the various roles of the laminate structure into a laminate structure with an anode, a hole injection layer, a hole transport layer, a light-emitting layer, an electron transport layer, an electron injection layer, and a cathode sequentially arranged on a substrate (see, for example, NPL 1).

In addition, the use of triplet excitons has been attempted to further improve light emission efficiency, and the use of phosphorescent emissive compounds has been investigated (see, for example, NPL 2).

And devices that use light emission from thermally activated delayed fluorescence (TADF) have also been developed. In 2011, Adachi et al. at Kyushu University achieved an external quantum efficiency of 5.3% with a device using a thermally activated delayed fluorescent material (see, for example, NPL 3).

The light-emitting layers of these organic EL devices are made by doping a fluorescent or phosphorescent compound or a material that emits delayed fluorescence into a charge transport compound generally called a host material. As described in the above non-patent literature, various organic layers are provided in organic EL devices, and the choice of organic materials has a significant impact on various properties such as the efficiency and durability of the devices (see, for example, NPL 2).

In other words, in an organic EL device, the charges injected from both electrodes are recombined in the light-emitting layer to produce luminescence, so it is important how efficiently both charges of holes and electrons are transferred to the light-emitting layer, and the device must have an excellent carrier balance. In addition, by increasing hole injectivity and increasing electron-blocking power that blocks electrons injected from a cathode, the probability of recombination between holes and electrons can be improved, and further by confining excitons generated in a light-emitting layer, high light emission efficiency can be attained. Consequently, the role of hole transport materials is important, and therefore hole transport materials with high hole injectivity, high hole mobility, high electron-blocking power, and high durability against electrons are required.

Heat resistance and amorphousness of materials are also important with respect to the lifetime of devices. In materials with low heat resistance, the heat generated during device drive causes thermal decomposition even at low temperatures, resulting in material degradation. Materials with low amorphousness cause crystallization of thin films and device degradation even in a short period of time. Consequently, the materials to be used must have high heat resistance and good amorphousness.

Heretofore, N,N'-diphenyl-N,N'-di(α-naphthyl)benzidine (NPD) and various aromatic amine derivatives have been used as hole transport materials for organic EL devices (see, for example, PTL 1 and PTL 2). Although NPD has good hole transport ability, its glass transition point (Tg), an index of heat resistance, is low at 96°C, and under high temperature conditions, device characteristics deteriorate due to crystallization (see, for example, NPL 4). Some aromatic amine derivatives described in the above-mentioned patent literature are known to have an excellent hole mobility of 10⁻³ cm²/Vs or higher (see, for example, PTL 1 and PTL 2); however, since their electron-blocking power is insufficient, some electrons can pass through the light-emitting layer with the derivative and no improvement in light emission efficiency can be expected. Therefore, for even higher efficiency, materials with higher electron-blocking power and with ability to form more stable and more heat-resistant thin films have been required. There are also reports of aromatic amine derivatives with high durability (see, for example, PTL 3), but in these, the aromatic amine derivatives were used as charge transport materials for electrophotographic photoreceptors, and there were no examples of their use as organic EL devices.

Arylamine compounds with a substituted carbazole structure have been proposed as compounds with improved properties such as heat resistance and hole injectivity (see, for example, PTL 4 and PTL 5). However, devices using these compounds in the hole injection layer or the hole transport layer have improved in terms of heat resistance and light emission efficiency, but these improvements are not yet sufficient, and there is a need for even lower drive voltage and even higher light emission efficiency.

To improve the device characteristics of organic EL devices, a combination of materials with excellent hole and electron injection and transport performance, thin-film stability and durability is required to produce carrier-balanced devices with high efficiency, low drive voltage and long lifetime.

### Citation List

### Patent Literature

PTL 1: US5792557B
PTL 2: US5639914B
PTL 3: US7759030B
PTL 4: JP2009076817A1
PTL 5: JP6674892B2
PTL 6: EP2684932B
PTL 7: Korean Patent 10-2020-0131929
PTL 8: WO2017/073594A1

### Non-Patent Literature

NPL 1: The 9th Symposium of the Society for Applied Physics, Proceedings pp. 55-61 (2001)
NPL 2: The 9th Symposium of the Society for Applied Physics, Proceedings pp. 23-31 (2001)
NPL 3: Appl. Phys. Let., 98, 083302 (2011)
NPL 4: The 3rd Regular Meeting of the Organic EL Discussion Committee, Proceedings pp. 13-14 (2006)

### Summary of Invention

### Technical Problem

An object of the invention is to provide an organic EL device with high efficiency, low drive voltage, and long lifetime by appropriately combining the materials used. It is also an object of the invention to provide an electronic device using such an organic EL device.

### Solution to Problem

In order to achieve the above-mentioned objectives, the inventors focused on the superiority of arylamine compounds in terms of hole injection and transport ability, thin-film stability, and durability, and diligently investigated various arylamine compounds and evaluated the characteristics of organic EL devices fabricated using them. As a result, the inventors found that an arylamine compound with a specific structure can efficiently transport holes injected from an anode side when used as a material for the hole transport layer. Furthermore, the inventors have found that by combining an organoboron compound with a specific structure, various organic EL devices with low drive voltage, high efficiency, and long lifetime can be fabricated. As a result, the invention has been completed.

In other words, according to the invention, the following organic EL device is provided.

(1) An organic EL device having an anode, a cathode, and an organic layer sandwiched between the anode and the cathode, wherein the organic layer contains an arylamine compound represented by the following general formula (1) and an organoboron compound represented by the following general formula (2-1) or (2-2): 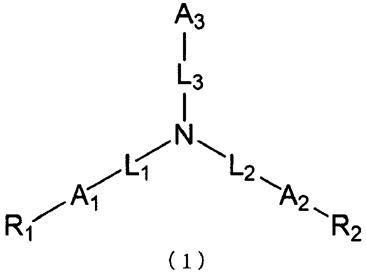
   wherein L₁ to L₃ may be the same as or different from each other, and each represent a single bond, a deuterium-substituted or unsubstituted divalent aromatic hydrocarbon group having 6 to 30 carbon atoms, a deuterium-substituted or unsubstituted divalent fused polycyclic aromatic hydrocarbon group having 10 to 30 carbon atoms, a deuterium-substituted or unsubstituted divalent aromatic heterocyclic group having 2 to 20 carbon atoms, or a deuterium-substituted or unsubstituted divalent fused polycyclic aromatic heterocyclic group having 2 to 30 carbon atoms,
   A₁ and A₂ may be the same as or different from each other, and each represent a deuterium-substituted or unsubstituted naphthylene group,
   A₃ represents a substituted or unsubstituted aromatic hydrocarbon group having 6 to 30 carbon atoms, a substituted or unsubstituted fused polycyclic aromatic hydrocarbon group having 10 to 30 carbon atoms, a substituted or unsubstituted aromatic heterocyclic group having 2 to 20 carbon atoms, or a substituted or unsubstituted fused polycyclic aromatic heterocyclic group having 2 to 30 carbon atoms;
   R₁ and R₂ may be the same as or different from each other, representing a deuterium-substituted or unsubstituted aromatic hydrocarbon group having 6 to 30 carbon atoms, a deuterium-substituted or unsubstituted fused polycyclic aromatic hydrocarbon group having 10 to 30 carbon atoms, a deuterium-substituted or unsubstituted aromatic heterocyclic group having 2 to 20 carbon atoms, or a deuterium-substituted or unsubstituted fused polycyclic aromatic heterocyclic group having 2 to 30 carbon atoms,
   the wording "substituted or unsubstituted" means having one or more substituents or having no substituents of any kind,
   the "substituent" may be the same as or different from each other, and represents a deuterium atom, a halogen atom, a cyano group, an alkyl group having 1 to 30 carbon atoms, a cycloalkyl group having 3 to 30 carbon atoms, an alkenyl group having 2 to 30 carbon atoms, an aromatic hydrocarbon group having 6 to 50 carbon atoms, a fused polycyclic aromatic hydrocarbon group having 10 to 30 carbon atoms, an aromatic heterocyclic group having 2 to 50 carbon atoms, a fused polycyclic aromatic heterocyclic group having 2 to 30 carbon atoms, an amino group having 0 to 30 carbon atoms, or a silyl group having 0 to 30 carbon atoms,
   these "substituents" may further have one or more substituents,
   when the "substituent" has a carbon atom, the carbon atom is counted in the "6 to 30 carbon atoms", "10 to 30 carbon atoms", "2 to 20 carbon atoms", and "2 to 30 carbon atoms" in A₃, R₁, and R₂ above, 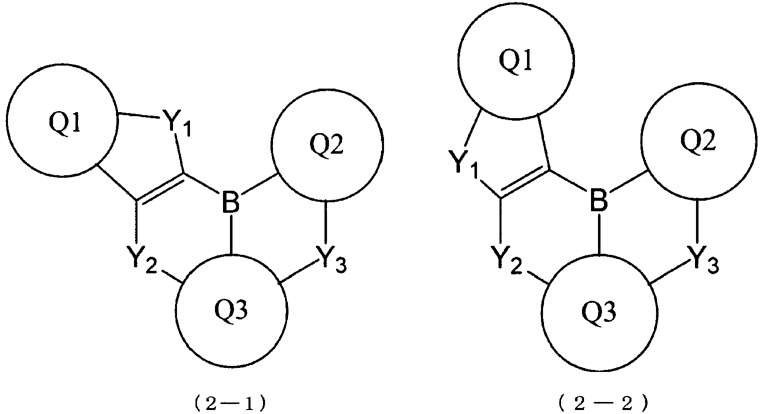
   wherein Q1 to Q3 may be the same as or different from each other and each represent a substituted or unsubstituted aromatic hydrocarbon ring having 6 to 50 carbon atoms, a substituted or unsubstituted fused polycyclic aromatic hydrocarbon ring having 10 to 50 carbon atoms, a substituted or unsubstituted aromatic heterocyclic ring having 2 to 50 carbon atoms, or a substituted or unsubstituted fused polycyclic aromatic heterocyclic ring having 2 to 50 carbon atoms,
   Y₁ to Y₃ may be the same as or different from each other and each represent N-R₃, CR₄R₅, O, S, Se, or SiR₆R₇,
   R₃ to R₇ may be the same as or different from each other, and each represent a hydrogen atom, a deuterium atom, a halogen atom, a nitro group, a cyano group, a substituted or unsubstituted alkyl group having 1 to 30 carbon atoms, a substituted or unsubstituted cycloalkyl group having 3 to 30 carbon atoms, a substituted or unsubstituted alkenyl group having 2 to 30 carbon atoms, a substituted or unsubstituted cycloalkenyl group having 3 to 30 carbon atoms, a substituted or unsubstituted heterocycloalkyl group having 1 to 30 carbon atoms, a substituted or unsubstituted aromatic hydrocarbon group having 6 to 50 carbon atoms, a substituted or unsubstituted fused polycyclic aromatic hydrocarbon group having 10 to 50 carbon atoms, a substituted or unsubstituted aromatic heterocyclic group having 2 to 50 carbon atoms, a substituted or unsubstituted fused polycyclic aromatic heterocyclic group having 2 to 50 carbon atoms, a substituted or unsubstituted alkoxy group having 1 to 30 carbon atoms, a substituted or unsubstituted aryloxy group having 6 to 30 carbon atoms, a substituted or unsubstituted alkylthio group having 1 to 30 carbon atoms, a substituted or unsubstituted arylthio group having 5 to 30 carbon atoms, a substituted or unsubstituted amino groups having 0 to 30 carbon atoms, or a substituted or unsubstituted silyl groups having 3 to 30 carbon atoms,
   R₃ to R₇ each may bond to any of Q1 to Q3 via a single bond, N, O, P or S, or fuse to form a fused ring, R₄ and R₅ may bond to each other to further form a ring, and R₆ and R₇ may bond to each other to further form a ring,
   the wording "substituted or unsubstituted" has the same definition as in the general formula (1), and the "substituent" represents the same group as the "substituent" in the general formula (1),
   these "substituents" may further have one or more substituents,
   when the "substituent" has a carbon atom, the carbon atom is counted in the "6 to 50 carbon atoms", "10 to 50 carbon atoms", "2 to 50 carbon atoms", "1 to 30 carbon atoms", "3 to 30 carbon atoms", "2 to 30 carbon atoms", "6 to 30 carbon atoms" and "5 to 30 carbon atoms" in Q1 to Q3, Y₁ to Y₃, and R₃ to R₇ above,
   when Y₂ or Y₃ is N-R₃, at least one R₃ represents a fused polycyclic aromatic heterocyclic group represented by the following general formula (2-A), or an aromatic hydrocarbon group, a fused polycyclic aromatic hydrocarbon group, or a fused polycyclic aromatic heterocyclic group represented by the following general formula (2-B): 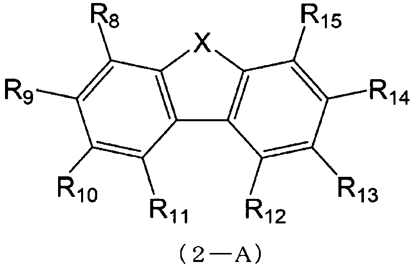
   wherein X represents O or S,
   R₈ to R₁₅ may be the same as or different from each other and each represent a single bond, a hydrogen atom, a deuterium atom, a halogen atom, a hydroxyl group, a nitro group, a cyano group, a substituted or unsubstituted alkyl group having 1 to 30 carbon atoms, a substituted or unsubstituted cycloalkyl group having 3 to 30 carbon atoms, a substituted or unsubstituted alkenyl group having 2 to 30 carbon atoms, a substituted or unsubstituted cycloalkenyl group having 3 to 30 carbon atoms, a substituted or unsubstituted alkynyl group having 2 to 30 carbon atoms, a substituted or unsubstituted heterocycloalkyl group having 1 to 30 carbon atoms, a substituted or unsubstituted aromatic hydrocarbon group having 6 to 50 carbon atoms, a fused polycyclic aromatic hydrocarbon group having 10 to 30 carbon atoms, a substituted or unsubstituted aromatic heterocyclic group having 2 to 50 carbon atoms, a substituted or unsubstituted fused polycyclic aromatic heterocyclic group having 2 to 30 carbon atoms, a substituted or unsubstituted alkoxy group having 1 to 30 carbon atoms, a substituted or unsubstituted aryloxy group having 6 to 30 carbon atoms, a substituted or unsubstituted alkylthio group having 1 to 30 carbon atoms, a substituted or unsubstituted arylthio group having 5 to 30 carbon atoms, a substituted or unsubstituted amino group having 0 to 30 carbon atoms, a substituted or unsubstituted silyl group having 3 to 30 carbon atoms, a substituted or unsubstituted germanium group having 0 to 30 carbon atoms, a substituted or unsubstituted boron group having 0 to 30 carbon atoms, a substituted or unsubstituted aluminum group having 0 to 30 carbon atoms, a substituted phosphoryl group having 0 to 30 carbon atoms, a substituted or unsubstituted seleno group having 0 to 30 carbon atoms, or a substituted or unsubstituted tellurium group having 0 to 30 carbon atoms,
   any one of R₈ to R₁₅ bonds to N of N-R₃ represented by Y₂ or Y₃,
   R₈ to R₁₅ each may bond to the adjacent group via a single bond, N, O, or S, or may fuse to form a ring,
   the wording "substituted or unsubstituted" has the same definition as in the general formula (1), and the "substituent" represents the same group as the "substituent" in the general formula (1),
   these "substituents" may further have one or more substituents,
   when the "substituent" has a carbon atom, the carbon atom is counted in the "1 to 30 carbon atoms", "3 to 30 carbon atoms", "2 to 30 carbon atoms", "10 to 30 carbon atoms", "6 to 50 carbon atoms", "2 to 50 carbon atoms", "6 to 30 carbon atoms", "5 to 30 carbon atoms" and "0 to 30 carbon atoms" in R₈ to R₁₅ above, 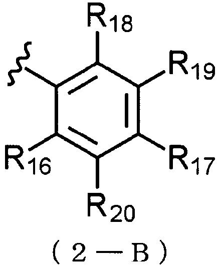
   wherein R₁₆ represents a hydrogen atom, a deuterium atom, a substituted or unsubstituted alkyl group having 1 to 30 carbon atoms, a substituted or unsubstituted aromatic hydrocarbon group having 6 to 50 carbon atoms, a substituted or unsubstituted aromatic heterocyclic group having 2 to 50 carbon atoms, or a substituted or unsubstituted fused polycyclic aromatic heterocyclic group having 2 to 50 carbon atoms,
   R₁₇ represents a hydrogen atom, a deuterium atom, a substituted or unsubstituted alkyl group having 1 to 30 carbon atoms, a substituted or unsubstituted cycloalkyl group having 3 to 30 carbon atoms, a substituted or unsubstituted aromatic hydrocarbon group having 6 to 50 carbon atoms, a substituted or unsubstituted fused polycyclic aromatic hydrocarbon group having 10 to 30 carbon atoms, a substituted or unsubstituted aromatic heterocyclic group having 2 to 50 carbon atoms, or a substituted or unsubstituted fused polycyclic aromatic heterocyclic group having 2 to 30 carbon atoms,
   R₁₈ to R₂₀ may be the same as or different from each other, and each represent a hydrogen atom, a deuterium atom, a halogen atom, a cyano group, a substituted or unsubstituted alkyl group having 1 to 30 carbon atoms, a substituted or unsubstituted cycloalkyl group having 3 to 30 carbon atoms, a substituted or unsubstituted aromatic hydrocarbon group having 6 to 50 carbon atoms, a substituted or unsubstituted aromatic heterocyclic group having 2 to 50 carbon atoms, a substituted or unsubstituted alkoxy group having 1 to 30 carbon atoms, a substituted or unsubstituted alkylthio group having 1 to 30 carbon atoms, a substituted or unsubstituted amino group having 0 to 30 carbon atoms, or a substituted or unsubstituted silyl group having 3 to 30 carbon atoms,
   the wavy line represents the bond to N in N-R₃ represented by Y₂ or Y₃,
   R₁₆ to R₂₀ each may bond to the adjacent group via a single bond, N, O, or S, or may fuse to form a ring,
   the wording "substituted or unsubstituted" has the same definition as in the general formula (1), and the "substituent" represents the same group as the "substituent" in the general formula (1),
   these "substituents" may further have one or more substituents,
   when the "substituent" has a carbon atom, the carbon atom is counted in the "1 to 30 carbon atoms", "6 to 50 carbon atoms", "2 to 50 carbon atoms", "3 to 30 carbon atoms", "10 to 30 carbon atoms", "2 to 30 carbon atoms" and "0 to 30 carbon atoms" in R₁₆ to R₂₀ above.
2) The organic EL device according to the above 1), containing an arylamine compound of the general formula (1), wherein A₁ and A₂ may be the same as or different from each other, and are each a deuterium-substituted or unsubstituted 1,2-naphthylene group, a deuterium-substituted or unsubstituted 1,3-naphthylene group, a deuterium-substituted or unsubstituted 1,4-naphthylene group, a deuterium-substituted or unsubstituted 2,6-naphthylene group, a deuterium-substituted or unsubstituted 2,7-naphthylene group, or a deuterium-substituted or unsubstituted 2,8-naphthylene group.
3) The organic EL device according to the above 1) or 2), containing an arylamine compound of the general formula (1) wherein L₁ and L₂ each are a deuterium-substituted or unsubstituted phenylene group or a deuterium-substituted or unsubstituted biphenylylene group.
4) The organic EL device according to any one of the above 1) to 3), containing an arylamine compound of the general formula (1) wherein R₁ and R₂ may be the same as or different from each other, each representing a deuterium-substituted or unsubstituted phenyl group, a deuterium-substituted or unsubstituted naphthyl group, a deuterium-substituted or unsubstituted dibenzofuranyl group, a deuterium-substituted or unsubstituted phenanthrenyl group, or a deuterium-substituted or unsubstituted biphenylyl group (C₆H₅-C₆H₄-).
5) The organic EL device according to any one of the above 1) to 4), containing an arylamine compound of the general formula (1) wherein A₃ represents a substituted or unsubstituted phenyl group, a substituted or unsubstituted naphthyl group, a substituted or unsubstituted dibenzofuranyl group, a substituted or unsubstituted dibenzothienyl group, a substituted or unsubstituted phenanthrenyl group, or a substituted or unsubstituted biphenylyl group.
6) The organic EL device according to any one of the above 1) to 5), containing an arylamine compound of the general formula (1) wherein A₁ and A₂ are the same group.
7) The organic EL device according to the above 6), containing an arylamine compound of the general formula (1) wherein R₁ and R₂ are the same group.
8) The organic EL device according to the above 6), containing an arylamine compound of the general formula (1) wherein R₁ and R₂ are different groups.
9) The organic EL device according to any one of the above 1) to 5), containing an arylamine compound of the general formula (1) wherein A₁ and A₂ are different groups.
10) The organic EL device according to the above 9), containing an arylamine compound of the general formula (1) wherein R₁ and R₂ are the same group.
11) The organic EL device according to the above 9), containing an arylamine compound of the general formula (1) wherein R₁ and R₂ are different groups.
12) The organic EL device according to any one of the above 1) to 11), wherein the general formulas (2-1) and (2-2) contain an organoboron compound represented by the following general formula (2-3), general formula (2-4), general formula (2-5) or general formula (2-6): 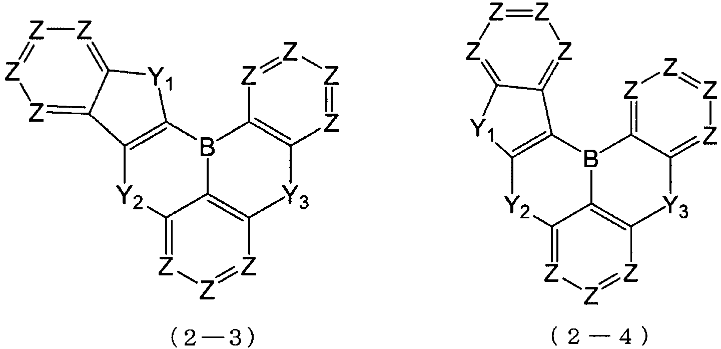 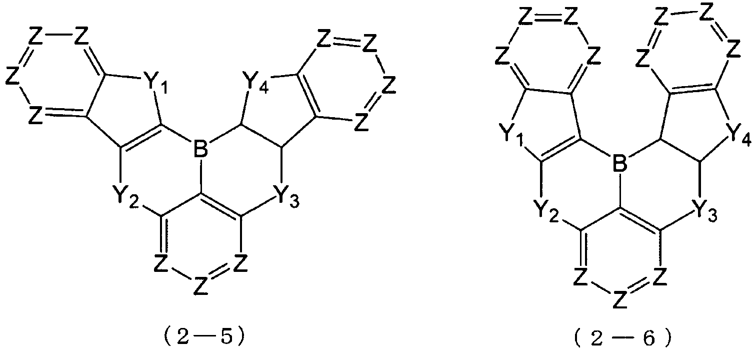
   wherein Y₁, Y₂ and Y₃ are the same as in the general formulas (2-1) and (2-2),
   Y₄ represents N-R₃, C-R₄R₅, O, S, Se or Si-R₆R₇,
   R₃ to R₇ are the same as in the general formulas (2-1) and (2-2),
   Z may be the same as or different from each other, and represents N or CR₂₁,
   R₂₁ represents a hydrogen atom, a deuterium atom, a halogen atom, a cyano group, a substituted or unsubstituted alkyl group having 1 to 30 carbon atoms, a substituted or unsubstituted cycloalkyl group having 3 to 30 carbon atoms, a substituted or unsubstituted aromatic hydrocarbon group having 6 to 50 carbon atoms, a substituted or unsubstituted fused polycyclic aromatic hydrocarbon group having 10 to 30 carbon atoms, a substituted or unsubstituted aromatic heterocyclic group having 2 to 50 carbon atoms, a substituted or unsubstituted fused polycyclic aromatic heterocyclic group having 2 to 30 carbon atoms, a substituted or unsubstituted alkoxy group having 1 to 30 carbon atoms, a substituted or unsubstituted aryloxy group having 6 to 30 carbon atoms, a substituted or unsubstituted alkylthio group having 1 to 30 carbon atoms, a substituted or unsubstituted arylthio group having 5 to 30 carbon atoms, a substituted or unsubstituted alkylamino group having 1 to 30 carbon atoms, a substituted or unsubstituted arylamino group having 5 to 30 carbon atoms, a substituted or unsubstituted alkylsilyl group having 1 to 30 carbon atoms, or a substituted or unsubstituted arylsilyl group having 5 to 30 carbon atoms,
   R₂₁ may bond to the adjacent group via a single bond, N, O, or S, or may fuse to form a ring,
   the wording "substituted or unsubstituted" has the same definition as in the general formula (1), and the "substituent" represents the same group as the "substituent" in the general formula (1),
   these "substituents" may further have one or more substituents,
   when the "substituent" has a carbon atom, the carbon atom is counted in the "1 to 30 carbon atoms", "3 to 30 carbon atoms", "6 to 50 carbon atoms", "2 to 50 carbon atoms", "6 to 30 carbon atoms", and "5 to 30 carbon atoms" in R₂₁ above.
13) The organic EL device according to any one of the above 1) to 12), in which the organic layer includes at least a hole transport layer and a light-emitting layer, the hole transport layer contains a compound represented by the general formula (1), and the light-emitting layer contains an organoboron compound represented by the general formula (2-1) or general formula (2-2).
14) The organic EL device according to any one of the above 1) to 12), in which the organic layer includes at least an electron-blocking layer and a light-emitting layer, the electron-blocking layer contains a compound represented by the general formula (1), and the light-emitting layer contains an organoboron compound represented by the general formula (2-1) or general formula (2-2).
15) The organic EL device according to any one of the above 1) to 12), in which the organic layer includes at least a hole injection layer and a light-emitting layer, the hole injection layer contains a compound represented by the general formula (1), and the light-emitting layer contains an organoboron compound represented by the general formula (2-1) or general formula (2-2).
16) An electronic device having a pair of electrodes, and an organic layer sandwiched between the pair of electrodes, wherein the organic layer contains an arylamine compound represented by the general formula (1) and an organoboron compound represented by the general formula (2-1) or (2-2).

### Advantageous Effects of Invention

By using an arylamine compound represented by the above general formula (1) in combination with an organoboron compound represented by the above general formula (2-1) or (2-2), according to the invention, an organic EL device with high efficiency, low drive voltage and long lifetime can be realized.

### Brief Description of Drawings

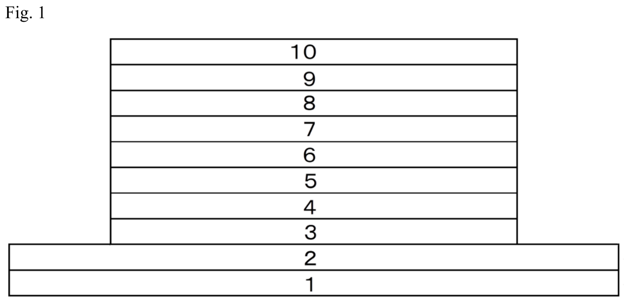

[Fig. 1] Fig. 1 shows a configuration of organic EL devices of Examples 1 to 189 and Comparative Examples 1 to 3.

### Description of Embodiments

### <Compound Represented by General Formula (1)>

The organic electroluminescent device of the invention contains a compound represented by the above general formula (1).

Specific examples of the "aromatic hydrocarbon group having 6 to 30 carbon atoms", the "fused polycyclic aromatic hydrocarbon group having 10 to 30 carbon atoms", the "aromatic heterocyclic group having 2 to 20 carbon atoms", or the "fused polycyclic aromatic heterocyclic group having 2 to 30 carbon atoms" represented by A₃, R₁ and R₂ in the general formula (1) include: an aromatic hydrocarbon group such as a phenyl group, a biphenylyl group and a terphenylyl group; a fused polycyclic aromatic hydrocarbon group such as a naphthyl group, a anthracenyl group, a phenanthrenyl group, an indenyl group, a pyrenyl group, a perylenyl group, a fluoranthenyl group, a triphenylenyl group, a fluorenyl group, and a spirobifluorenyl group; an aromatic heterocyclic group such as a pyridyl group, a pyrimidinyl group, a triazinyl group, a furyl group, a pyrrolyl group, and a thienyl group; a fused polycyclic aromatic heterocyclic group such as a quinolyl group, an isoquinolyl group, a benzofuranyl group, a benzothienyl group, an indolyl group, a carbazolyl group, a benzoxazolyl group, a benzothiazolyl group, an azafluorenyl group, a diazafluorenyl group, an azaspirobifluorenyl group, a diazaspirobifluorenyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, and a carbolinyl group. The "aromatic hydrocarbon group" includes groups of benzene rings linked by a single bond. The "fused polycyclic aromatic hydrocarbon group" is such that the ring skeleton-constituting atoms of the fused rings are solely carbon atoms. The "aromatic hydrocarbon group" does not include fused polycyclic aromatic hydrocarbon groups. The "fused polycyclic aromatic heterocyclic group" is such that the ring skeleton-constituting atoms of the fused rings contain a heteroatom. The "aromatic heterocyclic group" does not include fused polycyclic aromatic heterocyclic groups. The terms of "aromatic hydrocarbon group", "fused polycyclic aromatic hydrocarbon group", "fused polycyclic aromatic heterocyclic group", and "aromatic heterocyclic group" omit the notation "monovalent" when referring to monovalent groups. When a divalent group is indicated, it is clearly stated as "divalent".

The "substituted aromatic hydrocarbon group", the "substituted fused polycyclic aromatic hydrocarbon group", the "substituted aromatic heterocyclic group" or the "substituted fused polycyclic aromatic heterocyclic group" represented by A₃, R₁ and R₂ in the general formula (1) can have one or more substituents, in which specific examples of the "substituent" include a deuterium atom, a cyano group, a nitro group; a halogen atom such as a fluorine atom, a chlorine atom, a bromine atom, and an iodine atom; a linear or branched alkyl group such as a methyl group, an ethyl group, an n-propyl group, an isopropyl group, an n-butyl group, an iso-butyl group, and a tert-butyl group; a cycloalkyl group such as a cyclopropyl group, a cyclobutyl group, a cyclopentyl group, a cyclohexyl group, a 1-adamantyl group, and a 2-adamantyl group; an alkenyl group such as a vinyl group, an allyl group, an isopropenyl group, and a 2-butenyl group; an aromatic hydrocarbon group such as a phenyl group, a biphenylyl group, and a terphenylyl group; a fused polycyclic aromatic hydrocarbon group such as a naphthyl group, an anthracenyl group, a phenanthrenyl group, a fluorenyl group, a spirobifluorenyl group, an indenyl group, a pyrenyl group, a perylenyl group, a fluoranthenyl group, and a triphenylenyl group; an aromatic heterocyclic group such as a pyridyl group, a pyrimidinyl group, a triazinyl group, a pyrrolyl group, a thienyl group, and a furyl group; a fused polycyclic aromatic heterocyclic group such as a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, and a carbolinyl group; an unsubstituted amino group; a monoalkylamino group such as a methylamino group, an ethylamino group, an n-propylamino group, an isopropylamino group, an n-butylamino group, an isobutylamino group, a tert-butylamino group, an n-pentylamino group, an isopentylamino group, a neopentylamino group, and an n-hexylamino group; a dialkylamino group such as a dimethylamino group, a diethylamino group, a di-n-propylamino group, and a diisopropylamino group; a monoarylamino group such as a phenylamino group, a biphenylylamino group, a terphenylylamino group, a naphthylamino group, an anthracenylamino group, a pyrenylamino group, and a perylenylamino group; a diarylamino group such as a diphenylamino group, a bis(biphenylyl)amino group, a bis(terphenyl)amino group, a dinaphthylamino group, a dianthracenylamino group, a difluorenylamino group, a diindenylamino group, and an N-phenyl-N-naphthylamino group; an alkylarylamio group such as an N-methyl-N-phenylamino group; an alkylsilyl group such as a trimethylsilyl group, a triethylsilyl group, a tri-n-propylsilyl group, a triisopropylsilyl group, an n-butyldimethylsilyl group, an isobutyldimethylsilyl group, and a tert-butyldimethylsilyl group; an arylsilyl group such as a triphenylsilyl group, a trinaphthylsilyl group, a terphenylsilyl group, and a tris(terphenylyl)silyl group; and an alkylarylsilyl group such as a tert-butyldiphenylsilyl group. For example, as the "substituent", one or more groups can be selected from the group consisting of a deuterium atom, a linear or branched alkyl group having 1 to 20 carbon atoms, an aromatic hydrocarbon group having 6 to 30 carbon atoms, a fused polycyclic aromatic hydrocarbon group having 10 to 40 carbon atoms, and a combination of these groups.

These "substituents" can further have one or more substituents exemplified above. These substituents can bond to the adjacent group via a single bond, a substituted or unsubstituted methylene group, N, O or S, or can fuse to form a ring. N represents a nitrogen atom, O represents an oxygen atom, and S represents a sulfur atom. When the "substituent" has a carbon atom, the carbon atom is counted in the "6 to 30 carbon atoms", "10 to 30 carbon atoms", "2 to 20 carbon atoms", and "2 to 30 carbon atoms" in A₃, R₁, and R₂ above.

The "divalent aromatic hydrocarbon group", "divalent aromatic heterocyclic group", "divalent fused polycyclic aromatic hydrocarbon group", or "divalent fused polycyclic aromatic heterocyclic group" represented by L₁, L₂, and L₃ in the general formula (1) includes the groups of "aromatic hydrocarbon group", "fused polycyclic aromatic hydrocarbon group", "aromatic heterocyclic group" or "fused polycyclic aromatic heterocyclic group" of A₃, R₁ and R₂ in the general formula (1), from which one hydrogen atom is removed.

The position of the bond of the "naphthylene group" of the "deuterium-substituted or unsubstituted naphthylene group" represented by A₁ and A₂ is not particularly limited. Examples of the naphthylene group include a 1,2-naphthylene group, a 1,3-naphthylene group, a 1,4-naphthylene group, a 2,4-naphthylene group, a 1,6-naphthylene group, a 1,7-naphthylene group (2,8-naphthylene group), a 2,5-naphthylene group, a 2,6-naphthylene group, and a 2,7-naphthylene group.

L₁ and L₂ in the general formula (1) are preferably a phenylene group, more preferably a 1,4-phenylene group. A₃ in the general formula (1) is preferably a phenyl group or a 9-phenanthrenyl group. A₁ and A₂ in the general formula (1) are preferably a 1,2-naphthylene group or a 1,3-naphthylene group. R₁ and R₂ in the general formula (1) are preferably a phenyl group or a naphthyl group.

The compound represented by the general formula (1) used in the invention can be selected from the group shown below. For example, the compound can be selected from Compound Group 1 where R₁-A₁-L₁ and R₂-A₂-L₂ are different groups. In Compound Group 1, the compound can be selected from Compound Groups 2 to 10 that further satisfy the following conditions A to I. That is, the compound can be selected from any one compound group of Compound Group 2 satisfying Condition A, where L₃ is a single bond and A₃ is a substituted or unsubstituted aromatic hydrocarbon group having 6 to 30 carbon atoms or a substituted or unsubstituted fused polycyclic aromatic hydrocarbon group having 10 to 30 carbon atoms, Compound Group 3 satisfying Condition B, where L₃ is a deuterium-substituted or unsubstituted divalent aromatic hydrocarbon group having 6 to 30 carbon atoms, or a deuterium-substituted or unsubstituted divalent fused polycyclic aromatic hydrocarbon group having 10 to 30 carbon atoms (e.g., a deuterium-substituted or unsubstituted biphenylylene group, preferably a deuterium-substituted or unsubstituted phenylene group) and A₃ is a substituted or unsubstituted aromatic hydrocarbon group having 6 to 30 carbon atoms, or a substituted or unsubstituted fused polycyclic aromatic hydrocarbon group having 10 to 30 carbon atoms (e.g., a deuterium-substituted or phenyl-substituted or unsubstituted phenyl, naphthyl or phenanthrenyl group), Compound Group 4 satisfying Condition C, where L₃ is a deuterium-substituted or unsubstituted divalent aromatic hydrocarbon group having 6 to 30 carbon atoms, or a deuterium-substituted or unsubstituted divalent fused polycyclic aromatic hydrocarbon group having 10 to 30 carbon atoms (e.g., a deuterium-substituted or unsubstituted biphenylylene group, preferably a deuterium-substituted or unsubstituted phenylene group) and A₃ is a substituted or unsubstituted aromatic heterocyclic group having 2 to 20 carbon atoms, or a substituted or unsubstituted fused polycyclic aromatic heterocyclic group having 2 to 30 carbon atoms (e.g., a deuterium-substituted or unsubstituted dibenzofuranyl group or a deuterium-substituted or unsubstituted dibenzothienyl group), Compound Group 5 satisfying Condition D, where L₁ and L₂ are single bonds, Compound Group 6 satisfying Condition E, where L₁ and L₂ each are a deuterium-substituted or unsubstituted divalent aromatic hydrocarbon group having 6 to 30 carbon atoms (e.g., a deuterium-substituted or unsubstituted biphenylylene group, preferably a deuterium-substituted or unsubstituted phenylene group), Compound Group 7 satisfying Condition F, where A₁ and A₂ each are a deuterium-substituted or unsubstituted 1,2-naphthylene group, a deuterium-substituted or unsubstituted 1,3-naphthylene group, or a deuterium-substituted or unsubstituted 1,4-naphthylene group, Compound Group 8 satisfying Condition G, where A₁ and A₂ each are a deuterium-substituted or unsubstituted 2,6-naphthylene group, a deuterium-substituted or unsubstituted 2,7-naphthylene group, or a deuterium-substituted or unsubstituted 2,8-naphthylene group, Compound Group 9 satisfying Condition H, where R₁ and R₂ each are a deuterium-substituted or unsubstituted aromatic hydrocarbon group having 6 to 30 carbon atoms, or a deuterium-substituted or unsubstituted fused polycyclic aromatic hydrocarbon group having 10 to 30 carbon atoms (e.g., a phenyl, naphthyl or phenanthrenyl group), and Compound Group 10 satisfying Condition I, where R₁ and R₂ each are a deuterium-substituted, phenyl-substituted or unsubstituted aromatic heterocyclic group having 2 to 20 carbon atoms, or a deuterium-substituted, phenyl-substituted or unsubstituted fused polycyclic aromatic heterocyclic group having 2 to 30 carbon atoms (e.g., a dibenzofuranyl group).

When the overlap range between Group 2 and each of Groups 5 to 10 is designated as Group 11 to Group 16, Group 3 and each of Groups 5 to 10 as Group 17 to Group 22, and Group 4 and each of Groups 5 to 10 as Group 23 to Group 28, the compound represented by general formula (1) used in the invention can be selected from any of Group 11 to Group 28. Furthermore, the compound represented by the general formula (1) used in the invention can be selected from any one of Compound Group 29 where R₁ and R₂ are the same, L₁ and L₂ are the same, and A₁ and A₂ are different, Compound Group 30 where A₁ and A₂ are the same, L₁ and L₂ are the same, and R₁ and R₂ are different, and Compound Group 31 where L₁ and L₂ are the same, and R₁ and R₂ are different, and A₁ and A₂ are different.

The compound represented by the general formula (1) used in the invention can be selected from Compound Group 32 where R₁-A₁-L₁ and R₂-A₂-L₂ are the same group. In Compound Group 32, when those satisfying the above Conditions A to I are referred to as Compound Groups 33 to 41, respectively, the compound for use in the invention can be selected from any one of those Compound Groups 33 to 41. Further, the compound represented by the general formula (1) used in the invention can be selected from Compound Group 42 where R₁-A₁-L₁ is the same as R₂-A₂-L₂ but differs from A₃-L₃.

Specific examples of the compound represented by the general formula (1) are shown below. Here, the compound represented by the general formula (1) that can be used in the invention should not be construed as being limited by these specific examples. In the chemical structural formulae below, the hydrogen atom (¹H) is omitted and the deuterium atom (²H) is indicated as "D".

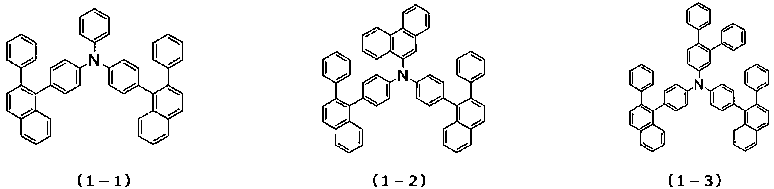

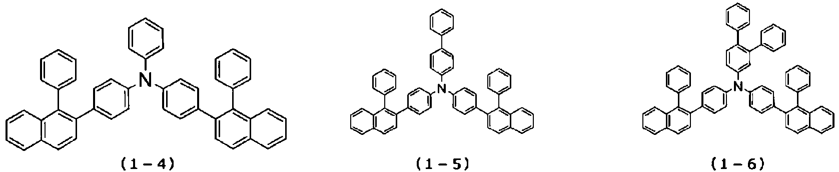

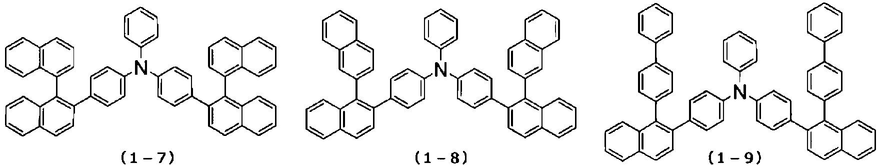

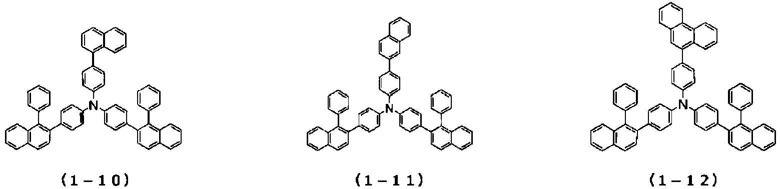

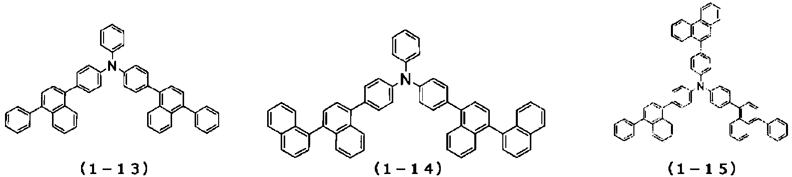

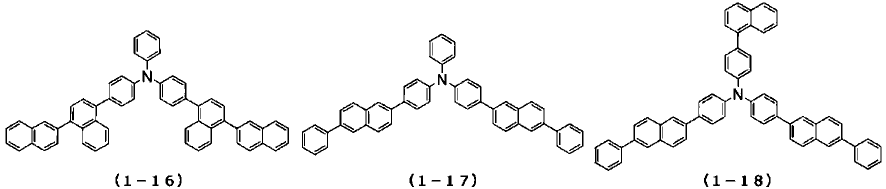

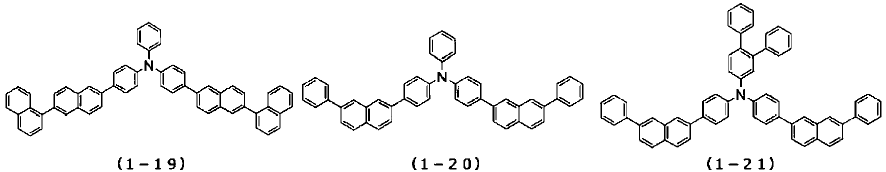

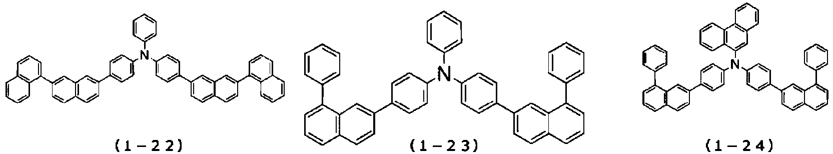

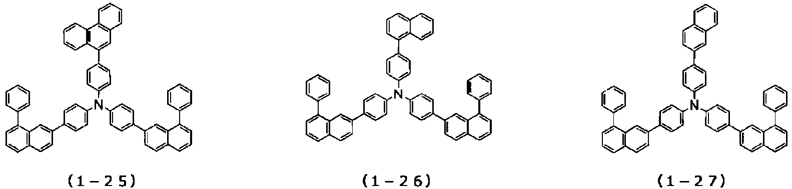

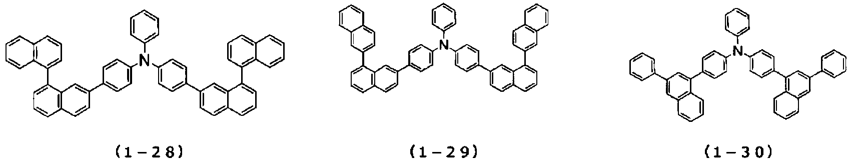

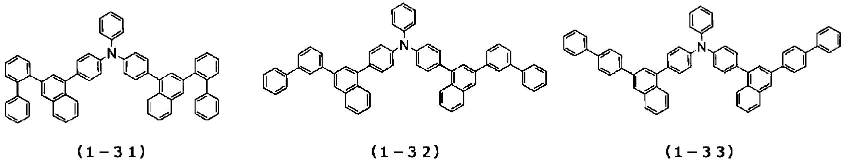

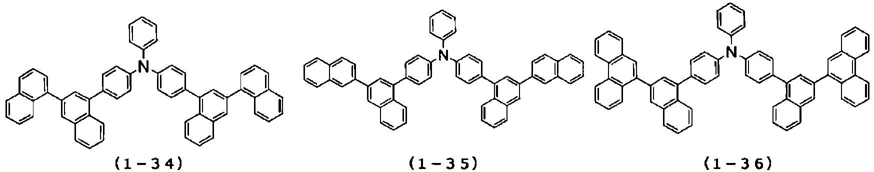

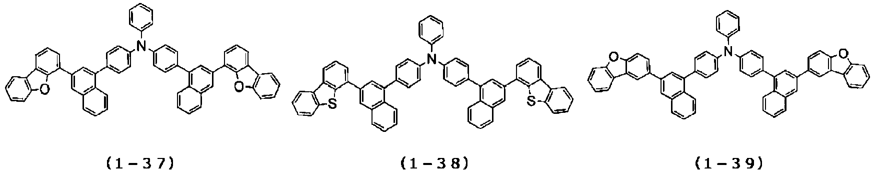

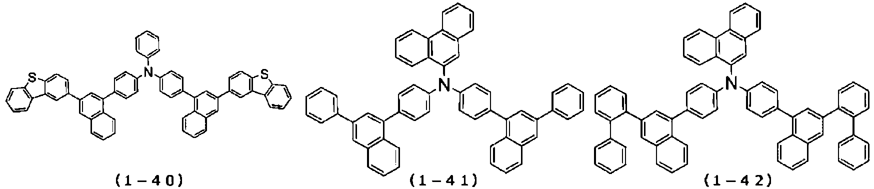

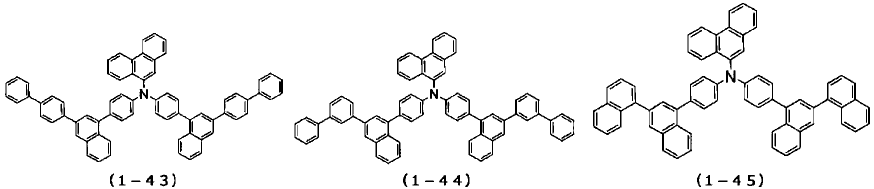

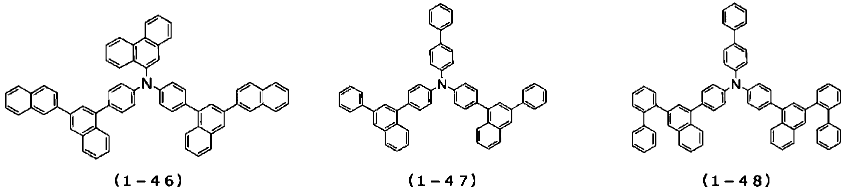

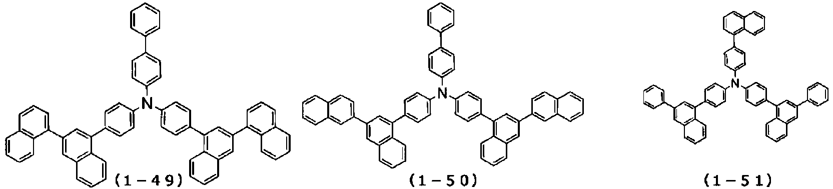

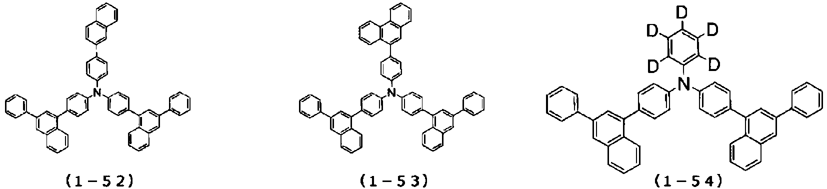

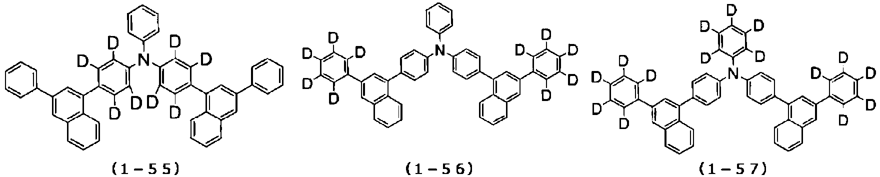

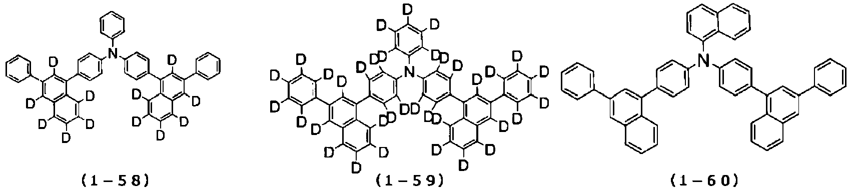

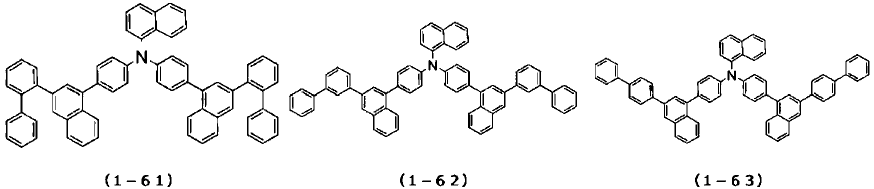

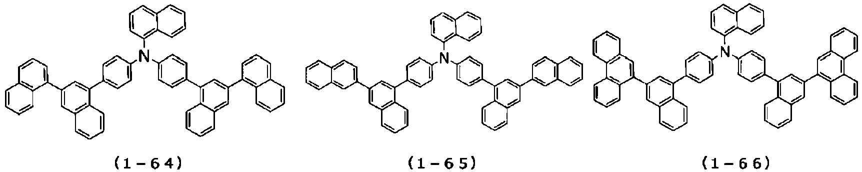

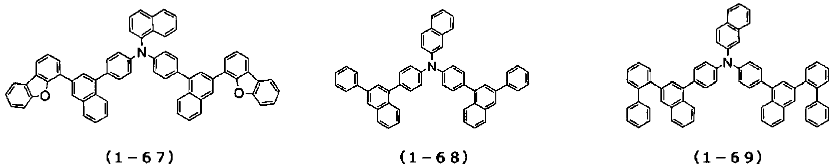

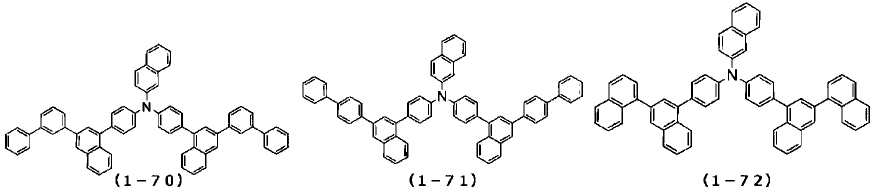

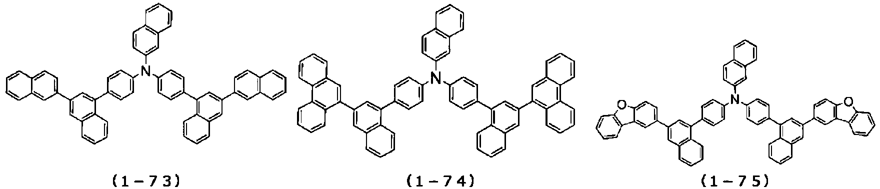

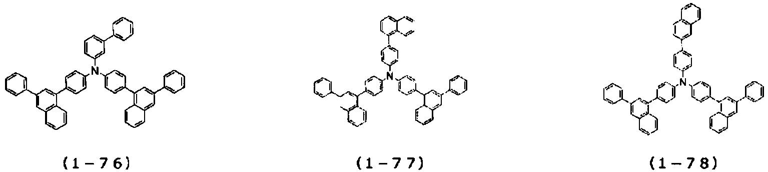

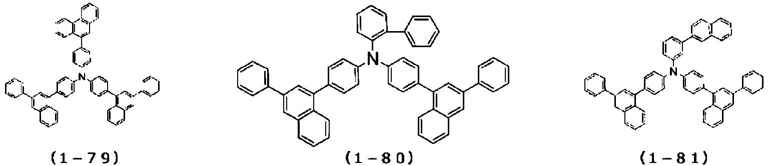

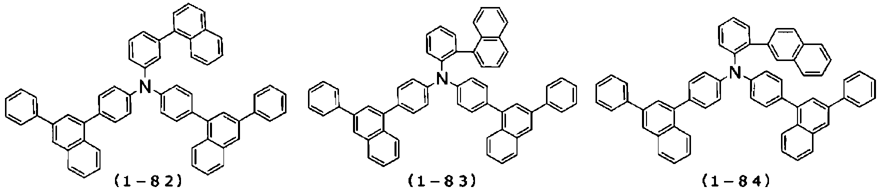

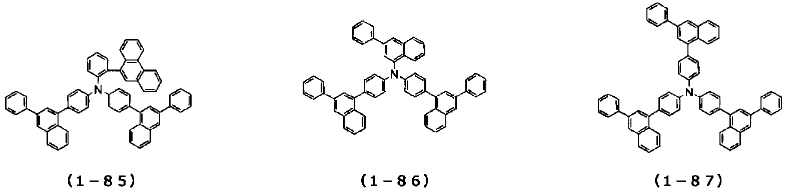

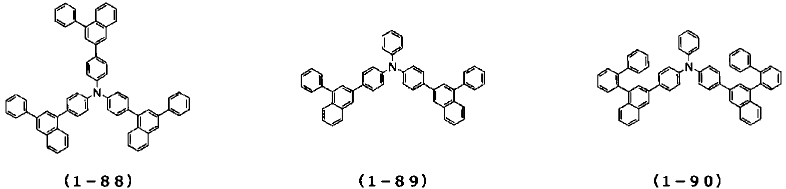

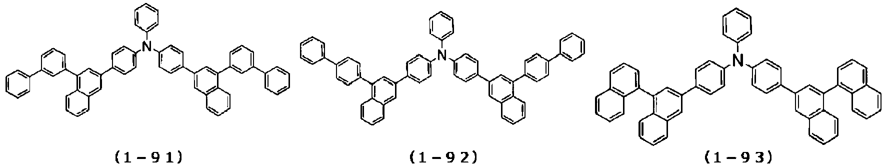

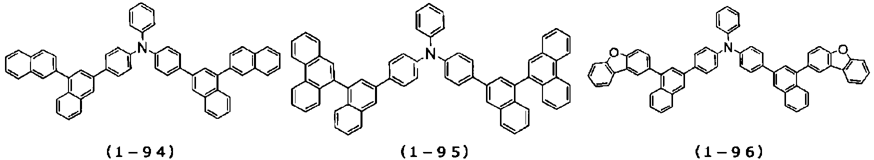

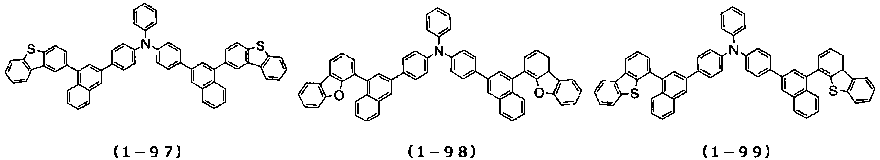

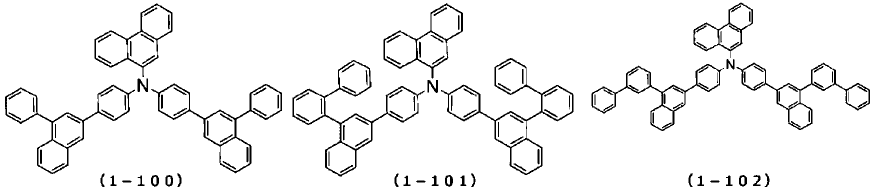

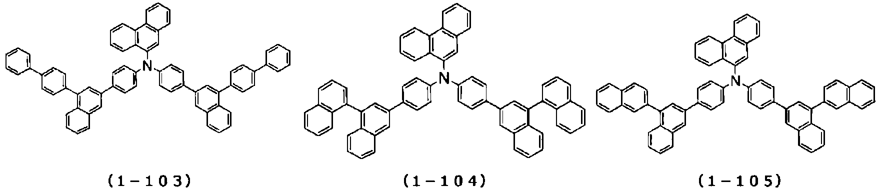

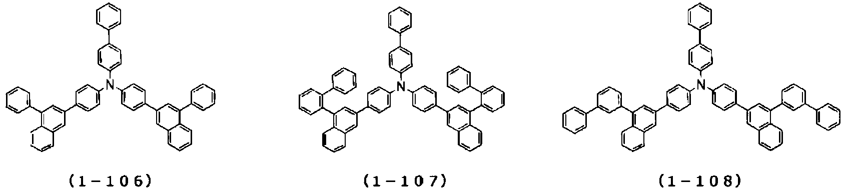

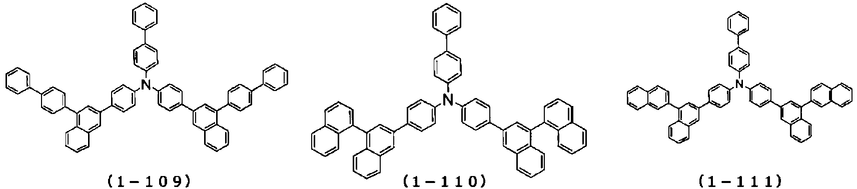

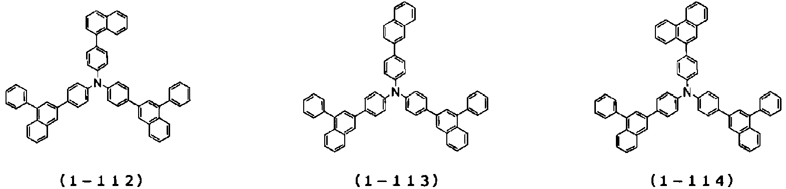

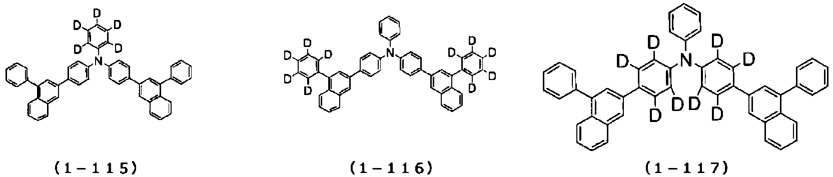

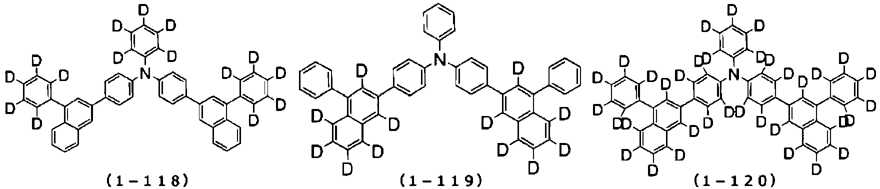

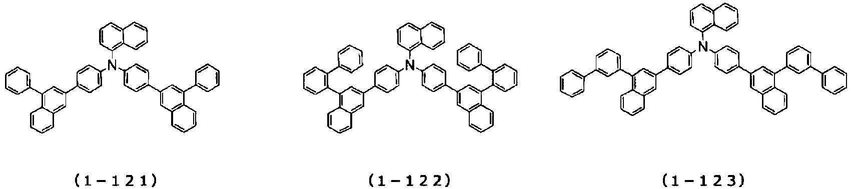

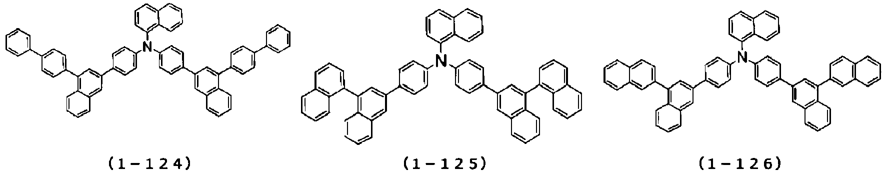

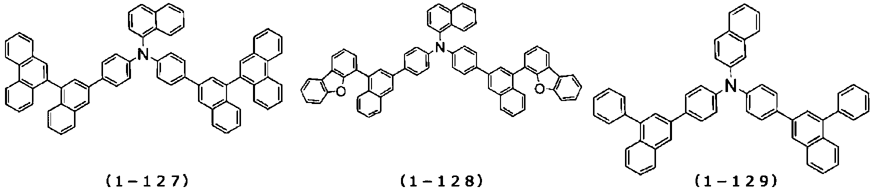

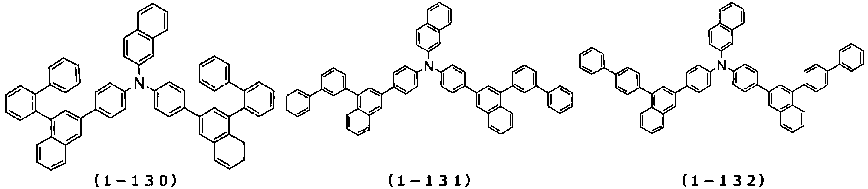

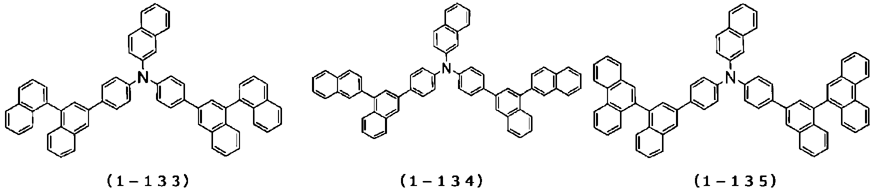

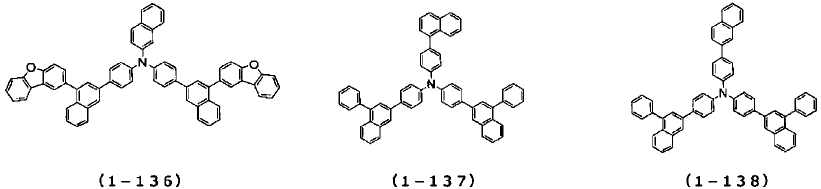

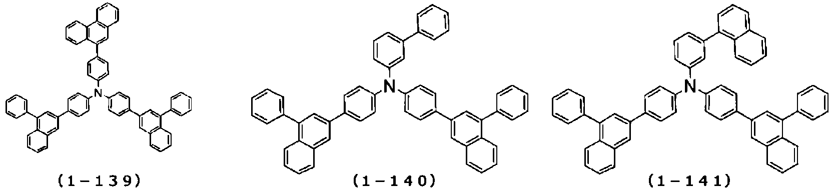

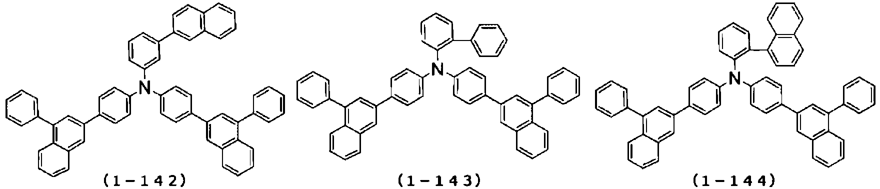

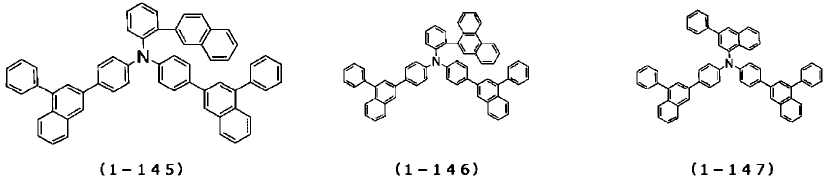

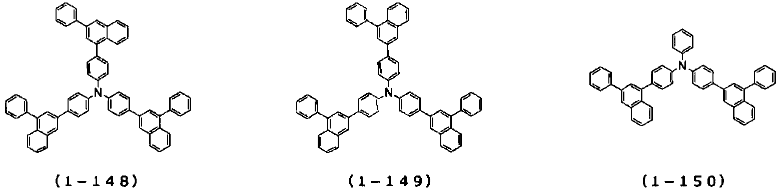

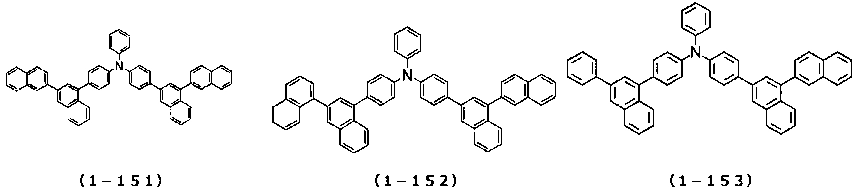

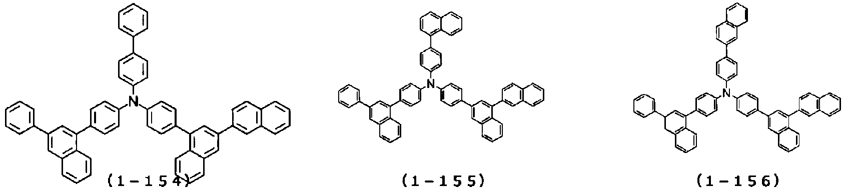

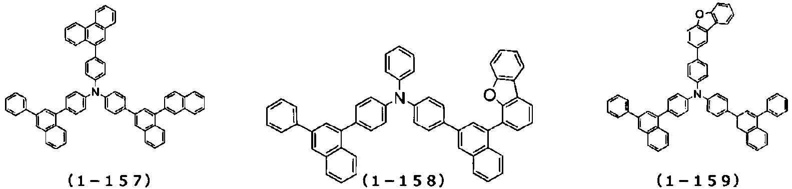

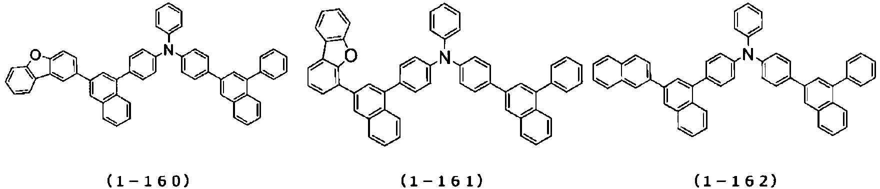

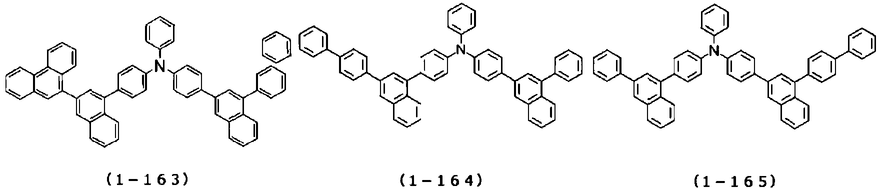

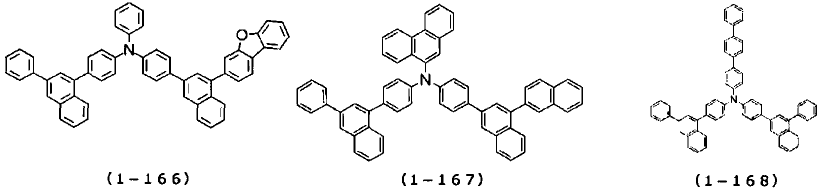

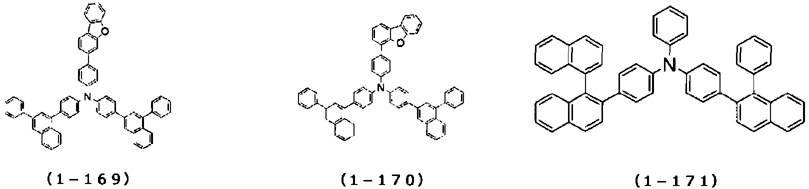

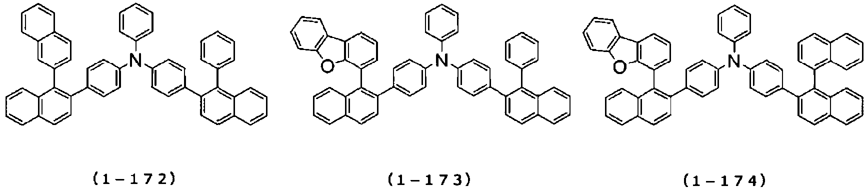

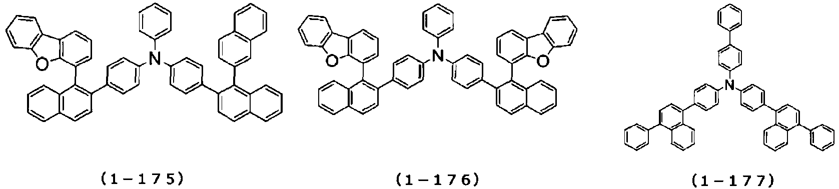

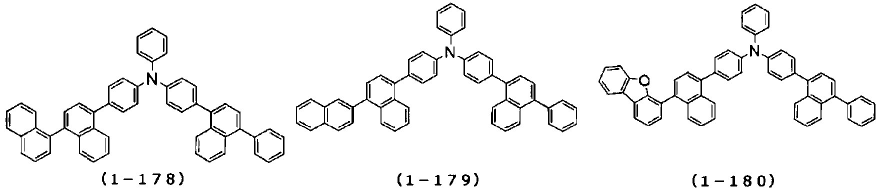

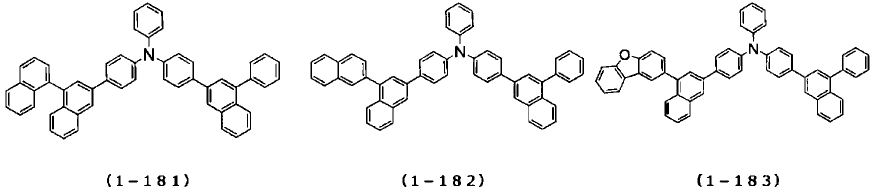

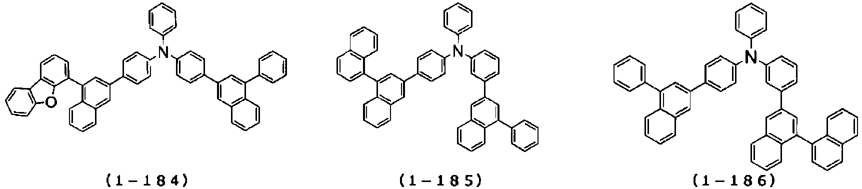

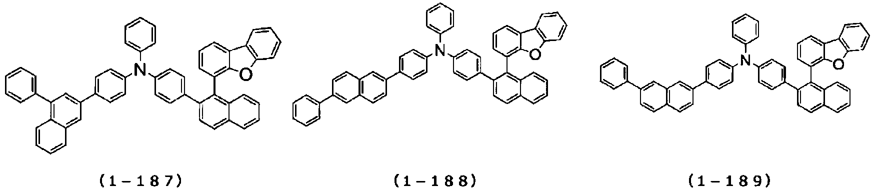

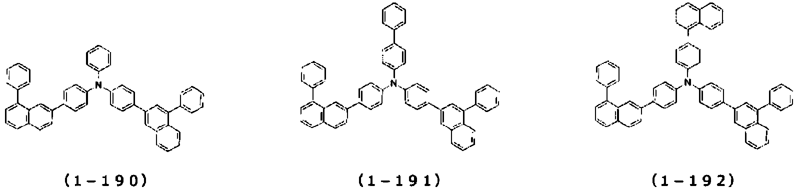

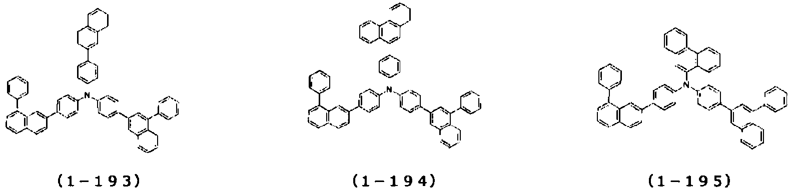

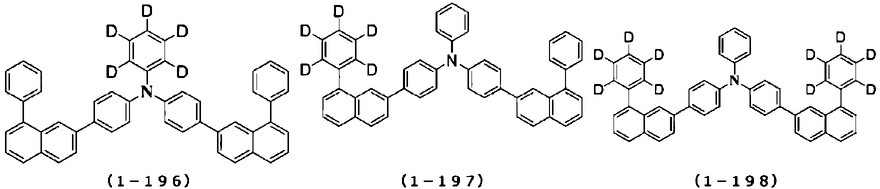

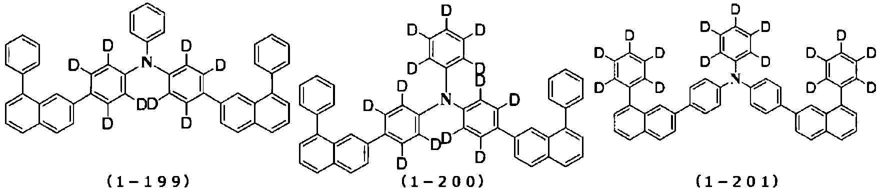

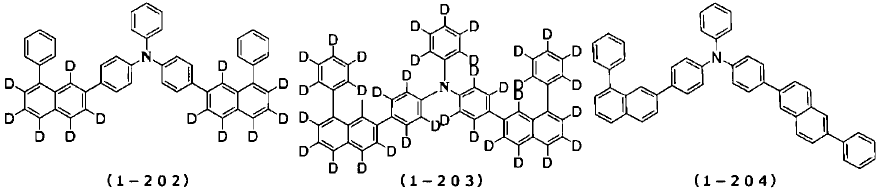

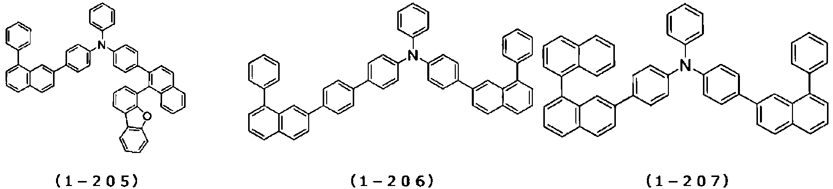

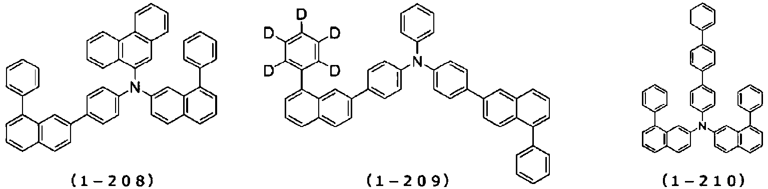

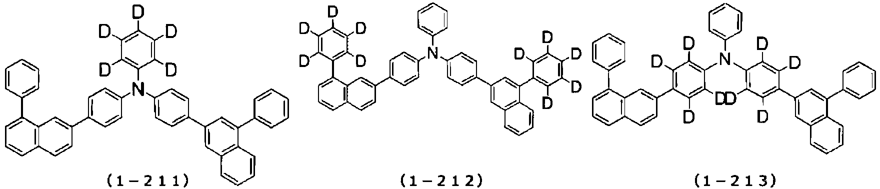

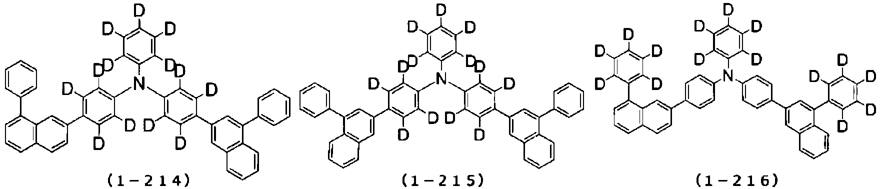

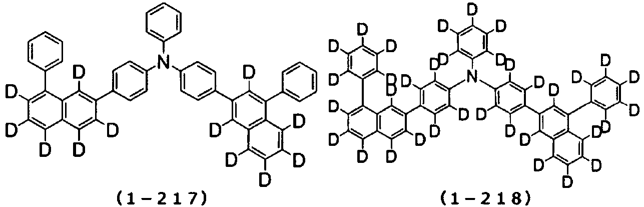

The compound represented by the general formula (1) can be synthesized by applying known coupling reactions and selecting known reaction conditions as appropriate. For details of the reactions, Synthesis Examples described later can be referred to.

The arylamine compound represented by the general formula (1) can be purified by known methods, such as purification by column chromatography, adsorption purification using silica gel, activated charcoal, or activated clay, solvent recrystallization, crystallization, or sublimation purification. The compound can be identified by NMR analysis and mass spectrometry (MS). Physical properties include melting point, glass transition point (Tg) and energy level of HOMO. The melting point is an indicator of deposition properties, the glass transition point (Tg) is an indicator of the stability in a thin film state, and the HOMO energy level is an indicator of hole injection, hole transport, or electron-blocking properties.

### <Organoboron Compound>

The organic electroluminescent device of the invention contains an organoboron compound represented by the above general formula (2-1) or (2-2).

Specific examples of the "aromatic hydrocarbon ring", the "fused polycyclic aromatic hydrocarbon ring", the "aromatic heterocyclic ring" or the "fused polycyclic aromatic heterocyclic ring" in the "substituted or unsubstituted aromatic hydrocarbon ring having 6 to 50 carbon atoms", the "substituted or unsubstituted fused polycyclic aromatic hydrocarbon ring having 10 to 50 carbon atoms", the "substituted or unsubstituted aromatic heterocyclic ring having 2 to 50 carbon atoms", or the "substituted or unsubstituted fused polycyclic aromatic heterocyclic ring having 2 to 50 carbons" represented by Q1 to Q3 in the general formula (2-1) and the general formula (2-2) include a benzene ring; a fused polycyclic aromatic hydrocarbon ring such as an indene ring, a naphthalene ring, an anthracene ring, a pyrene ring, a perylene ring, a fluorene ring, and a phenanthrene ring; an aromatic heterocyclic ring such as a pyridine ring, a pyrimidine ring, a triazine ring, a pyrrole ring, a furan ring, and a thiophene ring; and a fused polycyclic aromatic heterocyclic ring such as a quinoline ring, an isoquinoline ring, a benzofuran ring, a benzothiophene ring, an indole ring, an indoline ring, a carbazole ring, a carboline ring, a benzoxazole ring, a benzothiazole ring, a quinoxaline ring, a benzimidazole ring, a pyrazole ring, a dibenzofuran ring, a dibenzothiophene ring, a naphthyridine ring, a phenanthroline ring, and an acridine ring.

These "rings" can have one or more substituents, and the substituents can be the same groups as those indicated as "substituents" in the "substituted aromatic hydrocarbon group", the "substituted fused polycyclic aromatic hydrocarbon group", the "substituted aromatic heterocyclic group" or the "substituted fused polycyclic aromatic heterocyclic group" represented by A₃, R₁, and R₂ in the general formula (1) above; and these substituents can further have one or more substituents.

These "rings" and substituents or the substituents can bond to each other via a single bond, a substituted or unsubstituted methylene group, N, O, P or S, or can fuse to form a ring. Specific examples of the structure in which a "ring" and a substituent or substituents bond together or fuse to each other to form a ring include the following structures.

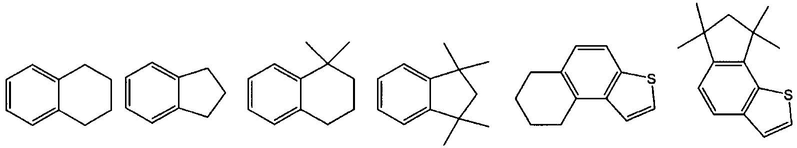

When the "substituent" has a carbon atom, the carbon atom is counted in the "6 to 50 carbon atoms", "10 to 50 carbon atoms", "2 to 50 carbon atoms" in Q1 to Q3 above.

Y₁ to Y₃ in the general formulas (2-1) and (2-2) can be the same as or different from each other and each represent N-R₃, CR₄R₅, O, S, Se, or Si-R₆R₇.
N-R₃ represents a nitrogen atom with R₃ as a substituent,
C-R₄R₅ represents a carbon atom with R₄ and R₅ as substituents,
O represents an oxygen atom, S represents a sulfur atom, Se represents a selenium atom,
Si-R₆R₇ represents a silicon atom with R₆ and R₇ as substituents.

The definitions of R₃ to R₇ are further explained in detail in the description below.

Specific examples of the halogen atom represented by R₃ to R₁₅ and R₁₈ to R₂₀ in the above general formula (2-1), general formula (2-2), general formula (2-A), and general formula (2-B) include a fluorine atom, a chlorine atom, a bromine atom, and an iodine atom.

In the above general formulas (2-1), (2-2), (2-A) and (2-B), specific examples of the "substituted or unsubstituted alkyl group having 1 to 30 carbon atoms", the "cycloalkyl group having 3 to 30 carbon atoms", the "alkenyl group having 2 to 30 carbon atoms", the "cycloalkenyl group having 3 to 30 carbon atoms", or the "heterocycloalkyl group having 1 to 30 carbon atoms" in the "substituted or unsubstituted alkyl group having 1 to 30 carbon atoms" represented by R₃ to R₂₀, in the "substituted or unsubstituted cycloalkyl group having 3 to 30 carbon atoms" represented by R₃ to R₁₅ and R₁₇ to R₂₀, or in the "substituted or unsubstituted alkenyl group having 2 to 30 carbon atoms", the "substituted or unsubstituted cycloalkenyl group having 3 to 30 carbon atoms" or the "substituted or unsubstituted heterocycloalkyl group having 1 to 30 carbon atoms" represented by R₃ to R₁₅ include a linear or branched alkyl group such as a methyl group, an ethyl group, an n-propyl group, an isopropyl group, an n-butyl group, an isobutyl group, a tert-butyl group, an n-pentyl group, an isopentyl group, a neopentyl group, and an n-hexyl group; a cycloalkyl group such as a cyclopentyl group, a cyclohexyl group, a 1-adamantyl group, and a 2-adamantyl group; an alkenyl group such as a vinyl group, an allyl group, an isopropenyl group, and a 2-butenyl group; a cycloalkenyl group such as a cyclopropenyl group, a cyclobutenyl group, a cyclopentenyl group, and a cyclohexenyl group; and a heterocycloalkyl group such as a tetrahydrofuranyl group and a tetrahydrothienyl group.

In the above general formulas (2-1), (2-2), (2-A) and (2-B), the "aromatic hydrocarbon group having 6 to50 carbon atoms", the "fused polycyclic aromatic hydrocarbon group having 10 to 50 carbon atoms", the "aromatic heterocyclic group having 2 to 50 carbon atoms" or the "fused polycyclic aromatic heterocyclic group having 2 to 50 carbon atoms" in the "substituted or unsubstituted aromatic hydrocarbon group having 6 to 50 carbon atoms" represented by R₃ to R₂₀, the "substituted or unsubstituted fused polycyclic aromatic hydrocarbon group having 10 to 50 carbon atoms" represented by R₃ to R₁₅ and R₁₇, the "substituted or unsubstituted aromatic heterocyclic group having 2 to 50 carbon atoms" represented by R₃ to R₂₀, or the "substituted or unsubstituted fused polycyclic aromatic heterocyclic group having 2 to 50 carbon atoms" represented by R₃ to R₁₇ includes the same groups as those shown above as the "aromatic hydrocarbon group", the "fused polycyclic aromatic hydrocarbon group", the "aromatic heterocyclic group" or the "fused polycyclic aromatic heterocyclic group" represented by A₃, R₁ and R₂ in the above general formula (1).

In the general formulas (2-1), (2-2), (2-A) and (2-B), specific examples of the "alkoxy group having 1 to 30 carbon atoms", the "aryloxy group having 6 to 30 carbon atoms", the "alkylthio group having 1 to 30 carbon atoms", or the "arylthio group having 5 to 30 carbon atoms" in the "substituted or unsubstituted alkoxy group having 1 to 30 carbon atoms" represented by R₃ to R₁₅ and R₁₈ to R₂₀, the "substituted or unsubstituted aryloxy group having 6 to 30 carbon atoms" represented by R₃ to R₁₅, the "substituted or unsubstituted alkylthio group having 1 to 30 carbon atoms" represented by R₃ to R₁₅ and R₁₈ to R₂₀, or the "substituted or unsubstituted arylthio group having 5 to 30 carbon atoms" represented by R₃ to R₁₅ include an alkoxy group such as a methoxy group, an ethoxy group, an n-propyloxy group, an isopropyloxy group, an n-butyloxy group, a tert-butyloxy group, an n-pentyloxy group, and an n-hexyloxy group; an aryloxy group such as a phenyloxy group, a biphenylyloxy group, a terphenylyloxy group, a naphthyloxy group, an anthracenyloxy group, a phenanthrenyloxy group, a fluorenyloxy group, an indenyloxy group, a pyrenyloxy group, and a perylenyloxy group; an alkylthio group such as an methylthio group, an ethylthio group, an n-propylthio group, an isopropylthio group, an n-butylthio group, an isobutylthio group, a tert-butylthio group, an n-pentylthio group, an isopentylthio group, a neopentylthio group, and an n-hexylthio group; and an arylthio group such as a phenylthio group, a biphenylylthio group, a terphenylylthio group, a naphthylthio group, an anthracenylthio group, a phenanthrenylthio group, a fluorenylthio group, an indenylthio group, a pyrenylthio group, and a perylenylthio group.

In the general formulas (2-1), (2-2), (2-A) and (2-B), specific examples of the "amino group having 0 to 30 carbon atoms" or the "silyl group having 3 to 30 carbon atoms" in the "substituted or unsubstituted amino group having 0 to 30 carbon atoms" or the "substituted or unsubstituted silyl group having 3 to 30 carbon atoms" represented by R₃ to R₁₅ and R₁₈ to R₂₀ include an unsubstituted amino group; a monoalkylamino group such as a methylamino group, an ethylamino group, an n-propylamino group, an isopropylamino group, an n-butylamino group, an isobutylamino group, a tert-butylamino group, an n-pentylamino group, an isopentylamino group, a neopentylamino group, and an n-hexylamino group; a dialkylamino group such as a dimethylamino group, a diethylamino group, a di-n-propylamino group, and a diisopropylamino group; a monoarylamino group such as a phenylamino group, a biphenylamino group, a terphenylylamino group, a naphthylamino group, an anthracenylamino group, a phenanthrenylamino group, a fluorenylamino group, an indenylamino group, a pyrenylamino group, and a perylenylamino group; a diarylamino group such as a diphenylamino group, a bis(biphenylyl)amino group, a bis(terphenyl)amino group, a dinaphthylamino group, a dianthracenylamino group, a difluorenylamino group, a diindenylamino group, and an N-phenyl-N-naphthylamino group; an alkylarylamino group such as a N-methyl-N-phenylamino group; an alkylsilyl group such as a trimethylsilyl group, a triethylsilyl group, a tri-n-propylsilyl group, a triisopropylsilyl group, an n-butyldimethylsilyl group, an isobutyldimethylsilyl group, and a tert-butyldimethylsilyl group; an arylsilyl group such as a triphenylsilyl group, a trinaphthylsilyl group, a terphenylylsilyl group, and a tris(terphenylyl)silyl group; and an alkylarylsilyl group such a tert-butyldiphenylsilyl group.

Specific examples of the "alkynyl group having 2 to 30 carbons" in the "substituted or unsubstituted alkynyl group having 2 to 30 carbons" represented by R₈ to R₁₅ in general formula (2-A) include an ethynyl group, a 2-propynyl group, and 2-butynyl group.

Specific examples of the "germanium group having 0 to 30 carbon atoms", the "boron group having 0 to 30 carbon atoms", the "aluminum group having 0 to 30 carbon atoms", the "substituted phosphoryl group having 0 to 30 carbon atoms", the "selenium group having 0 to 30 carbon atoms", or the "tellurium group having 0 to 30 carbon atoms" in the "substituted or unsubstituted germanium group having 0 to 30 carbon atoms", the "substituted or unsubstituted boron group having 0 to 30 carbon atoms", the "substituted or unsubstituted aluminum group having 0 to 30 carbon atoms", the "substituted phosphoryl group having 0 to 30 carbon atoms", the "substituted or unsubstituted selenium group having 0 to 30 carbon atoms", or the "substituted or unsubstituted tellurium group having 0 to 30 carbon atoms" represented by R₈ to R₁₅ in the general formula (2-A) include a germanium group such as a triphenylgermanium group; a boron group such as a pinacol boryl group and a diphenylboryl group; an aluminum group such as a diphenylaluminum group; a substituted phosphoryl group such as a diphenylphosphoryl group; a selenium group such as a phenylselenyl group; and a tellurium group such as phenyl tellurides.

Regarding the "substituted alkyl group", the "substituted cycloalkyl group", the "substituted alkenyl group", the "substituted cycloalkenyl group", the "substituted heterocycloalkyl group", the "substituted aromatic hydrocarbon group", the "substituted fused polycyclic aromatic hydrocarbon group", the "substituted aromatic heterocycle group", the "substituted fused polycyclic aromatic heterocyclic group", the "substituted alkoxy group", the "substituted aryloxy group", the "substituted alkylthio group", the "substituted arylthio group", the "substituted amino group", the "substituted silyl group", "substituted alkynyl group", the "substituted germanium group", the "substituted boron group", the "substituted aluminum group", the "substituted phosphoryl group", the "selenium group", or the "substituted tellurium group" represented by R₃ to R₂₀ in the general formula (2-1), the general formula (2-2), the general formula (2-A) and the general formula (2-B), these groups can have one or more substituents, and the "substituents" can be the same groups as those indicated as "substituents" in the "substituted aromatic hydrocarbon group", the "substituted fused polycyclic aromatic hydrocarbon group", the "substituted aromatic heterocyclic group" or the "substituted fused polycyclic aromatic heterocyclic group" represented by A₃, R₁ and R₂ in the general formula (1) above. These "substituents" can further have one or more substituents. These substituents can bond to the adjacent group via a single bond, a substituted or unsubstituted methylene group, N, S or O, or can fuse to form a ring.

When the "substituent" has a carbon atom, the carbon atom is counted in the "1 to 30 carbon atoms", "3 to 30 carbon atoms", "2 to 30 carbon atoms", "6 to 50 carbon atoms", "10 to 50 carbon atoms", "2 to 50 carbon atoms", "6 to 30 carbon atoms", "5 to 30 carbon atoms" and "0 to 30 carbon atoms" in R₃ to R₂₀ above.

R₃ to R₇ in Y₁ to Y₃ in the above general formulas (2-1) ad (2-2) each bond to any of Q1 to Q3 via a single bond, N, O or S, or fuse to form a fused ring, and R₄ and R₅, and R₆ and R₇ may each bond to each other to further form a ring. The "ring" to be formed can be either alicyclic or aromatic, and can be a fused ring of alicyclic rings, aromatic rings, or an alicyclic ring and an aromatic ring. Specific examples of the "alicyclic ring" include a cycloalkane ring such as a cyclopentane ring, a cyclohexane ring, and an adamantane ring; a cycloalkene ring such as a cyclopentene ring and a cyclohexene ring; and a heterocycloalkane ring such as a tetrahydrofuran ring and a tetrahydrothiophene ring; and specific examples of the "aromatic ring" include the same rings as those shown as the "aromatic hydrocarbon ring", the "fused polycyclic aromatic hydrocarbon ring", the "aromatic heterocyclic ring", or the "fused polycyclic aromatic heterocyclic ring" represented by Q1 to Q3 in the general formula (2-1) and general formula (2-2).

The "aromatic hydrocarbon group", "fused polycyclic aromatic hydrocarbon group", "aromatic heterocyclic group", or "fused polycyclic aromatic heterocyclic group" represented by R₃ to R₁₅ and R₁₇ in the above general formula (2-1) and general formula (2-2) is preferably a phenyl group, a biphenylyl group, a terphenylyl group, a naphthyl group, an anthracenyl group, a phenanthrenyl group, a pyridyl group, a pyrimidinyl group, a triazinyl group, a furyl group, a pyrrolyl group, or a thienyl group.

The "halogen atom" represented by R₂₁ in the above general formulas (2-3) to (2-6) include the same groups as those shown as the "halogen atom" represented by R₃ to R₁₅ and R₁₈ to R₂₀ in the above general formulas (2-1), (2-2), (2-A) and (2-B).

In the "substituted or unsubstituted alkyl group having 1 to 30 carbon atoms" or the "substituted or unsubstituted cycloalkyl group having 3 to 30 carbon atoms" represented by R₂₁ in the above general formulas (2-3) to (2-6), the "alkyl group having 1 to 30 carbon atoms" or the "cycloalkyl group having 3 to 30 carbons" includes the same groups as those shown as the "alkyl group having 1 to 30 carbons" represented by R₃ to R₂₀ and the "cycloalkyl groups having 3 to 30 carbons" represented by R₃ to R₁₅ and R₁₇ to R₂₀ in the above general formulas (2-1), (2-2), (2-A), and (2-B).

In the above general formulas (2-3) to (2-6), the "aromatic hydrocarbon group having 6 to 50 carbon atoms", the "fused polycyclic aromatic hydrocarbon group having 10 to 30 carbon atoms", the "aromatic heterocyclic group having 2 to 50 carbon atoms" or the "fused polycyclic aromatic heterocyclic group having 2 to 30 carbon atoms" in the "substituted or unsubstituted aromatic hydrocarbon group having 6 to 50 carbon atoms", the "substituted or unsubstituted fused polycyclic aromatic hydrocarbon group having 10 to 30 carbon atoms", the "substituted or unsubstituted aromatic heterocyclic group having 2 to 50 carbon atoms", or the "substituted or unsubstituted fused polycyclic aromatic heterocyclic group having 2 to 30 carbon atoms" represented by R₂₁ includes the same groups as those shown above as the "aromatic hydrocarbon group", the "fused polycyclic aromatic hydrocarbon group", the "aromatic heterocyclic group" or the "fused polycyclic aromatic heterocyclic group" represented by A₃, R₁ and R₂ in the above general formula (1).

In the above general formulas (2-3) to (2-6), the "alkoxy group having 1 to 30 carbon atoms", the "aryloxy group having 6 to 30 carbon atoms", the "alkylthio group having 1 to 30 carbon atoms", or the "arylthio group having 5 to 30 carbon atoms" in the "substituted or unsubstituted alkoxy group having 1 to 30 carbon atoms", the "substituted or unsubstituted aryloxy group having 6 to 30 carbon atoms", the "substituted or unsubstituted alkylthio group having 1 to 30 carbon atoms" or the "substituted or unsubstituted arylthio group having 5 to 30 carbon atoms" represented by R₂₁ includes the same groups as those shown above as he "substituted or unsubstituted alkoxy group having 1 to 30 carbon atoms" represented by R₃ to R₁₅ and R₁₈ to R₂₀, the "aryloxy group" represented by R₃ to R₁₅, the "substituted or unsubstituted alkylthio group having 1 to 30 carbon atoms" represented by R₃ to R₁₅ and R₁₈ to R₂₀, or the "arylthio group having 5 to 30 carbon atoms" represented by R₃ to R₁₅ in the above general formulas (2-1), (2-2), (2-A), and (2-B).

In the "substituted or unsubstituted alkylamino group having 1 to 30 carbon atoms", the "substituted or unsubstituted arylamino group having 5 to 30 carbon atoms", the "substituted or unsubstituted alkylsilyl group having 1 to 30 carbon atoms", or the "substituted or unsubstituted arylsilyl group having 5 to 30 carbon atoms" represented by R₂₁ in the above general formulas (2-3) to (2-6), the "alkylamino group having 1 to 30 carbon atoms", the "arylamino group having 5 to 30 carbon atoms", the "alkylsilyl group having 1 to 30 carbon atoms" or the "arylsilyl group having 5 to 30 carbon atoms" includes the same groups as those shown as the "amino group having 0 to 30 carbon atoms" or the "silyl group having 3 to 30 carbon atoms" represented by R₃ to R₁₅ and R₁₈ to R₂₀ in the above general formulas (2-1), (2-2), (2-A), and (2-B).

Regarding the "substituted alkyl group", the "substituted cycloalkyl group", the "substituted aromatic hydrocarbon group", the "substituted fused polycyclic aromatic hydrocarbon group", the "substituted aromatic heterocyclic group", the "substituted fused polycyclic aromatic heterocyclic group", the "substituted alkoxy group", the "substituted aryloxy group", the "substituted alkylthio group", the "substituted arylthio group", the "substituted amino group" or "the substituted silyl group" represented by R₂₁ in the above general formulas (2-3) to (2-6), these groups can have one or more substituents, and the "substituents" can be the same groups as those indicated as "substituents" in the "substituted aromatic hydrocarbon group", the "substituted fused polycyclic aromatic hydrocarbon group", the "substituted aromatic heterocyclic group" or the "substituted fused polycyclic aromatic heterocyclic group" represented by A₃, R₁ and R₂ in the general formula (1) above. These "substituents" can further have one or more substituents. These substituents can bond to the adjacent group via a single bond, a substituted or unsubstituted methylene group, N, S or O, or can fuse to form a ring.

When the "substituent" has a carbon atom, the carbon atom is counted in the "1 to 30 carbon atoms", "3 to 30 carbon atoms", "6 to 50 carbon atoms", "10 to 30 carbon atoms", "2 to 50 carbon atoms", "2 to 30 carbon atoms", "6 to 30 carbon atoms", and "5 to 30 carbon atoms" in R₂₁ above.

The organoboron compound used in the invention can be selected from the group shown below. For example, the compound can be selected from Compound Group 101 represented by the general formula (2-3), from Compound Group 102 represented by the general formula (2-4), from Compound Group 103 represented by the general formula (2-5), and from Compound Group 104 represented by the general formula (2-6). In the general formulas (2-1) to (2-6), the compound can be selected from Compound Group 105 in which Y₁ is O, can be selected from Compound Group 106 in which Y₁ is S, can be selected from Compound Group 107 in which Y₂ and Y₃ are the same, can be selected from Compound Group 108 in which Y₂ and Y₃ are different from each other, can be selected from Compound Group 109 in which one of Y₂ and Y₃ is N-R₃ and the other is CR₄R₅, O, S, Se, or SiR₆R₇, can be selected from Compound Group 110 in which Y₂ and Y₃ each are independently N-R₃, can be selected from Compound group 111 in which at least one of Y₂ and Y₃ is N-R₃ where R₃ is a substituted or unsubstituted aromatic hydrocarbon group having 6 to 50 carbon atoms (e.g., a phenyl group substituted with an alkyl group having 3 to 20 carbon atoms, e.g., a phenyl group substituted with an aromatic hydrocarbon group having 6 to 14 carbon atoms), or can be selected from Compound group 112 in which at least one of Y₂ and Y₃ is N-R₃ where R₃ is a substituted or unsubstituted fused polycyclic aromatic heterocyclic group having 2 to 50 carbon atoms (e.g., a substituted or unsubstituted dibenzofuranyl group, e.g., a substituted or unsubstituted dibenzothienyl group). Also the compound can be selected from Compound Group 113 in which in the general formulas (2-3) to (2-6), all Z's are C-H or C-D, can be selected from Compound Group 114 in which at least one Z is C-R₂₁ and R₂₁ is an alkyl group having 1 to 20 (e.g., 3 to 20) carbon atoms, can be selected from Compound Group 115 in which at least one Z is C-R₂₁ and R₂₁ is a substituted or unsubstituted aromatic hydrocarbon group having 6 to 50 carbon atoms, can be selected from Compound Group 116 in which at least one Z is C-R₂₁ and R₂₁ is a substituted or unsubstituted fused polycyclic aromatic heterocyclic group having 2 to 30 carbon atoms (e.g., a substituted or unsubstituted dibenzofuranyl group, e.g., a substituted or unsubstituted dibenzothienyl group), can be selected from Compound Group 117 in which at least one Z is C-R₂₁ and R₂₁ is a substituted or unsubstituted arylamino group having 5 to 30 carbon atoms (e.g., a diphenylamino group optionally substituted with an alkyl group having 1 to 20 carbon atoms or with an aromatic hydrocarbon group having 6 to 20 carbon atoms), or can be selected from Compound Group 118 in which at least one Z constituting each ring is C-R₂₁ and R₂₁ is a substituted or unsubstituted alkyl group having 1 to 30 carbon atoms, a substituted or unsubstituted aromatic hydrocarbon group having 6 to 50 carbon atoms, a substituted or unsubstituted fused polycyclic aromatic heterocyclic group having 2 to 30 carbon atoms, or a substituted or unsubstituted arylamino group having 5 to 30 carbon atoms. When the overlap range between Group 107 and each of Group 113 through Group 118 is designated in order as Group 119 through Group 124; the overlap range between Group 108 and each of Group 113 through Group 118 is designated in order as Group 125 through Group 130; the overlap range between Group 109 and each of Group 113 through Group 118 is designated in order as Group 131 through Group 136; the overlap range between Group 110 and each of Group 113 through Group 118 is designated in order as Group 137 through Group 142; the overlap range between Group 111 and each of Group 113 through Group 118 is designated in order as Group 143 through Group 148; and the overlap range between Group 112 and each of Group 113 through Group 118 is designated in order as Group 149 through Group 154, then the organoboron compound used in the invention can be selected from any of Groups 119 to 154.

The following are examples of selection conditions when selecting the organoboron compound to be used in the invention from the compound group represented by the general formula (2-1). As an example of selection conditions, a compound in which Y₁ is N-R₃, CR₄R₅, O, Se, or SiR₆R₇ can be selected, and for example, a compound in which Y₁ is O can be selected (condition 1). A compound in which at least one of Y₂ and Y₃ is CR₄R₅, O, S, Se, or SiR₆R₇ can also be selected, for example, a compound in which at least one of Y₂ and Y₃ is O can be selected (condition 2). A compound in which Y₂ and Y₃ are the same N-R₃ as each other, e.g., a compound in which the two R₃'s are both substituted or unsubstituted aromatic hydrocarbon groups having 6 to 50 carbons, substituted or unsubstituted fused polycyclic aromatic hydrocarbon groups having 10 to 50 carbons, substituted or unsubstituted aromatic heterocyclic groups having 2 to 50 carbons, or substituted or unsubstituted fused polycyclic aromatic heterocyclic groups having 2 to 50 carbons can be selected (condition 3). A compound in which one of or both Y₂ and Y₃ are N-R₃ and at least one R₃ is a fused polycyclic aromatic hydrocarbon group represented by the general formula (2-A) can be selected, for example, only one R₃ is a fused polycyclic aromatic hydrocarbon group represented by the general formula (2-A) can be selected, and a compound in which both Y₂ and Y₃ are N-R₃ and two R₃'s are fused polycyclic aromatic hydrocarbon groups represented by general formula (2-A) can be selected (Condition 4). A compound in which Y₂ and Y₃ are different N-R₃, and R₃ is an aromatic hydrocarbon group having 6 to 50 carbon atoms, which is substituted with any other than a deuterium atom or is unsubstituted, or a fused polycyclic aromatic hydrocarbon group having 10 to 50 carbons, which is substituted with any other than a deuterium atom or is unsubstituted, or an aromatic heterocyclic group having 2 to 50 carbon atoms, which is substituted with any other than a deuterium atom or is unsubstituted, or a fused polycyclic aromatic heterocyclic group having 2 to 50 carbons, which is substituted with any other than a deuterium atom or is unsubstituted, can be selected (Condition 5). In addition, the compound can also be selected from the compound group in which at least one of Q1 to Q3 is an unsubstituted ring, and for example, can be selected from the compound group in which all Q1 to Q3 are unsubstituted rings, for example, can be selected from the compound group in which two of Q1 to Q3 are unsubstituted rings, or can be selected from the compound group in which one of Q1 to Q3 is an unsubstituted ring (Condition 6). Furthermore, the compound can be selected from the compound group simultaneously satisfying two or more of Conditions 1 to 6.

Hereinafter, specific examples of the organoboron compounds represented by the general formula (2-1) or the general formula (2-2) will be given. However, the organoboron compound that can be used in the invention should not be construed as being limited by these specific examples. In the chemical structural formulae below, the hydrogen atom (¹H) is omitted and the deuterium atom (²H) is indicated as "D".

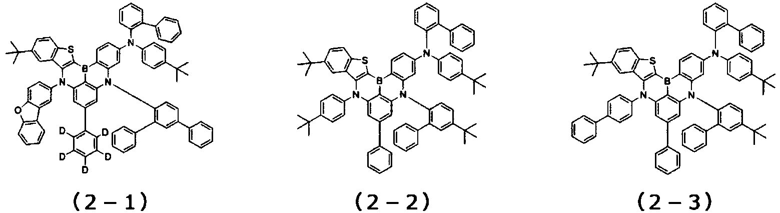

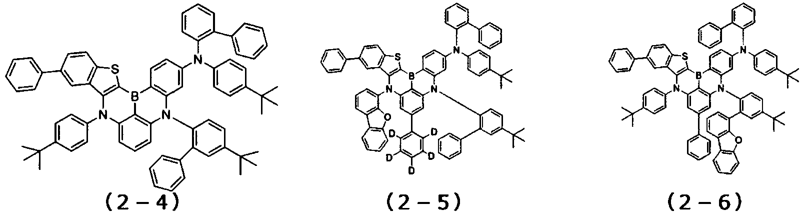

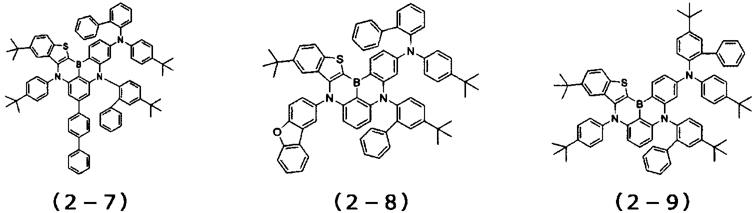

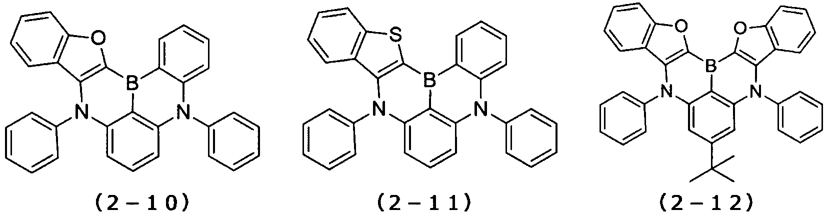

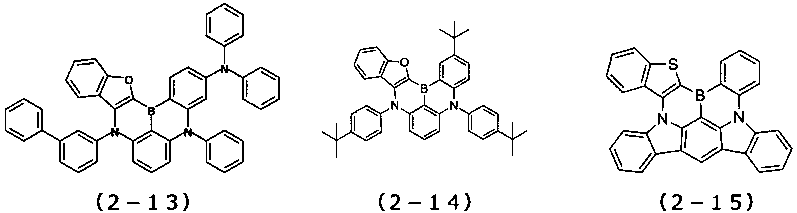

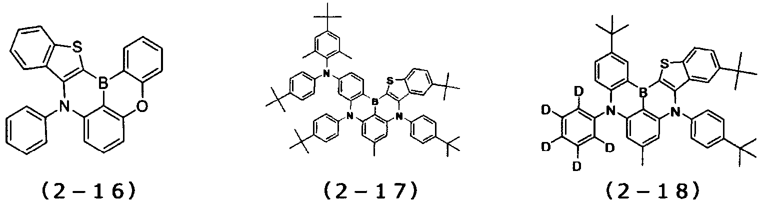

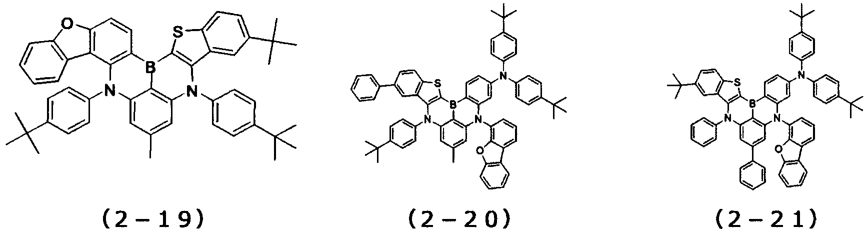

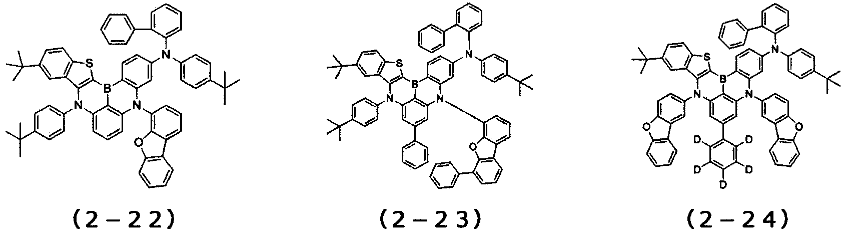

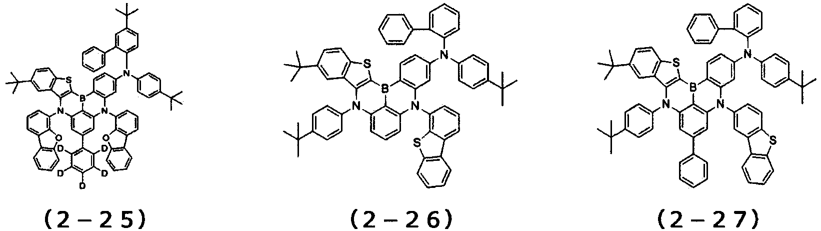

As the organoboron compound to be used in the invention, a compound represented by general formula (2-1) or general formula (2-2) and having a structure other than a compound (2-18) can be selected. For example, the compound can be selected from the group consisting of the above compounds (2-1) to (2-17) and the above compounds (2-19) to (2-27).

The organoboron compound used in the invention can be selected from the group consisting of compounds 1 to 87 listed in [0059] to [0067] of KR10-2453929B1. The organoboron compound used in the invention can be selected from the group consisting of compounds 1 to 176 listed in [0054] to [0141] of KR10-2094830B1. The organoboron compound used in the invention can be selected from the group consisting of compounds 1 to 149 and 151-176 listed in [0054] to [0141] of KR10-2094830B1. The organoboron compound used in the invention can be selected from the group consisting of compounds 1 to 156 listed in [0065] to [0077] of KR10-2022-0051822A. The description of the Korean Patent Publications described in this paragraph are hereby incorporated as a part of this description by reference. The organoboron compound represented by the general formula (2-1) or general formula (2-2) can be synthesized by referring to the synthesis procedures described in these publications.

### <Organic Electroluminescent Device>

### [Electrode and Organic Layer Constituting Device]

The organic electroluminescent device (organic EL device) of the invention has an anode, a cathode, and an organic layer sandwiched between the anode and the cathode, in which at least one organic layer contains a compound represented by the general formula (1), and at least one organic layer contains a compound represented by the general formula (2-1) or general formula (2-2).

The organic layers that the organic EL device of the invention has at least include a light-emitting layer, and the organic layers of the device can be light-emitting layers alone, or the device can have one or more organic layers in addition to a light-emitting layer. Preferably, the device has one or more additional organic layers between the anode and the light-emitting layer, and has one or more additional organic layers between the cathode and the light-emitting layer. Specific examples of the organic layers placed between the light-emitting layer and the anode include a hole injection layer, a hole transport layer, and an electron-blocking layer; and specific examples of the organic layers placed between the light-emitting layer and the cathode include a hole-blocking layer, an electron transport layer, and an electron injection layer. Here, the compound represented by the general formula (1) can be contained in the light-emitting layer, or can be contained in any other organic layer than the light-emitting layer, but is preferably contained in the organic layer disposed between the light-emitting layer and the anode. Preferably, the compound represented by the general formula (1) is contained in one or more of the hole injection layer, the hole transport layer and the electron-blocking layer, more preferably in one or more of the hole transport layer and the electron-blocking layer, more preferably in the electron-blocking layer. For example, the compound represented by the general formula (1) can be contained in only one of the organic layers placed between the anode and the light-emitting layer, for example, in only the electron-blocking layer, or for example, in only the hole transport layer. The compound represented by the general formula (1) has excellent hole injection and transport performance, electron-blocking performance, thin film stability, and durability. Consequently, the organic EL device having a hole injection layer, a hole transport layer, and/or an electron-blocking layer fabricated using the compound as a hole injection material, a hole transport material, and/or an electron-blocking material thereby improves the hole transport efficiency to the light-emitting layer, thereby increasing the light emission efficiency and lowering the drive voltage, thereby improving the device durability, and thereby resulting in good characteristics of higher efficiency, lower drive voltage and longer lifetime.

In one aspect of the invention, examples of the organic EL device include one having an anode, a hole transport layer, an electron-blocking layer, a light-emitting layer, an electron transport layer and a cathode sequentially on a substrate, one having a hole injection layer between the anode and the hole transport layer, one having a hole-blocking layer between the light-emitting layer and the electron transport layer, one having an electron injection layer between the electron transport layer and the cathode. In these multilayer structures, some organic layers can be omitted, or one organic layer can play multiple roles, for example, an organic layer can serve as a hole injection layer and a hole transport layer, or an organic layer can serve as an electron injection layer and an electron transport layer. It is also possible to provide a laminate structure with two or more organic layers having the same function, such as a laminate structure with two hole transport layers, a laminate structure with two electron-blocking layers, a laminate structure with two light-emitting layers, and a laminate structure with two electron transport layers. The organic layers constituting the organic EL device each can be formed of a single-material film consisting of a single material, or can be formed of a mixed-material film containing multiple materials. The layer can be a single-layer structure of a single-material film or a mixed-material film, a laminate structure of multiple layers of single-material films, a laminate structure of multiple layers of mixed-material films, or also a laminate structure of one or more layers of single-material films and one or more layers of mixed-material films. These films can be formed by known methods such as vapor deposition, spin-coating, or ink-jetting.

In the following, the constituent members and layers of the organic EL device are described in detail.

### [Anode]

As the anode of the organic EL device of the invention, usable are electrode materials with a large work function, such as ITO (indium tin oxide) and gold.

### [Hole Injection Layer, Hole Transport Layer]

The hole injection layer is provided between the anode and the light-emitting layer or between the anode and the hole transport layer to lower the injection barrier of holes supplied from the anode, thereby lowering the drive voltage and improving the luminance. The hole transport layer is a layer that functions to transport holes. The hole transport layer can be a hole injection transport layer that also functions as a hole injection layer.

The compound represented by the general formula (1) can be used as the materials for the hole injection layer, the hole transport layer and hole injection transport layer. The compound represented by the general formula (1) used in these layers can be one or more of the compounds in the group of compounds represented by the general formula (1). The compound represented by the general formula (1) can be also used in combination with any other hole transport material or hole injection material. Materials that are usable other than the compound represented by the general formula (1) are described below.

As materials for the hole injection layer of the organic EL device of the invention, porphyrin compounds such as copper phthalocyanine, starburst-type triphenylamine derivatives, arylamine compounds having two or more triphenylamine or carbazolyl structures in the molecule which are linked to each other by a single bond or a divalent group that does not contain a heteroatom, acceptor heterocyclic compounds such as hexacyanoazatriphenylene, and coating-type polymer materials, can be used. These materials can be formed into thin films by known methods such as vapor deposition, spin-coating, or ink-jetting.

As hole transport materials for the hole injection layer, the hole transport layer and the hole injection transport layer of the organic EL device of the invention, usable are benzidine derivatives such as N,N'-diphenyl-N,N'-di(m-tolyl)-benzidine (TPD), N,N'-diphenyl-N,N'-di(α-naphthyl)-benzidine (NPD), and N,N,N',N'-tetrabiphenylbenzidine (NPD), 1,1-bis[(di-4-tolylamino)phenyl]cyclohexane (TAPC), and arylamine compounds having two or more triphenylamine or carbazolyl structures in the molecule which are linked to each other by a single bond or a divalent group that does not contain a heteroatom. Coating-type polymer materials such as poly(3,4-ethylenedioxythiophene) (PEDOT)/poly(styrenesulfonate) (PSS) can also be used as the materials for the hole injection layer, the hole transport layer, and the hole injection transport layer. These materials can be formed into thin films by known methods such as vapor deposition, spin-coating, or ink-jetting.

The hole injection layer, the hole transport layer and the hole injection transport layer can also be formed of those prepared by further adding a P-type dopant such as tris-bromophenylamine hexachloroantimony or a radialene derivative described in EP 2684932 to the hole injection or hole transport materials, or those prepared by adding a polymer compound having a structure of a benzidine derivative such as TPD as the partial structure thereof to the materials.

The absolute value of the HOMO energy level of the hole-transport material is preferably larger (i.e., having a deeper HOMO level) than the absolute value of the HOMO level of general hole transport materials such as NPD and TPD (5.4 eV), and is preferably smaller than the absolute value of the HOMO energy level of the electron-blocking material described below. Specifically, the absolute value of the HOMO energy level of the hole transport material is preferably 5.45 eV or more and 5.80 eV or less, more preferably 5.60 eV or more and 5.75 eV or less.

### [Electron-Blocking Layer]

The electron-blocking layer is placed, for example, between the light-emitting layer and the hole transport layer and has the function of suppressing the diffusion of electrons in the light-emitting layer to the outside of the light-emitting layer (toward the hole transport layer). This improves the recombination probability of electrons and holes in the light-emitting layer. Usually, the electron-blocking layer additionally has the function of transporting holes. The electron-blocking layer can also serve as an exciton blocking layer that suppresses the diffusion of excitons from the light-emitting layer.

The compound represented by the general formula (1) can be used as a material for the electron-blocking layer. The compound represented by the general formula (1) has excellent electron-blocking ability, high electron tolerance, and stability in the thin film state, as well as the feature of confining excitons generated in the light-emitting layer. Thereby, the organic EL device using the compound represented by the general formula (1) as an electron-blocking material has high light emission efficiency because the probability of recombination between holes and electrons is improved and thermal deactivation is suppressed, and accordingly, the maximum luminance is improved because the drive voltage is lowered and the current resistance is improved. The compound represented by the general formula (1) used in the electron-blocking layer can be one or more of the compounds in the group of compounds represented by the general formula (1). The compound represented by the general formula (1) can be used in combination with other electron-blocking materials.

As the materials for the electron-blocking layer of the organic EL device of the invention, in addition to the arylamine compound represented by the general formula (1), carbazole derivatives, such as 4,4',4"-tri(N-carbazolyl)triphenylamine (TCTA), 9,9-bis[4-(carbazol-9-yl)phenyl] fluorene, 1,3-bis(carbazol-9-yl)benzene (mCP), and 2,2-bis(4-carbazol-9-ylphenyl)adamantane (Ad-Cz), and compounds having electron-blocking effect such as compounds having a triphenylsilyl group and a triarylamine structure, as typified by 9-[4-(carbazol-9-yl)phenyl]-9-[4-(triphenylsilyl)phenyl]-9H-fluorenone, can also be used.

The absolute value of the HOMO energy level of the electron-blocking material is preferably greater than the absolute value of the HOMO energy level of the hole transport material (i.e., it has a deeper HOMO level). Specifically, the absolute value of the HOMO energy level of the electron-blocking material is preferably 5.55 eV or more and 5.90 eV or less, more preferably 5.60 eV or more and 5.80 eV or less. The absolute value of the HOMO energy level of the electron-blocking material is larger than the absolute value of the HOMO energy level of the hole transport material preferably by 0.05 eV or more and 0.45 eV or less, more preferably 0.05 eV or more and 0.35 eV or less, even more preferably 0.10 eV or more and 0.35 eV or less.

### [Light-Emitting Layer]

The light-emitting layer is a layer that emits light after excitons are generated by the recombination of holes and electrons injected from the anode and cathode, respectively; and the light-emitting layer can be used alone as a light-emitting layer, but preferably contains a light-emitting material and a host material.

The organoboron compound represented by the general formula (2-1) or general formula (2-2) can be preferably used for the light-emitting layer of the organic EL device of the invention. The organoboron compound represented by the general formula (2-1) or general formula (2-2) can be contained only in the light-emitting layer in the organic EL device.

The compound represented by the general formula (1) can be used for organic EL devices, in combination with the compound represented by the general formula (2-1) or (2-2) to achieve even better effects. In other words, by combining a compound represented by the general formula (1) with a compound represented by the general formula (2-1) or (2-2) and using them in an organic EL device, the light emission efficiency is further improved and the durability of the device is further improved due to lowering of the drive voltage, which tends to make it easier to obtain characteristics of higher efficiency, lower drive voltage, and longer lifetime.

Consequently, the invention can provide an electron-blocking material comprising a compound represented by the general formula (1) for use in combination with a compound represented by the general formula (2-1) or (2-2); a laminate of a layer containing a compound represented by the general formula (2-1) or (2-2) and a layer containing a compound represented by the general formula (1) (preferably a laminate for light emission); an organic EL device containing a compound represented by the general formula (2-1) or (2-2) and a compound represented by the general formula (1); an organic EL device having a layer containing a compound represented by the general formula (1) and a layer containing a compound represented by the general formula (2-1) or (2-2) (preferably, these two layers are adjacent to each other); and an organic EL device having an electron-blocking layer containing a compound represented by the general formula (1) and a light-emitting layer containing a compound represented by the general formula (2-1) or (2-2) (preferably, these two layers are adjacent to each other).

In the organic EL device of the invention, the compound represented by the general formula (1) can be used in any freely selected combination with the compound represented by the general formula (2-1) or (2-2). Examples of the combination include Pairs 1 (101) to 1 (154), which are combinations of Compound Group 1 and Compound Groups 101 to 154 in that order. Compound Group 2 and Compound Groups 101 to 154 are combined in sequence as Pair 2 (101) to 2 (154), and Compound Group 3 and Compound Groups 101 to 154 are combined in sequence as Pair 3 (101) to 3 (154). The same procedure can be used to identify those in which each of Compound Groups 3-42 is combined with Compound Groups 101-154 in sequence. One of the Pairs 1(101) to 42(154) specified in that manner can be selected and employed in the organic EL device of the invention.

In addition to the compounds represented by the general formula (2-1) or (2-2), known light-emitting materials and host materials can be used in the light-emitting layer of the organic EL device of the invention. The light-emitting material can be any of a fluorescent emitting material, phosphorescent emitting material, or delayed fluorescent material.

Examples of fluorescent material usable herein include metal complexes of quinolinol derivatives such as tris(8-quinolinolato)aluminum (Alq₃), and in addition thereto, various metal complexes, anthracene derivatives, bis-styrylbenzene derivatives, pyrene derivatives, oxazole derivatives, and poly(para-phenylenevinylene) derivatives, and further include quinacridone, coumarin, rubrene, perylene and derivatives thereof, as well as benzopyran derivatives, indenophenanthrene derivatives, rhodamine derivatives, and aminostyryl derivatives.

Metal complexes with iridium or platinum as the central metal can be used as phosphorescent materials. For example, green phosphorescent materials such as Ir(ppy)₃, blue phosphorescent materials such as FIrpic and FIr6, and red phosphorescent materials such as Btp₂Ir(acac) can be used. The amount of the phosphorescent emitting material doped into the host material is preferably in a range of 1 to 30% by weight of the total light-emitting layer to avoid concentration quenching, and the doping is preferably attained by co-evaporation.

Examples of usable delayed fluorescent materials include carbazolyl dicyanobenzene (CDCB) derivatives such as PIC-TRZ, CC2TA, PXZ-TRZ, and 4CzIPN. For specific examples of these and other delayed fluorescent materials, reference can be made to Appl. Phys. Lett., 98, 083302 (2011).

Anthracene derivatives, heterocyclic compounds with an indole ring as a partial structure of the fused ring therein, heterocyclic compounds with a carbazole ring as a partial structure of the fused ring therein, carbazole derivatives, thiazole derivatives, benzimidazole derivatives, and polydialkylfluorene derivatives are also used as the host material in the light-emitting layer. Examples of a hole injection and transport host material include carbazole derivatives such as 4,4'-di(N-carbazolyl)biphenyl (CBP), TCTA, and mCP, and examples of an electron transport host material include p-bis(triphenylsilyl)benzene (UGH2) and 2,2',2"-(1,3,5-phenylene)-tris(1-phenyl-1H-benzimidazole) (TPBI).

### [Hole-Blocking Layer]

The hole-blocking layer is placed, for example, between the light-emitting layer and the electron transport layer and is a layer having the function of inhibiting the diffusion of holes existing in the light-emitting layer to the outside of the light-emitting layer (on electron transport layer side), thereby improving the recombination probability of electrons and holes in the light-emitting layer. The hole-blocking layer usually also has the function of transporting electrons. The hole-blocking layer can also serve as an exciton blocking layer that suppresses the diffusion of excitons from the light-emitting layer.

As materials for the hole-blocking layer in the organic EL device of the invention, compounds with hole-blocking effects, including phenanthroline derivatives such as bathocuproine (BCP), metal complexes of quinolinol derivatives such as bis(2-methyl-8-quinolinate)-4-(phenylphenolato)aluminum (BAlq), various rare earth complexes, triazole derivatives, triazine derivatives, and oxadiazole derivatives, can be used. These materials can also serve as materials for the electron transport layer.

### [Electron Transport Layer, Electron Injection Layer]

The electron injection layer is provided between the cathode and the light-emitting layer or between the cathode and the electron transport layer to lower the injection barrier of electrons supplied from the cathode, thereby lowering the drive voltage and improving the luminance.

The electron transport layer is a layer that functions to transport electrons. The electron transport layer can be an electron injection transport layer that also functions as an electron injection layer.

As materials for the electron transport layer of the organic EL device of the invention, metal complexes of quinolinol derivatives such as Alq₃ and BAlq, various metal complexes, triazole derivatives, triazine derivatives, oxadiazole derivatives, pyridine derivatives, pyrimidine derivatives, benzimidazole derivatives, thiadiazole derivatives, anthracene derivatives, carbodiimide derivatives, quinoxaline derivatives, pyridoindole derivatives, phenanthroline derivatives and silole derivatives, can be used.

As materials for the electron injection layer of the organic EL device of the invention, alkali metal salts such as lithium fluoride and cesium fluoride, alkaline earth metal salts such as magnesium fluoride, metal complexes of quinolinol derivatives such as lithium quinolinol, metal oxides such as aluminum oxide, or metals such as ytterbium (Yb), samarium (Sm), calcium (Ca), strontium (Sr), and cesium (Cs), can be used. The electron injection layer can be omitted by constructing the electron transport layer and the cathode with preferred materials.

Furthermore, for the electron injection layer and the electron transport layer, a metal such as cesium (N-type dopant) can be added to the electron injection material and the electron transport material.

### [Cathode]

For the cathode of the organic EL device of the invention, employable are metals with a low work function, such as aluminum, as well as alloys with a lower work function, such as magnesium silver alloys, magnesium indium alloys, and aluminum magnesium alloys.

### <Electronic Device>

The electronic device of the invention has a pair of electrodes, and at least one organic layer sandwiched between the pair of electrodes, wherein at least one organic layer contains an arylamine compound represented by the general formula (1), and additionally at least one organic layer contains an organoboron compound represented by the general formula (2-1) or (2-2).

Examples of the electronic device include display devices and light-emitting devices equipped with an organic EL device, and additionally electrophotographic photoreceptors, image sensors, photoelectric conversion devices, and solar cells. Examples of the display devices include display components such as organic EL panel modules, and also TVs, cell phones, tablets and personal computers. Examples of the light-emitting devices include lighting devices and vehicle lights.

### Examples

Hereinunder embodiments of the invention are described more specifically by examples. The materials, processes and procedures shown below can be appropriately modified unless they deviate from the gist of the invention. Therefore, the scope of the invention is not limited to the following examples. The reagents described in the synthesis examples were manufactured by Tokyo Chemical Industry Co., Ltd., Sigma-Aldrich, Alfa Aesar, etc. All reactions in the synthesis examples were performed using a reaction vessel equipped with a cooling tube, a stirrer, and a thermometer. Identification of the compounds in the synthesis examples was performed by ¹H-NMR analysis (Bruker Nuclear Magnetic Resonance System, Model: Ascend^{™}, 400 MHz) or MS (AB SCIEX Korea Mass Spectrometer, Model: API 3200).

### <Synthesis Example 1: Synthesis of compound (1-89)>

In a nitrogen-purged reaction vessel, N-phenyl-4-(phenylnaphthalen-3-yl)-aniline: 10.0 g, 3-(4-chlorophenyl)-1-phenylnaphthalene: 9.3 g, sodium tert-butoxide: 5.2 g, bis[tri(tert-butylphosphine)]palladium(0): 0.3 g, and toluene: 100 mL were put, and the mixture was stirred overnight under heat reflux. After confirming the completion of the reaction, the filtrate resulting from filtration was concentrated to give a crude product. The resultant crude product was purified by crystallization using a dichloromethane/acetone mixed solvent to give a compound (1-89): 14.4 g (yield: 82.3%).

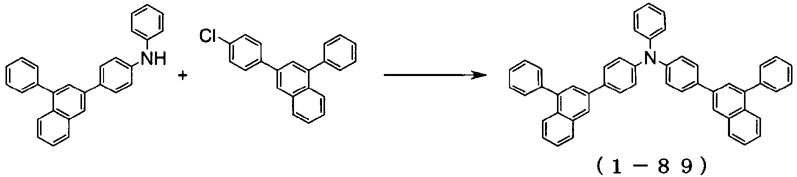

The resultant white powder was subjected to NMR measurement and the following 35 hydrogen signals were detected to identify the structure of the compound (1-89).
¹H-NMR(CDCl₃): δ(ppm) = 8.05(2H), 7.95(2H), 7.90(2H), 7.71(2H), 7.67(4H), 7.65-7.49(10H), 7.47-7.40(4H), 7.31(2H), 7.26-7.21(6H), 7.08(1H).

### Melting Point: 216°C

### <Synthesis Example 2: Synthesis of compound (1-181)>

In a nitrogen-purged reaction vessel, N-phenyl-4-([1,1'-binaphthalen]-3-yl)aniline: 10.0 g, 3-(4-chlorophenyl)-1-phenylnaphthalene: 7.8 g, sodium tert-butoxide: 3.4 g, tri-tert-butylphosphine: 0.2 g, tris(dibenzylideneacetone)dipalladium(0): 0.4 g, and xylene: 100 mL were put, and the mixture was stirred overnight under heat reflux. After confirming the completion of the reaction, the filtrate resulting from filtration was concentrated to give a crude product. The resultant crude product was purified by column chromatography (carrier: silica gel, eluent: dichloromethane/n-heptane) to give a compound (1-181): 12.6 g (yield: 75.9%).

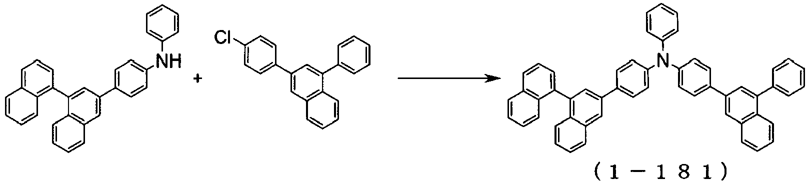

The resultant white powder was subjected to NMR measurement and the following 37 hydrogen signals were detected to identify the structure of the compound (1-181).
¹H-NMR(CDCl₃): δ(ppm) = 8.18(1H), 8.07(1H), 8.00(4H), 7.93(1H), 7.83(1H), 7.72(4H), 7.68(1H), 7.64(1H), 7.61-7.41(12H), 7.33(4H)7.28-7.22(6H), 7.10(1H).

### <Synthesis Example 3: Synthesis of compound (1-182)>

In a nitrogen-purged reaction vessel, N-phenyl-4-([1,2'-binaphthalen]-3-yl)aniline: 15.6 g, 3-(4-chlorophenyl)-1-phenylnaphthalene: 11.7 g, sodium tert-butoxide: 7.1 g, tri-tert-butylphosphine: 0.3 g, tris(dibenzylideneacetone)dipalladium(0): 0.7 g, and xylene: 160 mL were put, and the mixture was stirred overnight under heat reflux. After confirming the completion of the reaction, the filtrate resulting from filtration was concentrated to give a crude product. The resultant crude product was purified by crystallization using an ethyl acetate/toluene mixed solvent to give a compound (1-182): 20.0 g (yield: 74.1%).

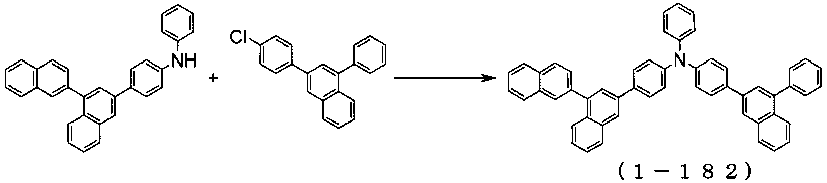

The resultant white powder was subjected to NMR measurement and the following 37 hydrogen signals were detected to identify the structure of the compound (1-182).
¹H-NMR(CDCl₃): δ(ppm) = 8.12(1H), 8.07(2H), 8.01(2H), 7.99-7.91(5H), 7.84(1H), 7.76-7.67(6H), 7.62-7.51(8H), 7.49(1H), 7.45(2H), 7.34(2H), 7.31-6.91(6H), 7.11(1H).

### <Synthesis Example 4: Synthesis of compound (1-23)>

In a nitrogen-purged reaction vessel, aniline: 1.8 g, 7-(4-chlorophenyl)-1-phenylnaphthalene: 12.2 g, tris(dibenzylideneacetone)palladium(0): 0.7 g, tri-tert-butylphosphine: 0.3 g, sodium tert-butoxide: 7.4 g, and xylene: 180 mL were put, and the mixture was stirred overnight under heat reflux.

After confirming the completion of the reaction, the filtrate resulting from filtration was concentrated to give a crude product. The resultant crude product was isolated by column chromatography (carrier: silica gel, eluent: dichloromethane/n-heptane) and purified by recrystallization in an ethanol solvent to give a compound (1-23): 4.0 g (yield: 31.8%).

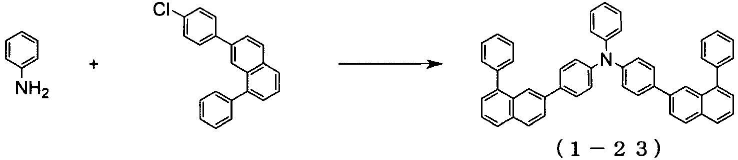

The resultant pale yellow powder was subjected to NMR measurement and the following 35 hydrogen signals were detected to identify the structure of the compound (1-23).
¹H-NMR(CDCl₃): δ(ppm) = 8.12(2H), 7.99(2H), 7.90(2H), 7.78(2H), 7.59-7.51(14H), 7.48-7.44(4H), 7.30(2H), 7.20-7.16(6H), 7.08(1H).

### <Synthesis Example 5: Synthesis of compound (1-190)>

In a nitrogen-purged reaction vessel, 7-(4-chlorophenyl)-1-phenylnaphthalene: 8.0 g, N-(phenyl)-4-(phenylnaphthalen-3-yl)-aniline: 7.5 g, sodium tert-butoxide: 3.1 g, bis[tri(tert-butylphosphine)]palladium(0): 0.2 g, g and toluene: 96 mL were put, and the mixture was stirred for 3 hours under heat reflux. After confirming the completion of the reaction, the filtrate resulting from filtration was concentrated to give a crude product. The resultant crude product was purified by crystallization using a dichloromethane/acetone mixed solvent to give a compound (1-190): 10.3 g (yield: 73.6%).

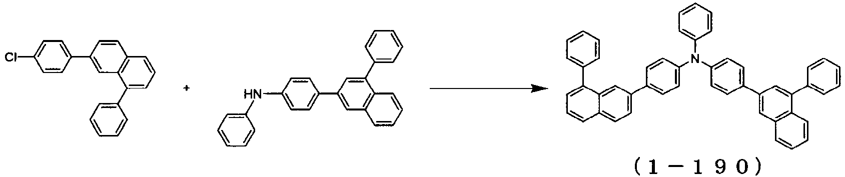

The resultant white powder was subjected to NMR measurement and the following 35 hydrogen signals were detected to identify the structure of the compound (1-190).
¹H-NMR(CDCl₃): δ(ppm) = 8.13(1H), 8.07(1H), 7.99(2H), 7.91(2H), 7.79(1H), 7.73(1H), 7.68(2H), 7.59-7.42(16H), 7.33(2H), 7.26-7.20(6H), 7.10(1H).

### <Synthesis Example 6: Synthesis of compound (1-214)>

In a nitrogen-purged reaction vessel, 7-(4-bromophenyl-d₄)-1-phenylnaphthalene: 8.2 g, N-(phenyl-d₄)-4-(phenylnaphthalen-3-yl)aniline-d₅: 9.0 g, sodium tert-butoxide: 4.3 g, bis[tri(tert-butylphosphine)]palladium(0): 0.2 g and toluene: 90 mL were put, and the mixture was stirred for 2 hours under heat reflux. After confirming the completion of the reaction, the filtrate resulting from filtration was concentrated to give a crude product. The resultant crude product was purified by crystallization using a dichloromethane/acetone mixed solvent to give a compound (1-214): 13.5 g (yield: 90.2 %).

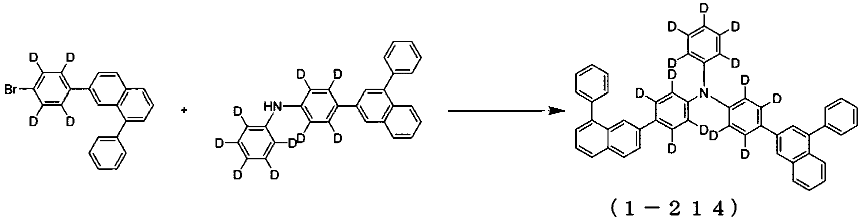

The resultant white powder was subjected to NMR measurement and the following 22 hydrogen signals were detected to identify the structure of the compound (1-214).
¹H-NMR(CDCl₃): δ(ppm) = 8.13(1H), 8.06(1H), 7.99(2H), 7.91(2H), 7.79(1H), 7.73(1H), 7.59-7.52(10H), 7.50-7.42(4H).

### <Synthesis Example 7: Synthesis of compound (1-215)>

In a nitrogen-purged reaction vessel, 3-(4-bromophenyl-d₄)-1-phenylnaphthalene: 14.0 g, N-(phenyl-d₄)-4-(phenylnaphthalen-3-yl)aniline-d₅: 15.4 g, sodium tert-butoxide: 7.4 g, bis[tri(tert-butylphosphine)]palladium(0): 0.4 g and toluene: 140 mL were put, and the mixture was stirred for 1 hour under heat reflux. After confirming the completion of the reaction, the filtrate resulting from filtration was concentrated to give a crude product. The resultant crude product was purified by crystallization using a dichloromethane/acetone mixed solvent to give a compound (1-215): 24.0 g (yield: 94.1 %).

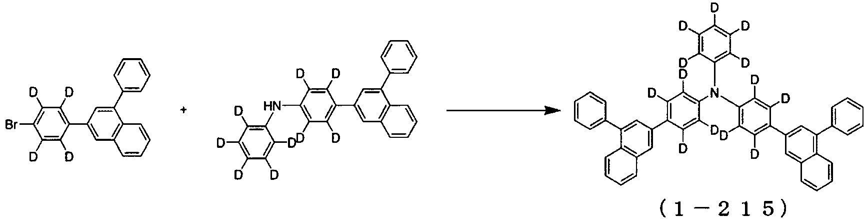

The resultant white powder was subjected to NMR measurement and the following 22 hydrogen signals were detected to identify the structure of the compound (1-215).
¹H-NMR(CDCl₃): δ(ppm) = 8.08(2H), 7.98(2H), 7.92(2H), 7.74(2H), 7.59-7.52(10H), 7.49-7.43(4H).

Compounds represented by general formula (1) other than those synthesized in Synthesis Examples 1 to 7 can also be synthesized in the same manner as in Synthesis Examples 1 to 7.

### <Measurement 1: Measurement of Glass Transition Point>

The glass transition point of the arylamine compounds represented by the general formula (1) and synthesized in Synthesis Examples 1 to 7 was measured with a high-sensitivity differential scanning calorimeter (Model: DSC 3100SA, manufactured by Bruker AXS). The results are shown in Table 1.

The arylamine compound represented by the general formula (1) has a glass transition point of 100°C or higher, confirming that the thin film state thereof is stable.

### <Measurement 2: Measurement of HOMO Level>

The arylamine compound represented by the general formula (1) was used to prepare a 100-nm-thick evaporated film on an ITO substrate, and the HOMO energy level (HOMO level, ionization potential) thereof was measured using an ionization potential measurement system (Model: PYS-202, manufactured by Sumitomo Heavy Industries). The results are shown in Table 1.

**[Table 1]**

| | Glass Transition Point | HOMO Level |
|---|---|---|
| Compound (1-87) | 110°C | 5.63 eV |
| Compound (1-181) | 129°C | 5.70 eV |
| Compound (1-182) | 121°C | 5.64 eV |
| Compound (1-23) | 110°C | 5.63 eV |
| Compound (1-190) | 110°C | 5.64 eV |
| Compound (1-214) | 110°C | 5.62 eV |
| Compound (1-215) | 110°C | 5.73 eV |

The arylamine compounds represented by the general formula (1) synthesized in Synthesis Examples 1 to 7 show a suitable energy level compared to the HOMO level (5.4 eV) of common hole transport materials such as NPD and TPD, indicating that the compounds have good hole transport ability.

Therefore, the arylamine compound represented by the general formula (1) is useful as a material for the hole injection layer, the hole transport layer, the electron-blocking layer, or the light-emitting layer of organic EL devices, and can improve the light emission efficiency, drive voltage, and durability of hitherto-known organic EL devices.

### [Example 1]

In Example 1, as shown in Fig. 1, an organic EL device was fabricated by depositing a hole injection layer 3, a hole transport layer 4, an electron-blocking layer 5, a light-emitting layer 6, an electron transport layer 7, an electron injection layer 8, a cathode 9, and a capping layer 10 in this order on a glass substrate 1 with a reflective ITO electrode pre-formed as a transparent anode 2.

Specifically, a glass substrate 1 having ITO with a thickness of 50 nm, a silver alloy reflective film with a thickness of 100 nm, and ITO with a thickness of 5 nm in this order was ultrasonically cleaned in isopropyl alcohol for 20 minutes and then dried on a hot plate heated at 250°C for 10 minutes. Then, after UV ozone treatment for 2 minutes, this glass substrate with ITO was mounted in a vacuum evaporator and the pressure was reduced to 0.001 Pa or less. Next, the following compound (Acceptor-1) as an electron acceptor and the following compound (HTM-1) were deposited to form a hole injection layer 3 having a thickness of 10 nm and covering the transparent anode 2, by binary deposition at a deposition rate of Acceptor-1:compound (HTM-1) = 3:97. The following compound (HTM-1) was formed as the hole transport layer 4 on top of the hole injection layer 3 to achieve a thickness of 140 nm. On the hole transport layer 4, the compound (1-89) synthesized in Synthesis Example 1 was deposited to form an electron-blocking layer 5 with a thickness of 5 nm. On top of the electron-blocking layer 5, the compound (2-1) and the following compound (EMH-1) were deposited to form a light-emitting layer 6 with a thickness of 20 nm, by binary deposition at a deposition rate ratio of (2-1): (EMH-1) = 5:95. On top of the light-emitting layer 6, the following compound (ETM-1) and the following compound (ETM-2) were deposited to form an electron transport layer 7 with a thickness of 30 nm, by binary deposition at a deposition rate ratio of (ETM-1): (ETM-2) = 50:50. On top of the electron transport layer 7, lithium fluoride was formed as an electron injection layer 8 with a thickness of 1 nm. On the electron injection layer 8, a magnesium silver alloy was formed as a cathode 9 with a thickness of 12 nm. Finally, the following compound (CPL-1) was formed to form a capping layer 10 with a thickness of 60 nm. Characteristics of the fabricated organic EL devices were measured (ENC TECHNOLOGY, Model: IVL-12M) in air at room temperature. The measurement results of the light emission characteristics of the fabricated organic EL devices with a DC voltage applied are summarized in Table 2.

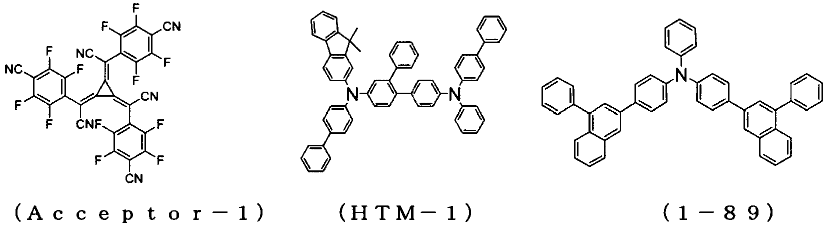

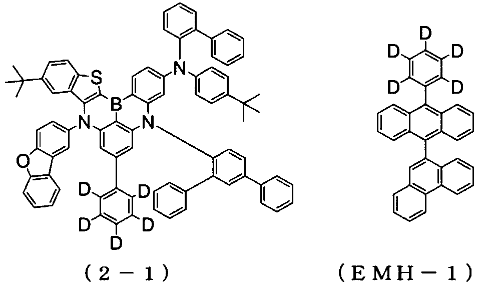

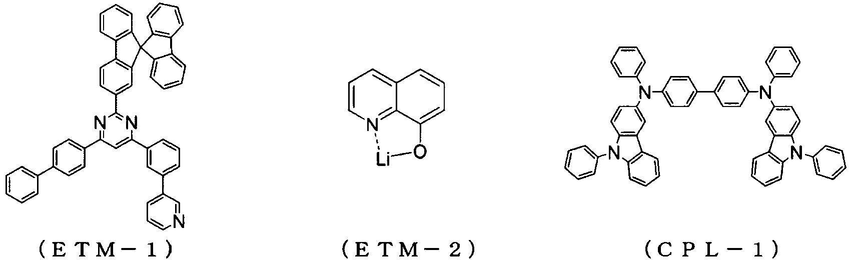

### [Examples 2 to 189]

Organic EL devices were fabricated in the same way as in Example 1, in which, however, instead of the compound (1-89) used as the material for the electron-blocking layer 5 and the compound (2-1) used as the material for the light-emitting layer 6, the compounds shown in Table 2 were used. The light emission characteristics of the fabricated organic EL devices were measured by applying a DC voltage to the devices in air at room temperature. The results are summarized in Table 2.

### [Comparative Example 1]

For comparison, an organic EL device was fabricated under the same conditions as in Example 1, except that the following compound (HTM-2) was used instead of the compound (1-89) as the material for the electron-blocking layer 5 (see PTL 8). The characteristics of the fabricated organic EL device were measured in air at room temperature. The measurement results of the light emission characteristics of the fabricated organic EL device with a DC voltage applied are summarized in Table 2.

### [Comparative Example 2]

For comparison, an organic EL device was fabricated under the same conditions as in Example 1, except that the following compound (HTM-3) was used instead of the compound (1-89) as the material for the electron-blocking layer 5 (see PTL 7). The characteristics of the fabricated organic EL device were measured in air at room temperature. The measurement results of the light emission characteristics of the fabricated organic EL device with a DC voltage applied are summarized in Table 2.

### [Comparative Example 3]

For comparison, an organic EL device was fabricated under the same conditions as in Example 1, except that the following compound (EMD-1) was used instead of the compound (2-1) as the material for the light-emitting layer 6. The characteristics of the fabricated organic EL device were measured in air at room temperature. The measurement results of the light emission characteristics of the fabricated organic EL device with a DC voltage applied are summarized in Table 2.

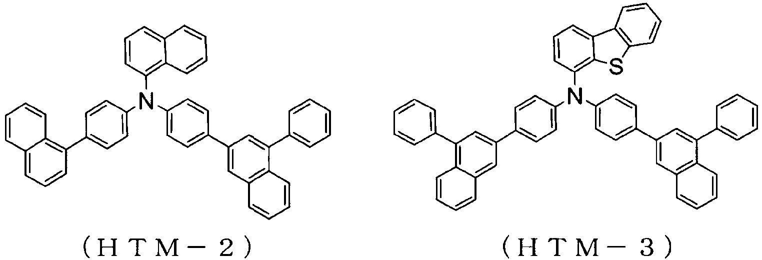

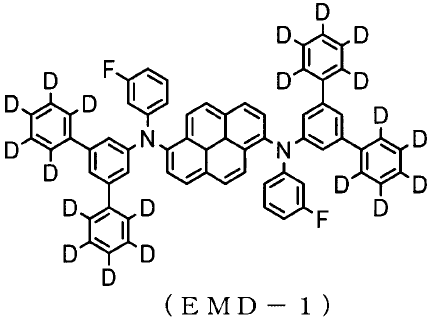

The results of the device lifetime measured with the organic EL devices fabricated in Examples 1 to 189 and Comparative Examples 1 to 3 were summarized in Table 2. The device lifetime was measured as the time required for the luminance to decay to 1900 cd/m² (equivalent to 95% when the initial luminance is set to 100%: 95% decay) when constant-current drive was performed with the luminance at the start of emission (initial luminance) set at 2000 cd/m².

**[Table 2]**

| | Electron Blocking Layer | Light-Emitting Layer | Voltage [V] (@10mA/cm²) | Luminance [cd/m²] (@10mA/cm²) | Light Emission Efficiency [cd/A] (@10mA/cm²) | Power Efficiency [lm/W] ((@10mA/cm²) | Device Lifetime 95% Decay |
|---|---|---|---|---|---|---|---|
| Ex. 1 | Cmpd (1-89) | Cmpd (2-1) | 3.35 | 969 | 9.69 | 9.10 | 201 hrs. |
| Ex. 2 | Cmpd (1-181) | Cmpd (2-1) | 3.34 | 967 | 9.67 | 9.11 | 200 hrs. |
| Ex. 3 | Cmpd (1-182) | Cmpd (2-1) | 3.35 | 974 | 9.74 | 9.14 | 210 hrs. |
| Ex. 4 | Cmpd (1-23) | Cmpd (2-1) | 3.34 | 945 | 9.45 | 8.89 | 198 hrs. |
| Ex. 5 | Cmpd (1-190) | Cmpd (2-1) | 3.38 | 957 | 9.57 | 8.89 | 209 hrs. |
| Ex. 6 | Cmpd (1-214) | Cmpd (2-1) | 3.38 | 954 | 9.54 | 8.86 | 241 hrs. |
| Ex. 7 | Cmpd (1-215) | Cmpd (2-1) | 3.37 | 966 | 9.66 | 9.01 | 238 hrs. |
| Ex. 8 | Cmpd (1-89) | Cmpd (2-2) | 3.34 | 972 | 9.72 | 9.14 | 202 hrs. |
| Ex. 9 | Cmpd (1-181) | Cmpd (2-2) | 3.35 | 952 | 9.52 | 8.95 | 231 hrs. |
| Ex. 10 | Cmpd (1-182) | Cmpd (2-2) | 3.35 | 954 | 9.54 | 8.95 | 223 hrs. |
| Ex. 11 | Cmpd (1-23) | Cmpd (2-2) | 3.34 | 948 | 9.48 | 8.92 | 205 hrs. |
| Ex. 12 | Cmpd (1-190) | Cmpd (2-2) | 3.36 | 975 | 9.75 | 9.13 | 218 hrs. |
| Ex. 13 | Cmpd (1-214) | Cmpd (2-2) | 3.36 | 976 | 9.76 | 9.13 | 248 hrs. |
| Ex. 14 | Cmpd (1-215) | Cmpd (2-2) | 3.33 | 978 | 9.78 | 9.24 | 242 hrs. |
| Ex. 15 | Cmpd (1-89) | Cmpd (2-3) | 3.34 | 996 | 9.96 | 9.38 | 211 hrs. |
| Ex. 16 | Cmpd (1-181) | Cmpd (2-3) | 3.34 | 973 | 9.73 | 9.15 | 232 hrs. |
| Ex. 17 | Cmpd (1-182) | Cmpd (2-3) | 3.35 | 974 | 9.74 | 9.15 | 212 hrs. |
| Ex. 18 | Cmpd (1-23) | Cmpd (2-3) | 3.36 | 958 | 9.58 | 8.97 | 220 hrs. |
| Ex. 19 | Cmpd (1-190) | Cmpd (2-3) | 3.36 | 944 | 9.44 | 8.84 | 216 hrs. |
| Ex. 20 | Cmpd (1-214) | Cmpd (2-3) | 3.35 | 943 | 9.43 | 8.86 | 248 hrs. |
| Ex. 21 | Cmpd (1-215) | Cmpd (2-3) | 3.34 | 992 | 9.92 | 9.33 | 245 hrs. |
| Ex. 22 | Cmpd (1-89) | Cmpd (2-4) | 3.35 | 998 | 9.98 | 9.38 | 243 hrs. |
| Ex. 23 | Cmpd (1-181) | Cmpd (2-4) | 3.35 | 958 | 9.58 | 8.99 | 238 hrs. |
| Ex. 24 | Cmpd (1-182) | Cmpd (2-4) | 3.35 | 963 | 9.63 | 9.04 | 231 hrs. |
| Ex. 25 | Cmpd (1-23) | Cmpd (2-4) | 3.34 | 967 | 9.67 | 9.12 | 251 hrs. |
| Ex. 26 | Cmpd (1-190) | Cmpd (2-4) | 3.36 | 988 | 9.88 | 9.25 | 238 hrs. |
| Ex. 27 | Cmpd (1-214) | Cmpd (2-4) | 3.35 | 985 | 9.85 | 9.24 | 280 hrs. |
| Ex. 28 | Cmpd (1-215) | Cmpd (2-4) | 3.37 | 995 | 9.95 | 9.30 | 287 hrs. |
| Ex. 29 | Cmpd (1-89) | Cmpd (2-5) | 3.32 | 1008 | 10.08 | 9.55 | 223 hrs. |
| Ex. 30 | Cmpd (1-181) | Cmpd (2-5) | 3.33 | 989 | 9.89 | 9.35 | 234 hrs. |
| Ex. 31 | Cmpd (1-182) | Cmpd (2-5) | 3.32 | 999 | 9.99 | 9.46 | 211 hrs. |
| Ex. 32 | Cmpd (1-23) | Cmpd (2-5) | 3.34 | 1002 | 10.02 | 9.43 | 215 hrs. |
| Ex. 33 | Cmpd (1-190) | Cmpd (2-5) | 3.33 | 1023 | 10.23 | 9.68 | 218 hrs. |
| Ex. 34 | Cmpd (1-214) | Cmpd (2-5) | 3.33 | 1026 | 10.26 | 9.69 | 254 hrs. |
| Ex. 35 | Cmpd (1-215) | Cmpd (2-5) | 3.32 | 1001 | 10.01 | 9.50 | 266 hrs. |
| Ex. 36 | Cmpd (1-89) | Cmpd (2-6) | 3.33 | 1022 | 10.22 | 9.65 | 222 hrs. |
| Ex. 37 | Cmpd (1-181) | Cmpd (2-6) | 3.33 | 990 | 9.90 | 9.35 | 211 hrs. |
| Ex. 38 | Cmpd (1-182) | Cmpd (2-6) | 3.32 | 995 | 9.95 | 9.44 | 217 hrs. |
| Ex. 39 | Cmpd (1-23) | Cmpd (2-6) | 3.36 | 1018 | 10.18 | 9.53 | 218 hrs. |
| Ex. 40 | Cmpd (1-190) | Cmpd (2-6) | 3.35 | 1020 | 10.20 | 9.56 | 220 hrs. |
| *Ex.: Example, Comp Ex.: Comparative Example, Cmpd: Compound, hrs.: hours | | | | | | | |

| | Electron Blocking Layer | Light-Emitting Layer | Voltage [V] (@10mA/cm²) | Luminance [cd/m²] (@10mA/cm²) | Light Emission Efficiency [cd/A] (@10mA/cm²) | Power Efficiency [1m/W] (@10mA/cm²) | Device Lifetime 95% Decay |
|---|---|---|---|---|---|---|---|
| Ex. 41 | Cmpd (1-214) | Comp (2-6) | 3.36 | 1019 | 10.19 | 9.52 | 271 hrs. |
| Ex. 42 | Cmpd (1-215) | Cmpd (2-6) | 3.35 | 1023 | 10.23 | 9.60 | 269 hrs. |
| Ex. 43 | Cmpd (1-89) | Cmpd (2-7) | 3.34 | 995 | 9.95 | 9.37 | 208 hrs. |
| Ex. 44 | Cmpd (1-181) | Cmpd (2-7) | 3.33 | 994 | 9.94 | 9.38 | 225 hrs. |
| Ex. 45 | Cmpd (1-182) | Cmpd (2-7) | 3.34 | 977 | 9.77 | 9.20 | 221 hrs. |
| Ex. 46 | Cmpd (1-23) | Cmpd (2-7) | 3.35 | 973 | 9.73 | 9.12 | 221 hrs. |
| Ex. 47 | Cmpd (1-190) | Cmpd (2-7) | 3.35 | 1016 | 10.16 | 9.53 | 213 hrs. |
| Ex. 48 | Cmpd (1-214) | Cmpd (2-7) | 3.34 | 1017 | 10.17 | 9.57 | 248 hrs. |
| Ex. 49 | Cmpd (1-215) | Cmpd (2-7) | 3.35 | 999 | 9.99 | 9.38 | 238 hrs. |
| Ex. 50 | Cmpd (1-89) | Cmpd (2-8) | 3.34 | 979 | 9.79 | 9.22 | 214 hrs. |
| Ex. 51 | Cmpd (1-181) | Cmpd (2-8) | 3.34 | 1000 | 10.00 | 9.40 | 217 hrs. |
| Ex. 52 | Cmpd (1-182) | Cmpd (2-8) | 3.34 | 996 | 9.96 | 9.39 | 201 hrs. |
| Ex. 53 | Cmpd (1-23) | Cmpd (2-8) | 3.36 | 962 | 9.62 | 9.01 | 208 hrs. |
| Ex. 54 | Cmpd (1-190) | Cmpd (2-8) | 3.37 | 994 | 9.94 | 9.28 | 209 hrs. |
| Ex. 55 | Cmpd (1-214) | Cmpd (2-8) | 3.36 | 993 | 9.93 | 9.28 | 244 hrs. |
| Ex. 56 | Cmpd (1-215) | Cmpd (2-8) | 3.35 | 983 | 9.83 | 9.23 | 249 hrs. |
| Ex. 57 | Cmpd (1-89) | Cmpd (2-9) | 3.34 | 980 | 9.80 | 9.23 | 211 hrs. |
| Ex. 58 | Cmpd (1-181) | Cmpd (2-9) | 3.34 | 977 | 9.77 | 9.19 | 204 hrs. |
| Ex. 59 | Cmpd (1-182) | Cmpd (2-9) | 3.35 | 1016 | 10.16 | 9.53 | 232 hrs. |
| Ex. 60 | Cmpd (1-23) | Cmpd (2-9) | 3.33 | 992 | 9.92 | 9.38 | 220 hrs. |
| Ex. 61 | Cmpd (1-190) | Cmpd (2-9) | 3.35 | 971 | 9.71 | 9.11 | 220 hrs. |
| Ex. 62 | Cmpd (1-214) | Cmpd (2-9) | 3.35 | 970 | 9.70 | 9.10 | 259 hrs. |
| Ex. 63 | Cmpd (1-215) | Cmpd (2-9) | 3.35 | 980 | 9.80 | 9.20 | 250 hrs. |
| Ex. 64 | Cmpd (1-89) | Cmpd (2-10) | 3.35 | 999 | 9.99 | 9.37 | 207 hrs. |
| Ex. 65 | Cmpd (1-181) | Cmpd (2-10) | 3.35 | 952 | 9.52 | 8.94 | 208 hrs. |
| Ex. 66 | Cmpd (1-182) | Cmpd (2-10) | 3.33 | 955 | 9.55 | 9.03 | 200 hrs. |
| Ex. 67 | Cmpd (1-23) | Cmpd (2-10) | 3.34 | 980 | 9.80 | 9.23 | 196 hrs. |
| Ex. 68 | Cmpd (1-190) | Cmpd (2-10) | 3.34 | 999 | 9.99 | 9.42 | 215 hrs. |
| Ex. 69 | Cmpd (1-214) | Cmpd (2-10) | 3.33 | 999 | 9.99 | 9.43 | 243 hrs. |
| Ex. 70 | Cmpd (1-215) | Cmpd (2-10) | 3.34 | 1002 | 10.02 | 9.43 | 246 hrs. |
| Ex. 71 | Cmpd (1-89) | Cmpd (2-11) | 3.33 | 956 | 9.56 | 9.04 | 240 hrs. |
| Ex. 72 | Cmpd (1-181) | Cmpd (2-11) | 3.32 | 1019 | 10.19 | 9.67 | 223 hrs. |
| Ex. 73 | Cmpd (1-182) | Cmpd (2-11) | 3.34 | 1001 | 10.01 | 9.43 | 218 hrs. |
| Ex. 74 | Cmpd (1-23) | Cmpd (2-11) | 3.35 | 980 | 9.80 | 9.19 | 229 hrs. |
| Ex. 75 | Cmpd (1-190) | Cmpd (2-11) | 3.36 | 959 | 9.59 | 8.96 | 255 hrs. |
| Ex. 76 | Cmpd (1-214) | Cmpd (2-11) | 3.36 | 961 | 9.61 | 9.00 | 289 hrs. |
| Ex. 77 | Cmpd (1-215) | Cmpd (2-11) | 3.33 | 956 | 9.56 | 9.02 | 277 hrs. |
| Ex. 78 | Cmpd (1-89) | Cmpd (2-12) | 3.34 | 946 | 9.46 | 8.91 | 238 hrs. |
| Ex. 79 | Cmpd (1-181) | Cmpd (2-12) | 3.35 | 956 | 9.56 | 8.97 | 227 hrs. |
| Ex. 80 | Cmpd (1-182) | Cmpd (2-12) | 3.35 | 954 | 9.54 | 8.96 | 214 hrs. |

| | Electron Blocking Layer | Light-Emitting Layer | Voltage [V] (@10mA/cm²) | Luminance [cd/m²] (@10mA/cm²) | Light Emission Efficiency [cd/A] (@10mA/cm²) | Power Efficiency [lm/W] (@10mA/cm²) | Device Lifetime 95% Decay |
|---|---|---|---|---|---|---|---|
| Ex. 81 | Cmpd. (1-23) | Cmpd. (2-12) | 3.37 | 971 | 9.71 | 9.06 | 231 hrs. |
| Ex. 82 | Cmpd (1-190) | Cmpd (2-12) | 3.36 | 987 | 9.87 | 9.24 | 251 hrs. |
| Ex. 83 | Cmpd (1-214) | Cmpd (2-12) | 3.35 | 985 | 9.85 | 9.24 | 279 hrs. |
| Ex. 84 | Cmpd (1-215) | Cmpd (2-12) | 3.33 | 943 | 9.43 | 8.90 | 268 hrs. |
| Ex. 85 | Cmpd (1-89) | Cmpd (2-13) | 3.32 | 940 | 9.40 | 8.91 | 203 hrs. |
| Ex. 86 | Cmpd (1-181) | Cmpd (2-13) | 3.34 | 996 | 9.96 | 9.39 | 208 hrs. |
| Ex. 87 | Cmpd (1-182) | Cmpd (2-13) | 3.35 | 989 | 9.89 | 9.27 | 208 hrs. |
| Ex. 88 | Cmpd (1-23) | Cmpd (2-13) | 3.36 | 987 | 9.87 | 9.23 | 201 hrs. |
| Ex. 89 | Cmpd (1-190) | Cmpd (2-13) | 3.33 | 971 | 9.71 | 9.19 | 221 hrs. |
| Ex. 90 | Cmpd (1-214) | Cmpd (2-13) | 3.32 | 970 | 9.70 | 9.18 | 239 hrs. |
| Ex. 91 | Cmpd (1-215) | Cmpd (2-13) | 3.32 | 941 | 9.41 | 8.91 | 246 hrs. |
| Ex. 92 | Cmpd (1-89) | Cmpd (2-14) | 3.33 | 973 | 9.73 | 9.20 | 240 hrs. |
| Ex. 93 | Cmpd (1-181) | Cmpd (2-14) | 3.35 | 987 | 9.87 | 9.26 | 211 hrs. |
| Ex. 94 | Cmpd (1-182) | Cmpd (2-14) | 3.33 | 983 | 9.83 | 9.28 | 219 hrs. |
| Ex. 95 | Cmpd (1-23) | Cmpd (2-14) | 3.36 | 972 | 9.72 | 9.09 | 223 hrs. |
| Ex. 96 | Cmpd (1-190) | Cmpd (2-14) | 3.36 | 986 | 9.86 | 9.23 | 236 hrs. |
| Ex. 97 | Cmpd (1-214) | Cmpd (2-14) | 3.36 | 984 | 9.84 | 9.22 | 280 hrs. |
| Ex. 98 | Cmpd (1-215) | Cmpd (2-14) | 3.32 | 972 | 9.72 | 9.20 | 287 hrs. |
| Ex. 99 | Cmpd (1-89) | Cmpd (2-15) | 3.32 | 958 | 9.58 | 9.08 | 235 hrs. |
| Ex. 100 | Cmpd (1-181) | Cmpd (2-15) | 3.34 | 984 | 9.84 | 9.26 | 236 hrs. |
| Ex. 101 | Cmpd (1-182) | Cmpd (2-15) | 3.34 | 980 | 9.80 | 9.23 | 217 hrs. |
| Ex. 102 | Cmpd (1-23) | Cmpd (2-15) | 3.34 | 977 | 9.77 | 9.19 | 238 hrs. |
| Ex. 103 | Cmpd (1-190) | Cmpd (2-15) | 3.34 | 1008 | 10.08 | 9.48 | 238 hrs. |
| Ex. 104 | Cmpd (1-214) | Cmpd (2-15) | 3.34 | 1010 | 10.10 | 9.52 | 280 hrs. |
| Ex. 105 | Cmpd (1-215) | Cmpd (2-15) | 3.33 | 960 | 9.60 | 9.08 | 277 hrs. |
| Ex. 106 | Cmpd (1-89) | Cmpd (2-16) | 3.34 | 959 | 9.59 | 9.04 | 230 hrs. |
| Ex. 107 | Cmpd (1-181) | Cmpd (2-16) | 3.34 | 951 | 9.51 | 8.97 | 220 hrs. |
| Ex. 108 | Cmpd (1-182) | Cmpd (2-16) | 3.35 | 990 | 9.90 | 9.29 | 231 hrs. |
| Ex. 109 | Cmpd (1-23) | Cmpd (2-16) | 3.36 | 988 | 9.88 | 9.24 | 203 hrs. |
| Ex. 110 | Cmpd (1-190) | Cmpd (2-16) | 3.34 | 956 | 9.56 | 9.01 | 224 hrs. |
| Ex. 111 | Cmpd (1-214) | Cmpd (2-16) | 3.33 | 954 | 9.54 | 9.00 | 271 hrs. |
| Ex. 112 | Cmpd (1-215) | Cmpd (2-16) | 3.35 | 957 | 9.57 | 8.99 | 268 hrs. |
| Ex. 113 | Cmpd (1-89) | Cmpd (2-17) | 3.35 | 966 | 9.66 | 9.05 | 225 hrs. |
| Ex. 114 | Cmpd (1-181) | Cmpd (2-17) | 3.35 | 975 | 9.75 | 9.16 | 218 hrs. |
| Ex. 115 | Cmpd (1-182) | Cmpd (2-17) | 3.35 | 951 | 9.51 | 8.94 | 205 hrs. |
| Ex. 116 | Cmpd (1-23) | Cmpd (2-17) | 3.34 | 965 | 9.65 | 9.08 | 219 hrs. |
| Ex. 117 | Cmpd (1-190) | Cmpd (2-17) | 3.32 | 983 | 9.83 | 9.30 | 226 hrs. |
| Ex. 118 | Cmpd (1-214) | Cmpd (2-17) | 3.33 | 984 | 9.84 | 9.31 | 262 hrs. |
| Ex. 119 | Cmpd (1-215) | Cmpd (2-17) | 3.34 | 969 | 9.69 | 9.12 | 254 hrs. |
| Ex. 120 | Cmpd (1-89) | Cmpd (2-18) | 3.35 | 955 | 9.55 | 8.96 | 217 hrs. |

| | Electron Blocking Layer | Light-Emitting Layer | Voltage [V] (@10mA/cm²) | Luminance [cd/m²] (@10mA/cm²) | Light Emission Efficiency [cd/A] (@10mA/cm²) | Power Efficiency [lm/W] (@10mA/cm²) | Device Lifetime 95% Decay |
|---|---|---|---|---|---|---|---|
| Ex. 121 | Cmpd (1-181) | Cmpd (2-18) | 3.35 | 964 | 9.64 | 9.07 | 232 hrs. |
| Ex. 122 | Cmpd (1-182) | Cmpd (2-18) | 3.33 | 967 | 9.67 | 9.14 | 227 hrs. |
| Ex. 123 | Cmpd (1-23) | Cmpd (2-18) | 3.37 | 962 | 9.62 | 8.96 | 207 hrs. |
| Ex. 124 | Cmpd (1-190) | Cmpd (2-18) | 3.33 | 974 | 9.74 | 9.19 | 224 hrs. |
| Ex. 125 | Cmpd (1-214) | Cmpd (2-18) | 3.34 | 978 | 9.78 | 9.21 | 259 hrs. |
| Ex. 126 | Cmpd (1-215) | Cmpd (2-18) | 3.35 | 954 | 9.54 | 8.95 | 271 hrs. |
| Ex. 127 | Cmpd (1-89) | Cmpd (2-19) | 3.34 | 940 | 9.40 | 8.86 | 206 hrs. |
| Ex. 128 | Cmpd (1-181) | Cmpd (2-19) | 3.35 | 980 | 9.80 | 9.18 | 213 hrs. |
| Ex. 129 | Cmpd (1-182) | Cmpd (2-19) | 3.34 | 1010 | 10.10 | 9.50 | 217 hrs. |
| Ex. 130 | Cmpd (1-23) | Cmpd (2-19) | 3.35 | 1000 | 10.00 | 9.38 | 211 hrs. |
| Ex. 131 | Cmpd (1-190) | Cmpd (2-19) | 3.34 | 1005 | 10.05 | 9.45 | 213 hrs. |
| Ex. 132 | Cmpd (1-214) | Cmpd (2-19) | 3.34 | 1008 | 10.08 | 9.50 | 256 hrs. |
| Ex. 133 | Cmpd (1-215) | Cmpd (2-19) | 3.34 | 942 | 9.42 | 8.86 | 243 hrs. |
| Ex. 134 | Cmpd (1-89) | Cmpd (2-20) | 3.33 | 1011 | 10.11 | 9.55 | 222 hrs. |
| Ex. 135 | Cmpd (1-181) | Cmpd (2-20) | 3.35 | 1001 | 10.01 | 9.40 | 236 hrs. |
| Ex. 136 | Cmpd (1-182) | Cmpd (2-20) | 3.33 | 1003 | 10.03 | 9.46 | 212 hrs. |
| Ex. 137 | Cmpd (1-23) | Cmpd (2-20) | 3.36 | 968 | 9.68 | 9.05 | 223 hrs. |
| Ex. 138 | Cmpd (1-190) | Cmpd (2-20) | 3.34 | 1019 | 10.19 | 9.61 | 220 hrs. |
| Ex. 139 | Cmpd (1-214) | Cmpd (2-20) | 3.33 | 1021 | 10.21 | 9.63 | 263 hrs. |
| Ex. 140 | Cmpd (1-215) | Cmpd (2-20) | 3.33 | 1015 | 10.15 | 9.59 | 251 hrs. |
| Ex. 141 | Cmpd (1-89) | Cmpd (2-21) | 3.34 | 973 | 9.73 | 9.17 | 222 hrs. |
| Ex. 142 | Cmpd (1-181) | Cmpd (2-21) | 3.34 | 974 | 9.74 | 9.18 | 216 hrs. |
| Ex. 143 | Cmpd (1-182) | Cmpd (2-21) | 3.35 | 988 | 9.88 | 9.28 | 213 hrs. |
| Ex. 144 | Cmpd (1-23) | Cmpd (2-21) | 3.37 | 962 | 9.62 | 8.96 | 219 hrs. |
| Ex. 145 | Cmpd (1-190) | Cmpd (2-21) | 3.33 | 997 | 9.97 | 9.42 | 228 hrs. |
| Ex. 146 | Cmpd (1-214) | Cmpd (2-21) | 3.33 | 995 | 9.95 | 9.41 | 268 hrs. |
| Ex. 147 | Cmpd (1-215) | Cmpd (2-21) | 3.34 | 970 | 9.70 | 9.15 | 274 hrs. |
| Ex. 148 | Cmpd (1-89) | Cmpd (2-22) | 3.33 | 986 | 9.86 | 9.31 | 235 hrs. |
| Ex. 149 | Cmpd (1-181) | Cmpd (2-22) | 3.34 | 965 | 9.65 | 9.08 | 210 hrs. |
| Ex. 150 | Cmpd (1-182) | Cmpd (2-22) | 3.35 | 966 | 9.66 | 9.06 | 227 hrs. |
| Ex. 151 | Cmpd (1-23) | Cmpd (2-22) | 3.36 | 968 | 9.68 | 9.05 | 238 hrs. |
| Ex. 152 | Cmpd (1-190) | Cmpd (2-22) | 3.37 | 960 | 9.60 | 8.96 | 233 hrs. |
| Ex. 153 | Cmpd (1-214) | Cmpd (2-22) | 3.37 | 963 | 9.63 | 8.97 | 301 hrs. |
| Ex. 154 | Cmpd (1-215) | Cmpd (2-22) | 3.34 | 985 | 9.85 | 9.27 | 295 hrs. |
| Ex. 155 | Cmpd (1-89) | Cmpd (2-23) | 3.35 | 1000 | 10.00 | 9.37 | 214 hrs. |
| Ex. 156 | Cmpd (1-181) | Cmpd (2-23) | 3.34 | 1003 | 10.03 | 9.45 | 216 hrs. |
| Ex. 157 | Cmpd (1-182) | Cmpd (2-23) | 3.35 | 1003 | 10.03 | 9.43 | 224 hrs. |
| Ex. 158 | Cmpd (1-23) | Cmpd (2-23) | 3.35 | 1012 | 10.12 | 9.50 | 208 hrs. |
| Ex. 159 | Cmpd (1-190) | Cmpd (2-23) | 3.36 | 1004 | 10.04 | 9.38 | 221 hrs. |
| Ex. 160 | Cmpd (1-214) | Cmpd (2-23) | 3.36 | 1004 | 10.04 | 9.39 | 259 hrs. |
| Ex. 161 | Cmpd (1-215) | Cmpd (2-23) | 3.36 | 1002 | 10.02 | 9.36 | 254 hrs. |
| Ex. 162 | Cmpd (1-89) | Cmpd (2-24) | 3.34 | 1003 | 10.03 | 9.44 | 231 hrs. |
| Ex. 163 | Cmpd (1-181) | Cmpd (2-24) | 3.35 | 974 | 9.74 | 9.14 | 213 hrs. |
| Ex. 164 | Cmpd (1-182) | Cmpd (2-24) | 3.32 | 944 | 9.44 | 8.94 | 199 hrs. |
| Ex. 165 | Cmpd (1-23) | Cmpd (2-24) | 3.35 | 986 | 9.86 | 9.24 | 203 hrs. |
| Ex. 166 | Cmpd (1-190) | Cmpd (2-24) | 3.33 | 980 | 9.80 | 9.24 | 227 hrs. |
| Ex. 167 | Cmpd (1-214) | Cmpd (2-24) | 3.34 | 981 | 9.81 | 9.25 | 288 hrs. |
| Ex. 168 | Cmpd (1-215) | Cmpd (2-24) | 3.35 | 1003 | 10.03 | 9.40 | 291 hrs. |
| Ex. 169 | Cmpd (1-89) | Cmpd (2-25) | 3.35 | 985 | 9.85 | 9.25 | 209 hrs. |
| Ex. 170 | Cmpd (1-181) | Cmpd (2-25) | 3.34 | 981 | 9.81 | 9.24 | 206 hrs. |
| Ex. 171 | Cmpd (1-182) | Cmpd (2-25) | 3.34 | 960 | 9.60 | 9.03 | 239 hrs. |
| Ex. 172 | Cmpd (1-23) | Cmpd (2-25) | 3.34 | 986 | 9.86 | 9.28 | 231 hrs. |
| Ex. 173 | Cmpd (1-190) | Cmpd (2-25) | 3.34 | 966 | 9.66 | 9.10 | 207 hrs. |
| Ex. 174 | Cmpd (1-214) | Cmpd (2-25) | 3.34 | 964 | 9.64 | 9.08 | 265 hrs. |
| Ex. 175 | Cmpd (1-215) | Cmpd (2-25) | 3.35 | 986 | 9.86 | 9.25 | 259 hrs. |
| Ex. 176 | Cmpd (1-89) | Cmpd (2-26) | 3.34 | 1004 | 10.04 | 9.44 | 221 hrs. |
| Ex. 177 | Cmpd (1-181) | Cmpd (2-26) | 3.33 | 999 | 9.99 | 9.42 | 218 hrs. |
| Ex. 178 | Cmpd (1-182) | Cmpd (2-26) | 3.34 | 980 | 9.80 | 9.24 | 240 hrs. |
| Ex. 179 | Cmpd (1-23) | Cmpd (2-26) | 3.36 | 1018 | 10.18 | 9.53 | 223 hrs. |
| Ex. 180 | Cmpd (1-190) | Cmpd (2-26) | 3.35 | 1021 | 10.21 | 9.58 | 233 hrs. |
| Ex. 181 | Cmpd (1-214) | Cmpd (2-26) | 3.36 | 1020 | 10.20 | 9.55 | 304 hrs. |
| Ex. 182 | Cmpd (1-215) | Cmpd (2-26) | 3.35 | 1003 | 10.03 | 9.41 | 290 hrs. |
| Ex. 183 | Cmpd (1-89) | Cmpd (2-27) | 3.35 | 984 | 9.84 | 9.25 | 222 hrs. |
| Ex. 184 | Cmpd (1-181) | Cmpd (2-27) | 3.34 | 1006 | 10.06 | 9.48 | 229 hrs. |
| Ex. 185 | Cmpd (1-182) | Cmpd (2-27) | 3.35 | 986 | 9.86 | 9.25 | 221 hrs. |
| Ex. 186 | Cmpd (1-23) | Cmpd (2-27) | 3.35 | 995 | 9.95 | 9.35 | 239 hrs. |
| Ex. 187 | Cmpd (1-190) | Cmpd (2-27) | 3.35 | 1011 | 10.11 | 9.50 | 243 hrs. |
| Ex. 188 | Cmpd (1-214) | Cmpd (2-27) | 3.34 | 1012 | 10.12 | 9.52 | 299 hrs. |
| Ex. 189 | Cmpd (1-215) | Cmpd (2-27) | 3.36 | 985 | 9.85 | 9.21 | 271 hrs. |
| Comp Ex. 1 | Cmpd (HTM-2) | Cmpd (2-1) | 3.51 | 887 | 8.87 | 7.94 | 156 hrs. |
| Comp Ex. 2 | Cmpd (HTM-3) | Cmpd (2-1) | 3.53 | 878 | 8.78 | 7.83 | 161 hrs. |
| Comp Ex. 3 | Cmpd (1-89) | Cmpd (EMD-1) | 3.43 | 801 | 8.01 | 7.34 | 183 hrs. |

As shown in Table 2, the light emission efficiency when a current density of 10 mA/cm² was applied was 8.01 to 8.87 cd/A for the organic EL devices of Comparative Examples 1 to 3, while the organic EL devices of Examples 1 to 189 had a high efficiency of 9.40 to 10.26 cd/A. In terms of power efficiency, the organic EL devices of Examples 1 to 189 had a high efficiency of 8.84 to 9.69 lm/W, compared to 7.34 to 7.94 1m/W of the organic EL devices of Comparative Examples 1 to 3. Furthermore, in terms of device lifetime (95% decay), the organic EL devices of Examples 1 to 189 have a longer lifetime of 196 to 304 hours, compared to 156 to 183 hours for the organic EL devices of Comparative Examples 1 to 3.

As is clear from the above results, arylamine compounds having a specific structure represented by the general formula (1) have large hole mobility and excellent electron-blocking ability compared to hitherto-known arylamine compounds used as hole transport material, and when combined with an organoboron compound represented by the general formula (2-1) or the general formula (2-2), an organic EL device with higher light emission efficiency and longer lifetime can be realized compared to hitherto-known organic EL devices.

### Industrial Applicability

The organic EL device of the invention using an arylamine compound having a specific structure and an organoboron compound has improved light emission efficiency and improved durability, making it possible, for example, to expand the use of the organic EL device to household appliances and lighting applications. In addition, the arylamine compound of the invention can be applied also in the field of electronic appliances such as electrophotographic photoreceptors, image sensors, photoelectric conversion devices and solar cells, not limited to the use in organic EL devices.

### Reference Signs List

1: Glass Substrate
2: Transparent Anode
3: Hole Injection Layer
4: Hole Transport Layer
5: Electron-Blocking Layer
6: Light-Emitting Layer
7: Electron Transport Layer
8: Electron Injection Layer
9: Cathode
10: Capping Layer

## Claims

1. An organic electroluminescent device comprising an anode, a cathode, and an organic layer sandwiched between the anode and the cathode, wherein the organic layer contains an arylamine compound represented by the following general formula (1) and an organoboron compound represented by the following general formula (2-1) or (2-2): 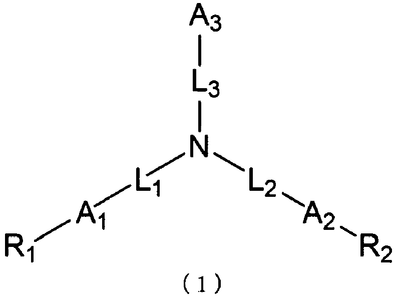
wherein L₁ to L₃ may be the same as or different from each other, and each represent a single bond, a deuterium-substituted or unsubstituted divalent aromatic hydrocarbon group having 6 to 30 carbon atoms, a deuterium-substituted or unsubstituted divalent fused polycyclic aromatic hydrocarbon group having 10 to 30 carbon atoms, a deuterium-substituted or unsubstituted divalent aromatic heterocyclic group having 2 to 20 carbon atoms, or a deuterium-substituted or unsubstituted divalent fused polycyclic aromatic heterocyclic group having 2 to 30 carbon atoms,
A₁ and A₂ may be the same as or different from each other, and each represent a deuterium-substituted or unsubstituted naphthylene group,
A₃ represents a substituted or unsubstituted aromatic hydrocarbon group having 6 to 30 carbon atoms, a substituted or unsubstituted fused polycyclic aromatic hydrocarbon group having 10 to 30 carbon atoms, a substituted or unsubstituted aromatic heterocyclic group having 2 to 20 carbon atoms, or a substituted or unsubstituted fused polycyclic aromatic heterocyclic group having 2 to 30 carbon atoms,
R₁ and R₂ may be the same as or different from each other, representing a deuterium-substituted or unsubstituted aromatic hydrocarbon group having 6 to 30 carbon atoms, a deuterium-substituted or unsubstituted fused polycyclic aromatic hydrocarbon group having 10 to 30 carbon atoms, a deuterium-substituted or unsubstituted aromatic heterocyclic group having 2 to 20 carbon atoms, or a deuterium-substituted or unsubstituted fused polycyclic aromatic heterocyclic group having 2 to 30 carbon atoms,
the wording "substituted or unsubstituted" means having one or more substituents or having no substituents of any kind,
the "substituent" may be the same as or different from each other, and represents a deuterium atom, a halogen atom, a cyano group, an alkyl group having 1 to 30 carbon atoms, a cycloalkyl group having 3 to 30 carbon atoms, an alkenyl group having 2 to 30 carbon atoms, an aromatic hydrocarbon group having 6 to 50 carbon atoms, a fused polycyclic aromatic hydrocarbon group having 10 to 30 carbon atoms, an aromatic heterocyclic group having 2 to 50 carbon atoms, a fused polycyclic aromatic heterocyclic group having 2 to 30 carbon atoms, an amino group having 0 to 30 carbon atoms, or a silyl group having 3 to 30 carbon atoms,
these "substituents" may further have one or more substituents,
when the "substituent" has a carbon atom, the carbon atom is counted in the "6 to 30 carbon atoms", "10 to 30 carbon atoms", "2 to 20 carbon atoms", and "2 to 30 carbon atoms" in A₃, R₁, and R₂ above, 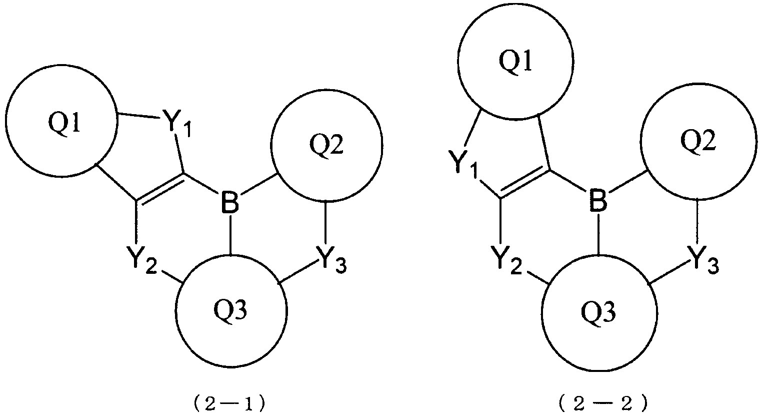
wherein Q1 to Q3 may be the same as or different from each other and each represent a substituted or unsubstituted aromatic hydrocarbon ring having 6 to 50 carbon atoms, a substituted or unsubstituted fused polycyclic aromatic hydrocarbon ring having 10 to 50 carbon atoms, a substituted or unsubstituted aromatic heterocyclic ring having 2 to 50 carbon atoms, or a substituted or unsubstituted fused polycyclic aromatic heterocyclic ring having 2 to 50 carbon atoms,
Y₁ to Y₃ may be the same as or different from each other and each represent N-R₃, CR₄R₅, O, S, Se, or SiR₆R₇,
R₃ to R₇ may be the same as or different from each other, and each represent a hydrogen atom, a deuterium atom, a halogen atom, a nitro group, a cyano group, a substituted or unsubstituted alkyl group having 1 to 30 carbon atoms, a substituted or unsubstituted cycloalkyl group having 3 to 30 carbon atoms, a substituted or unsubstituted alkenyl group having 2 to 30 carbon atoms, a substituted or unsubstituted cycloalkenyl group having 3 to 30 carbon atoms, a substituted or unsubstituted heterocycloalkyl group having 1 to 30 carbon atoms, a substituted or unsubstituted aromatic hydrocarbon group having 6 to 50 carbon atoms, a substituted or unsubstituted fused polycyclic aromatic hydrocarbon group having 10 to 50 carbon atoms, a substituted or unsubstituted aromatic heterocyclic group having 2 to 50 carbon atoms, a substituted or unsubstituted fused polycyclic aromatic heterocyclic group having 2 to 50 carbon atoms, a substituted or unsubstituted alkoxy group having 1 to 30 carbon atoms, a substituted or unsubstituted aryloxy group having 6 to 30 carbon atoms, a substituted or unsubstituted alkylthio group having 1 to 30 carbon atoms, a substituted or unsubstituted arylthio group having 5 to 30 carbon atoms, a substituted or unsubstituted amino groups having 0 to 30 carbon atoms, or a substituted or unsubstituted silyl groups having 3 to 30 carbon atoms,
R₃ to R₇ may each bond to any of Q1 to Q3 via a single bond, N, O, P or S, or fuse to form a fused ring, R₄ and R₅ may bond to each other to further form a ring, and R₆ and R₇ may bond to each other to further form a ring,
the wording "substituted or unsubstituted" has the same definition as in the general formula (1), and the "substituent" represents the same group as the "substituent" in the general formula (1),
these "substituents" may further have one or more substituents,
when the "substituent" has a carbon atom, the carbon atom is counted in the "6 to 50 carbon atoms", "10 to 50 carbon atoms", "2 to 50 carbon atoms", "1 to 30 carbon atoms", "3 to 30 carbon atoms", "2 to 30 carbon atoms", "6 to 30 carbon atoms", "5 to 30 carbon atoms" and "0 to 30 carbon atoms" in Q1 to Q3, Y₁ to Y₃, and R₃ to R₇ above,
when Y₂ or Y₃ is N-R₃, at least one R₃ represents a fused polycyclic aromatic heterocyclic group represented by the following general formula (2-A), or an aromatic hydrocarbon group, a fused polycyclic aromatic hydrocarbon group, or a fused polycyclic aromatic heterocyclic group represented by the following general formula (2-B): 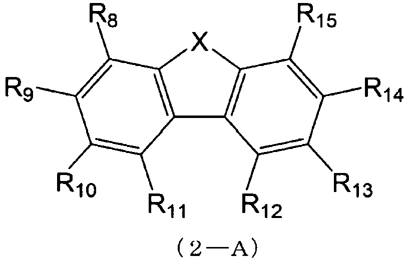
wherein X represents O or S,
R₈ to R₁₅ may be the same as or different from each other and each represent a single bond, a hydrogen atom, a deuterium atom, a halogen atom, a hydroxyl group, a nitro group, a cyano group, a substituted or unsubstituted alkyl group having 1 to 30 carbon atoms, a substituted or unsubstituted cycloalkyl group having 3 to 30 carbon atoms, a substituted or unsubstituted alkenyl group having 2 to 30 carbon atoms, a substituted or unsubstituted cycloalkenyl group having 3 to 30 carbon atoms, a substituted or unsubstituted alkynyl group having 2 to 30 carbon atoms, a substituted or unsubstituted heterocycloalkyl group having 1 to 30 carbon atoms, a substituted or unsubstituted aromatic hydrocarbon group having 6 to 50 carbon atoms, a fused polycyclic aromatic hydrocarbon group having 10 to 30 carbon atoms, a substituted or unsubstituted aromatic heterocyclic group having 2 to 50 carbon atoms, a substituted or unsubstituted fused polycyclic aromatic heterocyclic group having 2 to 30 carbon atoms, a substituted or unsubstituted alkoxy group having 1 to 30 carbon atoms, a substituted or unsubstituted aryloxy group having 6 to 30 carbon atoms, a substituted or unsubstituted alkylthio group having 1 to 30 carbon atoms, a substituted or unsubstituted arylthio group having 5 to 30 carbon atoms, a substituted or unsubstituted amino group having 0 to 30 carbon atoms, a substituted or unsubstituted silyl group having 3 to 30 carbon atoms, a substituted or unsubstituted germanium group having 0 to 30 carbon atoms, a substituted or unsubstituted boron group having 0 to 30 carbon atoms, a substituted or unsubstituted aluminum group having 0 to 30 carbon atoms, a substituted phosphoryl group having 0 to 30 carbon atoms, a substituted or unsubstituted seleno group having 0 to 30 carbon atoms, or a substituted or unsubstituted tellurium group having 0 to 30 carbon atoms,
any one of R₈ to R₁₅ bonds to N of N-R₃ represented by Y₂ or Y₃,
R₈ to R₁₅ may bond to the adjacent group via a single bond, N, O, or S, or may fuse to form a ring,
the wording "substituted or unsubstituted" has the same definition as in the general formula (1), and the "substituent" represents the same group as the "substituent" in the general formula (1),
these "substituents" may further have one or more substituents,
when the "substituent" has a carbon atom, the carbon atom is counted in the "1 to 30 carbon atoms", "3 to 30 carbon atoms", "2 to 30 carbon atoms", "10 to 30 carbon atoms", "6 to 50 carbon atoms", "2 to 50 carbon atoms", "6 to 30 carbon atoms", "5 to 30 carbon atoms", "0 to 30 carbon atoms", and "0 to 30 carbon atoms" in R₈ to R₁₅ above, 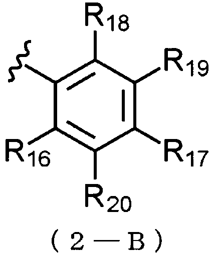
wherein R₁₆ represents a hydrogen atom, a deuterium atom, a substituted or unsubstituted alkyl group having 1 to 30 carbon atoms, a substituted or unsubstituted aromatic hydrocarbon group having 6 to 50 carbon atoms, a substituted or unsubstituted aromatic heterocyclic group having 2 to 50 carbon atoms, or a substituted or unsubstituted fused polycyclic aromatic heterocyclic group having 2 to 50 carbon atoms,
R₁₇ represents a hydrogen atom, a deuterium atom, a substituted or unsubstituted alkyl group having 1 to 30 carbon atoms, a substituted or unsubstituted cycloalkyl group having 3 to 30 carbon atoms, a substituted or unsubstituted aromatic hydrocarbon group having 6 to 50 carbon atoms, a substituted or unsubstituted fused polycyclic aromatic hydrocarbon group having 10 to 30 carbon atoms, a substituted or unsubstituted aromatic heterocyclic group having 2 to 50 carbon atoms, or a substituted or unsubstituted fused polycyclic aromatic heterocyclic group having 2 to 30 carbon atoms,
R₁₈ to R₂₀ may be the same as or different from each other, and each represent a hydrogen atom, a deuterium atom, a halogen atom, a cyano group, a substituted or unsubstituted alkyl group having 1 to 30 carbon atoms, a substituted or unsubstituted cycloalkyl group having 3 to 30 carbon atoms, a substituted or unsubstituted aromatic hydrocarbon group having 6 to 50 carbon atoms, a substituted or unsubstituted aromatic heterocyclic group having 2 to 50 carbon atoms, a substituted or unsubstituted alkoxy groups having 1 to 30 carbon atoms, a substituted or unsubstituted alkylthio groups having 1 to 30 carbon atoms, a substituted or unsubstituted amino groups having 0 to 30 carbon atoms, or a substituted or unsubstituted silyl groups having 3 to 30 carbon atoms, and
the wavy line represents the bond to N in N-R₃ represented by Y₂ or Y₃,
R₁₆ to R₂₀ may bond to the adjacent group via a single bond, N, O, or S, or may fuse to form a ring,
the wording "substituted or unsubstituted" has the same definition as in the general formula (1), and the "substituent" represents the same group as the "substituent" in the general formula (1),
these "substituents" may further have one or more substituents,
when the "substituent" has a carbon atom, the carbon atom is counted in the "1 to 30 carbon atoms", "6 to 50 carbon atoms", "2 to 50 carbon atoms", "3 to 30 carbon atoms", "10 to 30 carbon atoms", "2 to 30 carbon atoms" and "0 to 30 carbon atoms" in R₁₆ to R₂₀ above.

2. The organic electroluminescent device according to claim 1, containing an arylamine compound of the general formula (1) wherein A₁ and A₂ may be the same as or different from each other, and are each a deuterium-substituted or unsubstituted 1,2-naphthylene group, a deuterium-substituted or unsubstituted 1,3-naphthylene group, a deuterium-substituted or unsubstituted 1,4-naphthylene group, a deuterium-substituted or unsubstituted 2,6-naphthylene group, a deuterium-substituted or unsubstituted 2,7-naphthylene group, or a deuterium-substituted or unsubstituted 2,8-naphthylene group.

3. The organic electroluminescent device according to claim 1, containing an arylamine compound of the general formula (1) wherein L₁ and L₂ each are a deuterium-substituted or unsubstituted phenylene group or a deuterium-substituted or unsubstituted biphenylylene group.

4. The organic electroluminescent device according to claim 1, containing an arylamine compound of the general formula (1) wherein R₁ and R₂ may be the same as or different from each other, each representing a deuterium-substituted or unsubstituted phenyl group, a deuterium-substituted or unsubstituted naphthyl group, a deuterium-substituted or unsubstituted dibenzofuranyl group, a deuterium-substituted or unsubstituted phenanthrenyl group, or a deuterium-substituted or unsubstituted biphenylyl group.

5. The organic electroluminescent device according to claim 1, containing an arylamine compound of the general formula (1) wherein A₃ represents a substituted or unsubstituted phenyl group, a substituted or unsubstituted naphthyl group, a substituted or unsubstituted dibenzofuranyl group, a substituted or unsubstituted dibenzothienyl group, a substituted or unsubstituted phenanthrenyl group, or a substituted or unsubstituted biphenylyl group.

6. The organic electroluminescent device according to any one of claims 1 to 5, containing an arylamine compound of the general formula (1) wherein A₁ and A₂ are the same group.

7. The organic electroluminescent device according to claim 6, containing an arylamine compound of the general formula (1) wherein R₁ and R₂ are the same group.

8. The organic electroluminescent device according to claim 6, containing an arylamine compound of the general formula (1) wherein R₁ and R₂ are different groups.

9. The organic electroluminescent device according to any one of claims 1 to 5, containing an arylamine compound of the general formula (1) wherein A₁ and A₂ are different groups.

10. The organic electroluminescent device according to claim 9, containing an arylamine compound of the general formula (1) wherein R₁ and R₂ are the same group.

11. The organic electroluminescent device according to claim 9, containing an arylamine compound of the general formula (1) wherein R₁ and R₂ are different groups.

12. The organic electroluminescent device according to claim 1, wherein the general formula (2-1) or (2-2) contains an organoboron compound represented by the following general formula (2-3), general formula (2-4), general formula (2-5) or general formula (2-6): 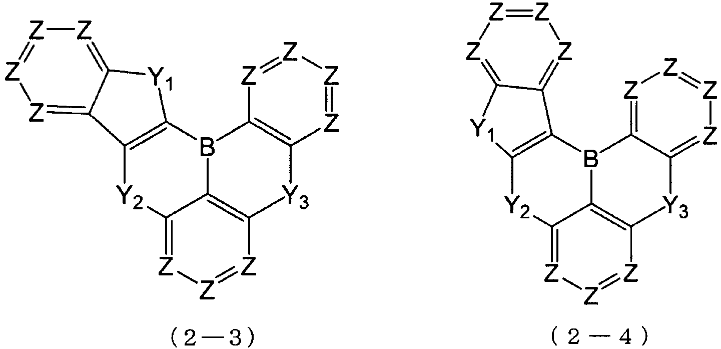 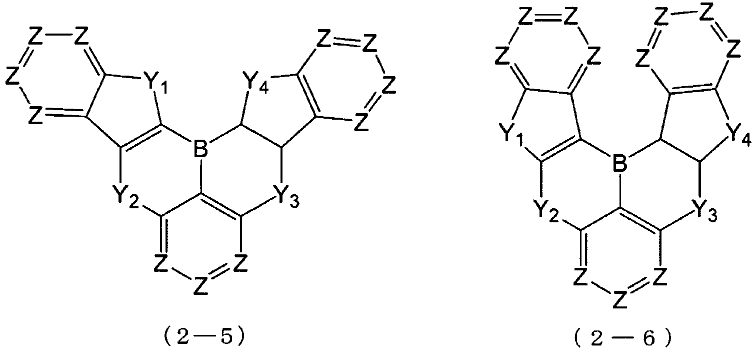
wherein Y₁, Y₂ and Y₃ are the same as in the general formulas (2-1) and (2-2),
Y₄ represents N-R₃, C-R₄R₅, O, S, Se or Si-R₆R₇,
R₃ to R₇ are the same as in the general formulas (2-1) and (2-2),
Z may be the same as or different from each other, and represents N or CR₂₁,
R₂₁ represents a hydrogen atom, a deuterium atom, a halogen atom, a cyano group, a substituted or unsubstituted alkyl group having 1 to 30 carbon atoms, a substituted or unsubstituted cycloalkyl group having 3 to 30 carbon atoms, a substituted or unsubstituted aromatic hydrocarbon group having 6 to 50 carbon atoms, a substituted or unsubstituted fused polycyclic aromatic hydrocarbon group having 10 to 30 carbon atoms, a substituted or unsubstituted aromatic heterocyclic group having 2 to 50 carbon atoms, a substituted or unsubstituted fused polycyclic aromatic heterocyclic group having 2 to 30 carbon atoms, a substituted or unsubstituted alkoxy group having 1 to 30 carbon atoms, a substituted or unsubstituted aryloxy group having 6 to 30 carbon atoms, a substituted or unsubstituted alkylthio group having 1 to 30 carbon atoms, a substituted or unsubstituted arylthio group having 5 to 30 carbon atoms, a substituted or unsubstituted alkylamino group having 1 to 30 carbon atoms, a substituted or unsubstituted arylamino group having 5 to 30 carbon atoms, a substituted or unsubstituted alkylsilyl group having 1 to 30 carbon atoms, or a substituted or unsubstituted arylsilyl group having 5 to 30 carbon atoms, R₂₁ may bond to the adjacent group via a single bond, N, O, or S, or may fuse to form a ring,
the wording "substituted or unsubstituted" has the same definition as in the general formula (1), and the "substituent" represents the same group as the "substituent" in the general formula (1),
these "substituents" may further have one or more substituents,
when the "substituent" has a carbon atom, the carbon atom is counted in the "1 to 30 carbon atoms", "3 to 30 carbon atoms", "6 to 50 carbon atoms", "2 to 50 carbon atoms", "6 to 30 carbon atoms", and "5 to 30 carbon atoms" in R₂₁ above.

13. The organic electroluminescent device according to claim 1, in which the organic layer includes at least a hole transport layer and a light-emitting layer, the hole transport layer contains a compound represented by the general formula (1), and the light-emitting layer contains an organoboron compound represented by the general formula (2-1) or general formula (2-2).

14. The organic electroluminescent device according to claim 1, in which the organic layer includes at least an electron-blocking layer and a light-emitting layer, the electron-blocking layer contains a compound represented by the general formula (1), and the light-emitting layer contains an organoboron compound represented by the general formula (2-1) or general formula (2-2).

15. The organic electroluminescent device according to claim 1, in which the organic layer includes at least a hole injection layer and a light-emitting layer, the hole injection layer contains a compound represented by the general formula (1), and the light-emitting layer contains an organoboron compound represented by the general formula (2-1) or general formula (2-2).

16. An electronic device having a pair of electrodes, and an organic layer sandwiched between the pair of electrodes, wherein the organic layer contains an arylamine compound represented by the following general formula (1) and an organoboron compound represented by the following general formula (2-1) or (2-2): 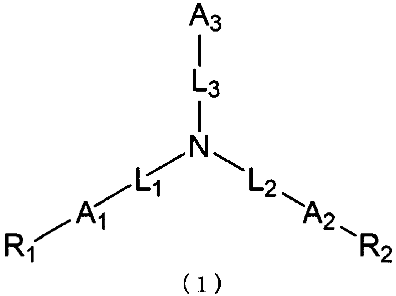
wherein L₁ to L₃ may be the same as or different from each other, and each represent a single bond, a deuterium-substituted or unsubstituted divalent aromatic hydrocarbon group having 6 to 30 carbon atoms, a deuterium-substituted or unsubstituted divalent fused polycyclic aromatic hydrocarbon group having 10 to 30 carbon atoms, a deuterium-substituted or unsubstituted divalent aromatic heterocyclic group having 2 to 20 carbon atoms, or a deuterium-substituted or unsubstituted divalent fused polycyclic aromatic heterocyclic group having 2 to 30 carbon atoms,
A₁ and A₂ may be the same as or different from each other, and each represent a deuterium-substituted or unsubstituted naphthylene group,
A₃ represents a substituted or unsubstituted aromatic hydrocarbon group having 6 to 30 carbon atoms, a substituted or unsubstituted fused polycyclic aromatic hydrocarbon group having 10 to 30 carbon atoms, a substituted or unsubstituted aromatic heterocyclic group having 2 to 20 carbon atoms, or a substituted or unsubstituted fused polycyclic aromatic heterocyclic group having 2 to 30 carbon atoms,
R₁ and R₂ may be the same as or different from each other, representing a deuterium-substituted or unsubstituted aromatic hydrocarbon group having 6 to 30 carbon atoms, a deuterium-substituted or unsubstituted fused polycyclic aromatic hydrocarbon group having 10 to 30 carbon atoms, a deuterium-substituted or unsubstituted aromatic heterocyclic group having 2 to 20 carbon atoms, or a deuterium-substituted or unsubstituted fused polycyclic aromatic heterocyclic group having 2 to 30 carbon atoms,
the wording "substituted or unsubstituted" means having one or more substituents or having no substituents of any kind,
the "substituent" may be the same as or different from each other, and represents a deuterium atom, a halogen atom, a cyano group, an alkyl group having 1 to 30 carbon atoms, a cycloalkyl group having 3 to 30 carbon atoms, an alkenyl group having 2 to 30 carbon atoms, an aromatic hydrocarbon group having 6 to 50 carbon atoms, a fused polycyclic aromatic hydrocarbon group having 10 to 30 carbon atoms, an aromatic heterocyclic group having 2 to 50 carbon atoms, a fused polycyclic aromatic heterocyclic group having 2 to 30 carbon atoms, an amino group having 0 to 30 carbon atoms, or a silyl group having 3 to 30 carbon atoms,
these "substituents" may further have one or more substituents,
when the "substituent" has a carbon atom, the carbon atom is counted in the "6 to 30 carbon atoms", "10 to 30 carbon atoms", "2 to 20 carbon atoms", and "2 to 30 carbon atoms" in A₃, R₁, and R₂ above, 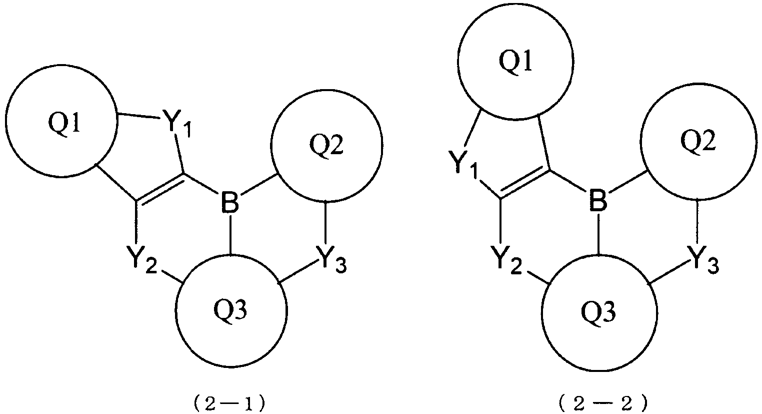
wherein Q1 to Q3 may be the same as or different from each other and each represent a substituted or unsubstituted aromatic hydrocarbon ring having 6 to 50 carbon atoms, a substituted or unsubstituted fused polycyclic aromatic hydrocarbon ring having 10 to 50 carbon atoms, a substituted or unsubstituted aromatic heterocyclic ring having 2 to 50 carbon atoms, or a substituted or unsubstituted fused polycyclic aromatic heterocyclic ring having 2 to 50 carbon atoms,
Y₁ to Y₃ may be the same as or different from each other and each represent N-R₃, CR₄R₅, O, S, Se, or SiR₆R₇,
R₃ to R₇ may be the same as or different from each other, and each represent a hydrogen atom, a deuterium atom, a halogen atom, a nitro group, a cyano group, a substituted or unsubstituted alkyl group having 1 to 30 carbon atoms, a substituted or unsubstituted cycloalkyl group having 3 to 30 carbon atoms, a substituted or unsubstituted alkenyl group having 2 to 30 carbon atoms, a substituted or unsubstituted cycloalkenyl group having 3 to 30 carbon atoms, a substituted or unsubstituted heterocycloalkyl group having 1 to 30 carbon atoms, a substituted or unsubstituted aromatic hydrocarbon group having 6 to 50 carbon atoms, a substituted or unsubstituted fused polycyclic aromatic hydrocarbon group having 10 to 50 carbon atoms, a substituted or unsubstituted aromatic heterocyclic group having 2 to 50 carbon atoms, a substituted or unsubstituted fused polycyclic aromatic heterocyclic group having 2 to 50 carbon atoms, a substituted or unsubstituted alkoxy group having 1 to 30 carbon atoms, a substituted or unsubstituted aryloxy group having 6 to 30 carbon atoms, a substituted or unsubstituted alkylthio group having 1 to 30 carbon atoms, a substituted or unsubstituted arylthio group having 5 to 30 carbon atoms, a substituted or unsubstituted amino groups having 0 to 30 carbon atoms, or a substituted or unsubstituted silyl groups having 3 to 30 carbon atoms,
R₃ to R₇ may each bond to any of Q1 to Q3 via a single bond, N, O, P or S, or fuse to form a fused ring, R₄ and R₅ may bond to each other to further form a ring, and R₆ and R₇ may bond to each other to further form a ring,
the wording "substituted or unsubstituted" has the same definition as in the general formula (1), and the "substituent" represents the same group as the "substituent" in the general formula (1),
these "substituents" may further have one or more substituents,
when the "substituent" has a carbon atom, the carbon atom is counted in the "6 to 50 carbon atoms", "10 to 50 carbon atoms", "2 to 50 carbon atoms", "1 to 30 carbon atoms", "3 to 30 carbon atoms", "2 to 30 carbon atoms", "6 to 30 carbon atoms", "5 to 30 carbon atoms" and "0 to 30 carbon atoms" in Q1 to Q3, Y₁ to Y₃, and R₃ to R₇ above,
when Y₂ or Y₃ is N-R₃, at least one R₃ represents a fused polycyclic aromatic heterocyclic group represented by the following general formula (2-A), or an aromatic hydrocarbon group, a fused polycyclic aromatic hydrocarbon group, or a fused polycyclic aromatic heterocyclic group represented by the following general formula (2-B): 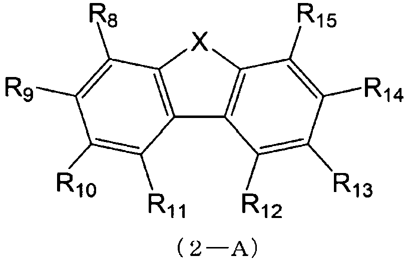
wherein X represents O or S,
R₈ to R₁₅ may be the same as or different from each other and each represent a single bond, a hydrogen atom, a deuterium atom, a halogen atom, a hydroxyl group, a nitro group, a cyano group, a substituted or unsubstituted alkyl group having 1 to 30 carbon atoms, a substituted or unsubstituted cycloalkyl group having 3 to 30 carbon atoms, a substituted or unsubstituted alkenyl group having 2 to 30 carbon atoms, a substituted or unsubstituted cycloalkenyl group having 3 to 30 carbon atoms, a substituted or unsubstituted alkynyl group having 2 to 30 carbon atoms, a substituted or unsubstituted heterocycloalkyl group having 1 to 30 carbon atoms, a substituted or unsubstituted aromatic hydrocarbon group having 6 to 50 carbon atoms, a fused polycyclic aromatic hydrocarbon group having 10 to 30 carbon atoms, a substituted or unsubstituted aromatic heterocyclic group having 2 to 50 carbon atoms, a substituted or unsubstituted fused polycyclic aromatic heterocyclic group having 2 to 30 carbon atoms, a substituted or unsubstituted alkoxy group having 1 to 30 carbon atoms, a substituted or unsubstituted aryloxy group having 6 to 30 carbon atoms, a substituted or unsubstituted alkylthio group having 1 to 30 carbon atoms, a substituted or unsubstituted arylthio group having 5 to 30 carbon atoms, a substituted or unsubstituted amino group having 0 to 30 carbon atoms, a substituted or unsubstituted silyl group having 3 to 30 carbon atoms, a substituted or unsubstituted germanium group having 0 to 30 carbon atoms, a substituted or unsubstituted boron group having 0 to 30 carbon atoms, a substituted or unsubstituted aluminum group having 0 to 30 carbon atoms, a substituted phosphoryl group having 0 to 30 carbon atoms, a substituted or unsubstituted seleno group having 0 to 30 carbon atoms, or a substituted or unsubstituted tellurium group having 0 to 30 carbon atoms,
any one of R₈ to R₁₅ bonds to N of N-R₃ represented by Y₂ or Y₃,
R₈ to R₁₅ may bond to the adjacent group via a single bond, N, O, or S, or may fuse to form a ring,
the wording "substituted or unsubstituted" has the same definition as in the general formula (1), and the "substituent" represents the same group as the "substituent" in the general formula (1),
these "substituents" may further have one or more substituents,
when the "substituent" has a carbon atom, the carbon atom is counted in the "1 to 30 carbon atoms", "3 to 30 carbon atoms", "2 to 30 carbon atoms", "10 to 30 carbon atoms", "6 to 50 carbon atoms", "2 to 50 carbon atoms", "6 to 30 carbon atoms", "5 to 30 carbon atoms", "0 to 30 carbon atoms", and "0 to 30 carbon atoms" in R₈ to R₁₅ above, 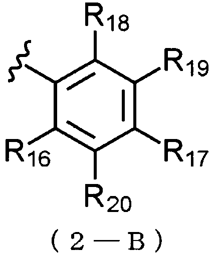
wherein R₁₆ represents a hydrogen atom, a deuterium atom, a substituted or unsubstituted alkyl group having 1 to 30 carbon atoms, a substituted or unsubstituted aromatic hydrocarbon group having 6 to 50 carbon atoms, a substituted or unsubstituted aromatic heterocyclic group having 2 to 50 carbon atoms, or a substituted or unsubstituted fused polycyclic aromatic heterocyclic group having 2 to 50 carbon atoms,
R₁₇ represents a hydrogen atom, a deuterium atom, a substituted or unsubstituted alkyl group having 1 to 30 carbon atoms, a substituted or unsubstituted cycloalkyl group having 3 to 30 carbon atoms, a substituted or unsubstituted aromatic hydrocarbon group having 6 to 50 carbon atoms, a substituted or unsubstituted fused polycyclic aromatic hydrocarbon group having 10 to 30 carbon atoms, a substituted or unsubstituted aromatic heterocyclic group having 2 to 50 carbon atoms, or a substituted or unsubstituted fused polycyclic aromatic heterocyclic group having 2 to 30 carbon atoms,
R₁₈ to R₂₀ may be the same as or different from each other, and each represent a hydrogen atom, a deuterium atom, a halogen atom, a cyano group, a substituted or unsubstituted alkyl group having 1 to 30 carbon atoms, a substituted or unsubstituted cycloalkyl group having 3 to 30 carbon atoms, a substituted or unsubstituted aromatic hydrocarbon group having 6 to 50 carbon atoms, a substituted or unsubstituted aromatic heterocyclic group having 2 to 50 carbon atoms, a substituted or unsubstituted alkoxy group having 1 to 30 carbon atoms, a substituted or unsubstituted alkylthio group having 1 to 30 carbon atoms, a substituted or unsubstituted amino group having 0 to 30 carbon atoms, or a substituted or unsubstituted silyl group having 3 to 30 carbon atoms,
the wavy line represents the bond to N in N-R₃ represented by Y₂ or Y₃,
R₁₆ to R₂₀ may bond to the adjacent group via a single bond, N, O, or S, or may fuse to form a ring,
the wording "substituted or unsubstituted" has the same definition as in the general formula (1), and the "substituent" represents the same group as the "substituent" in the general formula (1),
these "substituents" may further have one or more substituents,
when the "substituent" has a carbon atom, the carbon atom is counted in the "1 to 30 carbon atoms", "6 to 50 carbon atoms", "2 to 50 carbon atoms", "3 to 30 carbon atoms", "10 to 30 carbon atoms", "2 to 30 carbon atoms" and "0 to 30 carbon atoms" in R₁₆ to R₂₀ above.
